# EUROPÄISCHE PATENTSCHRIFT

(11) **EP 2 726 490 B1**
(45) Veröffentlichungstag und Bekanntmachung des Hinweises auf die Patenterteilung: **29.04.2015**
(21) Anmeldenummer: 12724915.9
(22) Anmeldetag: 30.05.2012
(51) Int. Cl.: C07F 15/00, C09K 11/00, H01L 51/00, H05B 33/00

(54) **METALLKOMPLEXE**
METAL COMPLEXES
COMPLEXES METALLIQUES

(30) Priorität: 28.06.2011 EP 11005252
(43) Veröffentlichungstag der Anmeldung: 07.05.2014
(73) Patentinhaber: Merck Patent GmbH, 64293 Darmstadt (DE)
(72) Erfinder: STOESSEL, Philipp, 60487 Frankfurt am Main (DE); JATSCH, Anja, 60486 Frankfurt am Main (DE); BREUNING, Esther, 64372 Ober-Ramstadt (DE)
(86) Internationale Anmeldenummer: PCT/EP2012/002289
(87) Internationale Veröffentlichungsnummer: WO 2013/000531

(56) Entgegenhaltungen:
- WO-A1-2010/086089
- ARNOLD L. RHEINGOLD ET AL: "Hydrotris(indazolyl)borates: Homoscorpionates with Tunable Regiochemistry", INORGANIC CHEMISTRY, Bd. 36, Nr. 22, 1. Oktober 1997 (1997-10-01), Seiten 5097-5103, XP55033183, ISSN: 0020-1669, DOI: 10.1021/ic970734l
- RICCARDO PETTINARI ET AL: "Solid-State 15 N CPMAS NMR and Computational Analysis of Ligand Hapticity in Rhodium([eta]-diene) Poly(pyrazolyl)borate Complexes", INORGANIC CHEMISTRY, Bd. 49, Nr. 23, 6. Dezember 2010 (2010-12-06), Seiten 11205-11215, XP55033175, ISSN: 0020-1669, DOI: 10.1021/ic101830e

## Beschreibung

Die vorliegende Erfindung betrifft Metallkomplexe sowie organische Elektrolumineszenzvorrichtungen, welche diese Metallkomplexe in der emittierenden Schicht enthalten.

Der Aufbau organischer Elektrolumineszenzvorrichtungen (OLEDs), in denen organische Halbleiter als funktionelle Materialien eingesetzt werden, ist beispielsweise in US 4,539,507, US 5,151,629, EP 0676461 und WO 98/27136 beschrieben. Dabei werden als emittierende Materialien häufig metallorganische Komplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Generell gibt es bei OLEDs, die Triplettemission zeigen, jedoch immer noch Verbesserungsbedarf, insbesondere im Hinblick auf Effizienz, Betriebsspannung und Lebensdauer. Dies gilt insbesondere auch für OLEDs, welche im kürzerwelligen Bereich, also grün und insbesondere blau, emittieren.

Gemäß dem Stand der Technik werden in phosphoreszierenden OLEDs als Triplettemitter neben Iridiumkomplexen insbesondere auch Platinkomplexe eingesetzt. Eine Verbesserung dieser OLEDs konnte dadurch erzielt werden, dass Metallkomplexe mit tetradentatem Liganden, wodurch die Komplexe eine höhere thermische Stabilität aufweisen, was zu einer höheren Lebensdauer der OLEDs führt (WO 2005/042550).

Aus dem Stand der Technik sind weiterhin Iridiumkomplexe, welche als Liganden Imidazophenanthridin-Derivate bzw. Diimidazochinazolin-Derivate enthalten (WO 2007/095118), und Platinkomplexe, die tetradentate Liganden mit Imidazophenanthridin bzw. Diimidazochinazolin als Teilliganden enthalten (US 2011/0073848), bekannt. Diese Komplexe können bei Anwendung in organischen Elektrolumineszenzvorrichtungen, je nach Struktur des Liganden, zu blauer Phosphoreszenz führen. Auch hier sind noch weitere Verbesserungen hinsichtlich Effizienz, Betriebsspannung und Lebensdauer, wünschenswert. Insbesondere besteht hier auch noch Verbesserungsbedarf in Bezug auf die Farbkoordinaten, um tiefblaue Emission erzielen zu können.

Aus WO 2010/086089 sind Metallkomplexe bekannt, welche als Liganden Imidazoisochinolin-Derivate enthalten. Mit derartigen Komplexen wurden bereits gute Fortschritte in der Entwicklung blauer Triplettemitter erzielt. Jedoch sind auch hier noch weitere Verbesserungen hinsichtlich Effizienz, Betriebsspannung und Lebensdauer wünschenswert.

Aufgabe der vorliegenden Erfindung ist daher die Bereitstellung neuer und vorzugsweise verbesserter Metallkomplexe, welche sich als Emitter für die Verwendung in OLEDs eignen. Insbesondere ist es die Aufgabe, Emitter bereitzustellen, welche sich für blau und grün phosphoreszierende OLEDs eignen.

Überraschend wurde gefunden, dass bestimmte, unten näher beschriebene Metallchelatkomplexe diese Aufgabe lösen und zu Verbesserungen der organischen Elektrolumineszenzvorrichtung führen, insbesondere hinsichtlich der Betriebsspannung, der Effizienz und der Emissionsfarbe. Insbesondere überraschend ist das Ergebnis, dass Metallkomplexe, welche ein Heteroatom als Brücke V aufweisen, wie unten näher definiert, dabei verbesserte Ergebnisse gegenüber Komplexen aufweisen, welche ein Kohlenstoffatom als Brücke V aufweisen. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung gemäß Formel (1), 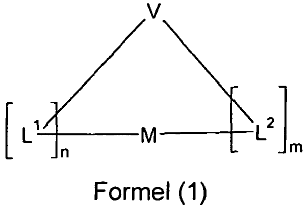 wobei L¹ gleich oder verschieden bei jedem Auftreten für einen Teilliganden der folgenden Formel (2) steht, 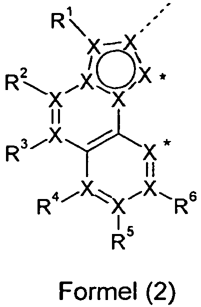 wobei die gestrichelte Bindung die Bindung an V andeutet, * die Position der Koordination an M kennzeichnet und für die verwendeten Symbole und Indizes gilt:
- M: ist ausgewählt aus der Gruppe bestehend aus Pt, Ir und Au;
- V: ist ausgewählt aus der Gruppe bestehend aus NR⁷, N⁻, BR⁷, B(R⁷)₂⁻, O, S und Se;
- X: ist bei jedem Auftreten gleich oder verschieden C oder N, wobei alle X im Teilliganden gemäß Formel (2) gemeinsam ein 14 π-Elektronensystem bilden, mit der Maßgabe, dass mindestens zwei Gruppen X und höchstens 6 Gruppen X in jedem Teilliganden der Formel (2) für N stehen;
- R¹ bis R⁶: ist bei jedem Auftreten gleich oder verschieden H, D, F, Cl, Br, I, N(R⁸)₂, CN, NO₂, Si(R⁸)₃, B(OR⁸)₂, C(=O)R⁸, P(=O)(R⁸)₂, S(=O)R⁸, S(=O)₂R⁸, OSO₂R⁸, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C=C, Si(R⁸)₂, C=O, C=S, C=NR⁸, P(=O)(R⁸), SO, SO₂, NR⁸, O, S oder CONR⁸ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁸ substituiert sein kann, oder eine Aralkyl- oder Heteroaralkylgruppe mit 5 bis 60 aromatischen Ringatomen, die durch einen oder mehrere Reste R⁸ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann; dabei können R⁴ und R⁵ und/oder R⁵ und R⁶ und/oder R¹ und R⁷ auch miteinander ein mono- oder polycyclisches, aliphatisches, aromatisches und/oder benzoannelliertes Ringsystem bilden; weiterhin können R² und R³ miteinander ein mono- oder polycyclisches, aliphatisches Ringsystem bilden;
mit der Maßgabe, dass R¹ bis R⁶ ein freies Elektronenpaar darstellt, wenn die Gruppe X, an welche dieser Rest R¹ bis R⁶ gebunden ist, ein Stickstoffatom mit abgesättigter Valenz ist;
- R⁷: ist bei jedem Auftreten gleich oder verschieden H, D, Si(R⁸)₃, C(=O)R⁸, eine geradkettige Alkyl- oder Alkoxygruppe mit 1 bis 40 C-Atomen oder eine Alkenyl- oder Alkinylgruppe mit 2 bis 40 C-Atomen oder eine verzweigte oder cyclische Alkyl- oder Alkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C=C, Si(R⁸)₂, C=O, C=S, C=NR⁸, P(=O)(R⁸), SO, SO₂, NR⁸, O, S oder CONR⁸ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁸ substituiert sein kann, oder eine Aralkyl- oder Heteroaralkylgruppe mit 5 bis 60 aromatischen Ringatomen, die durch einen oder mehrere Reste R⁸ substituiert sein kann; dabei können R¹ und R⁷ auch miteinander ein mono- oder polycyclisches, aliphatisches, aromatisches und/oder benzoannelliertes Ringsystem bilden;
- R⁸: ist bei jedem Auftreten gleich oder verschieden H, D, F, Cl, Br, I, N(R⁹)₂, CN, NO₂, Si(R⁹)₃, B(OR⁹)₂, C(=O)R⁹, P(=O)(R⁹)₂, S(=O)R⁹, S(=O)₂R⁹, OSO₂R⁹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁹ substituiert sein kann, wobei eine oder mehrere nicht benachbarte CH₂-Gruppen durch R⁹C=CR⁹, C=C, Si(R⁹)₂, C=O, C=S, C=NR⁹, P(=O)(R⁹), SO, SO₂, NR⁹, O, S oder CONR⁹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Aralkyl- oder Heteroaralkylgruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann; dabei können zwei oder mehrere benachbarte Reste R⁸ miteinander ein mono- oder polycyclisches, aliphatisches oder aromatisches Ringsystem bilden;
- R⁹: ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R⁹ auch miteinander ein mono- oder polycyclisches, aliphatisches oder aromatisches Ringsystem bilden;
- L²: ist ein bidentater Teilligand, der an V gebunden ist;
- n: ist 1 oder 2;
- m: ist (2 - n).

Sowohl der Ligand des Komplexes gemäß Formel (1) als ganzes wie auch einzelne Atome X im Teilliganden der Formel (2) können auch geladen sein.

Der Ligand des erfindungsgemäßen Komplexes ist ein tetradentater Ligand, in welchem ein bidentater Teilligand L¹ gemäß Formel (1) und ein bidentater Teilligand L² über eine Brücke V miteinander verknüpft sind.

Der Teilligand L¹ gemäß Formel (2) ist ein bidentater Ligand, welcher über ein Kohlenstoffatom und ein Stickstoffatom oder über zwei Kohlenstoffatome oder über zwei Stickstoffatome an das Metall M bindet. Wenn der Ligand über zwei Kohlenstoffatome an das Metall bindet, enthält der Ligand bevorzugt in dem koordinierenden Carben-Ring genau zwei Stickstoffatome. In einer bevorzugten Ausführungsform der Erfindung bindet der Teilligand L¹ über ein Kohlenstoffatom und ein Stickstoffatom an das Metall M.

Alle Atome X im Teilliganden L¹ gemäß Formel (2) bilden zusammen ein 14 π-Elektronensystem. Dabei trägt jedes Kohlenstoffatom 1 π-Elektron zum gesamten Elektronensystem bei. Jedes Stickstoffatom, welches nur in einem 6-Ring gebunden ist, trägt ebenfalls 1 π-Elektron zum gesamten Elektronensystem bei. Jedes Stickstoffatom, welches gleichzeitig in einem 5-Ring und einem 6-Ring gebunden ist, trägt 2 π-Elektronen zum gesamten Elektronensystem bei. Jedes Stickstoffatom, welches nur in einem 5-Ring gebunden ist, trägt 1 oder 2 π-Elektronen zum gesamten Elektronensystem bei. Dabei hängt es von der Bindung des Stickstoffs im 5-Ring ab, ob dieses Stickstoffatom 1 oder 2 π-Elektronen zum gesamten Elektronensystem beiträgt. Dabei stellt der Kreis in einem Cyclus in Formel (2), (3) und (4) ein 6 π-Elektronensystem dar, wie es üblicherweise für die Darstellung aromatischer oder heteroaromatischer Strukturen in der organischen Chemie verwendet wird. Die folgenden Strukturen erläutern nochmals, wann der Stickstoff 1 bzw. 2 π-Elektronen (in dem Schema nur als Elektronen bezeichnet) zum gesamten π-Elektronensystem beiträgt:

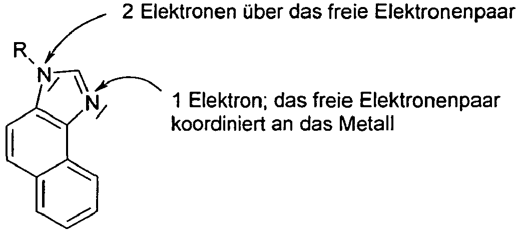

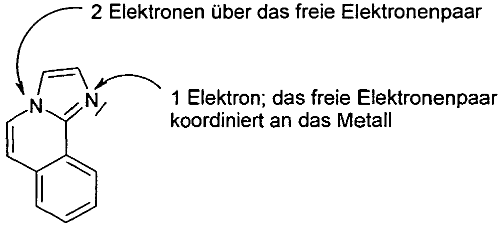

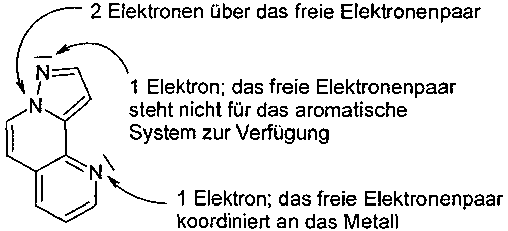

Unter einem Stickstoffatom mit abgesättigter Valenz im Sinne dieser Erfindung wird ein Stickstoffatom verstanden, welches innerhalb des aromatischen Grundgerüsts entweder formal eine Einfachbindung und eine Doppelbindung oder drei Einfachbindungen eingeht. In diesen Fällen stellt der Rest R¹ bis R⁶, welcher an dieses Stickstoffatom gebunden ist, ein freies Elektronenpaar dar. Unter einem Stickstoffatom mit nicht abgesättigter Valenz im Sinne dieser Erfindung wird dagegen ein Stickstoffatom verstanden, welches innerhalb des aromatischen Grundgerüsts formal nur zwei Einfachbindungen eingeht. In diesen Fällen stellt der Rest R¹ bis R⁶, welcher an dieses Stickstoffatom gebunden ist, einen Rest dar, wie er oben definiert ist, und kein freies Elektronenpaar. Die folgenden Strukturen erläutern nochmals, was unter einem Stickstoffatom mit abgesättigter Valenz verstanden wird:

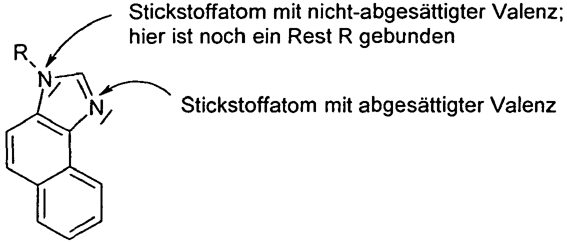

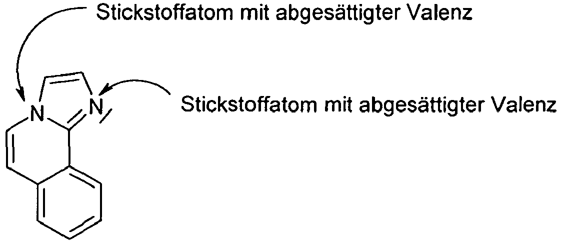

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Die Liganden können auch über ein Carben-Kohlenstoffatom an das Metall binden. Ein cyclisches Carben im Sinne dieser Erfindung ist eine cyclische Gruppe, welche über ein neutrales C-Atom an das Metall bindet. Bevorzugt sind hierbei Arduengo-Carbene, also solche Carbene, bei welchen an das Carben-C-Atom zwei Stickstoffatome gebunden sind. Dabei wird ein Fünfring-Arduengo-Carben bzw. ein anderes ungesättigtes Fünfring-Carben ebenfalls als eine Arylgruppe im Sinne dieser Erfindung angesehen. In einer bevorzugten Ausführungsform der Erfindung enthält das cyclische Carben, welches an das Metall koordiniert, genau zwei Stickstoffatome, die an das Carben-C-Atom binden, aber keine weiteren Stickstoffatome.

Ein aromatisches Ringsystem im Sinne dieser Erfindung enthält 6 bis 60 C-Atome im Ringsystem. Ein heteroaromatisches Ringsystem im Sinne dieser Erfindung enthält 1 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind.

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, n-Butyl, i-Butyl, s-Butyl, t-Butyl, 2-Methylbutyl, n-Pentyl, s-Pentyl, tert-Pentyl, 2-Pentyl, Cyclopentyl, n-Hexyl, s-Hexyl, tert-Hexyl, 2-Hexyl, 3-Hexyl, Cyclohexyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Trifluormethyl, Pentafluorethyl oder 2,2,2-Trifluorethyl verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₄₀-Alkoxygruppe werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen Ringsystem mit 5 - 60 aromatischen Ringatomen, welches noch jeweils mit den oben genannten Resten R substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt sind Verbindungen gemäß Formel (1), dadurch gekennzeichnet, dass diese nicht geladen, d. h. elektrisch neutral, sind. Dies wird auf einfache Weise dadurch erreicht, dass die Ladung der Teilliganden L¹ und L² und der verbrückenden Einheit V so gewählt werden, dass sie die Ladung des komplexierten Metallatoms M kompensieren. Wenn die Verbindung gemäß Formel (1) geladen ist, enthält sie noch ein Gegenion.

In einer bevorzugten Ausführungsform der Erfindung koordiniert der Fünfring des Teilliganden L¹ über ein Stickstoffatom an das Metall M. Eine bevorzugte Ausführungsform des Teilliganden der Formel (2) ist also die Struktur gemäß der folgenden Formel (3), 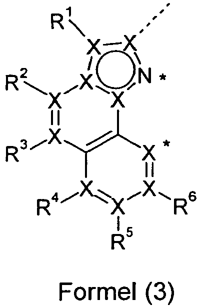 wobei die verwendeten Symbole die oben genannten Bedeutungen aufweisen und mindestens ein Symbol X und höchstens 5 Symbole X für N stehen.

In einer besonders bevorzugten Ausführungsform der Erfindung koordiniert weiterhin der Sechsring des Teilliganden L¹ über ein Kohlenstoffatom an das Metall M. Eine besonders bevorzugte Ausführungsform des Teilliganden der Formel (2) und (3) ist also die Struktur gemäß der folgenden Formel (4), 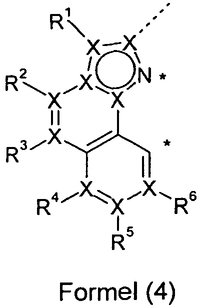 wobei die verwendeten Symbole die oben genannten Bedeutungen aufweisen und mindestens ein Symbol X und höchstens 5 Symbole X für N stehen.

In einer bevorzugten Ausführungsform der Erfindung enthält der Fünfring des Teilliganden gemäß Formel (2), (3) und (4) mindestens zwei Stickstoffatome, wobei maximal ein Atom an der Kante, die den Fünfring und den Sechsring verbindet, ein Stickstoffatom ist. Bevorzugte Ausführungsformen des Teilliganden gemäß Formel (4) sind die Teilliganden gemäß den folgenden Formeln (5), (6) und (7), 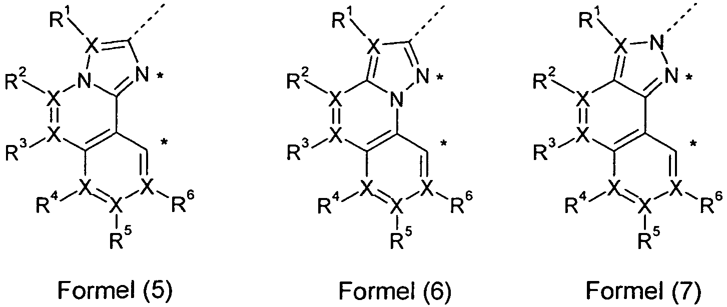 wobei die verwendeten Symbole die oben genannten Bedeutungen aufweisen und bei Verwendung der Teilliganden gemäß Formel (7) die verbrückende Einheit V ausgewählt ist aus BR⁷ und B(R⁷)₂.

Dabei enthalten die Teiliganden gemäß Formel (5), (6) und (7) insgesamt zwei, drei, vier, fünf oder sechs Stickstoffatome. Bevorzugte Ausführungsformen der Teilliganden gemäß Formel (5) sind die Teilliganden gemäß den folgenden Formeln (5a) bis (5r), bevorzugte Ausführungsformen der Teilliganden gemäß Formel (6) sind die Teilliganden gemäß den folgenden Formeln (6a) bis (6r), und bevorzugte Ausführungsformen der Teilliganden gemäß Formel (7) sind die Teilliganden gemäß den folgenden Formeln (7a) bis (7r), 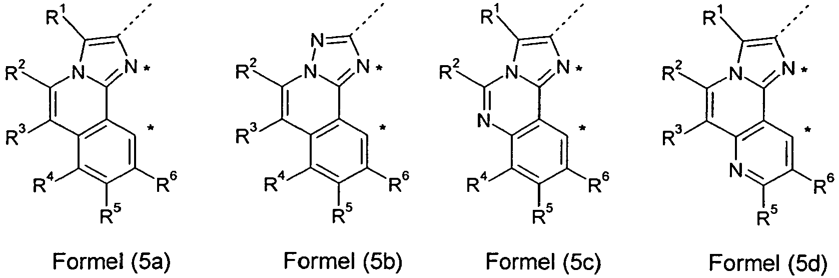 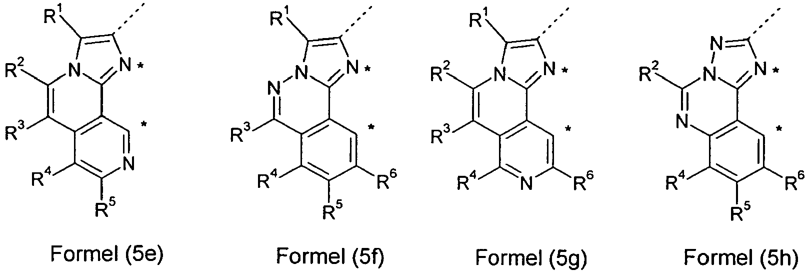 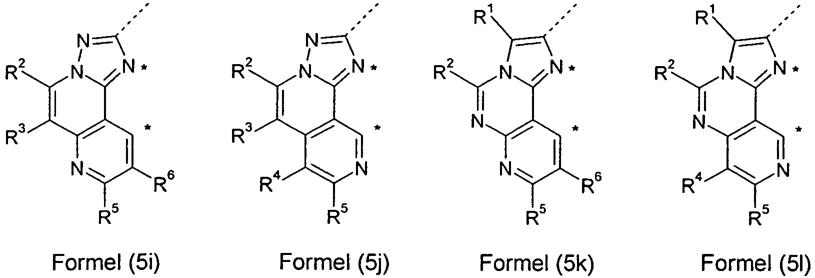 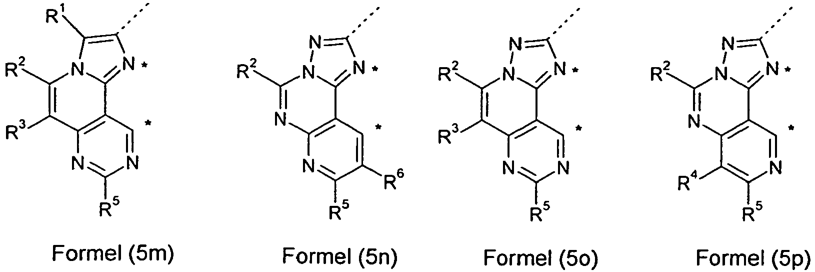 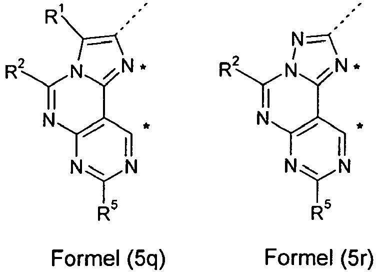 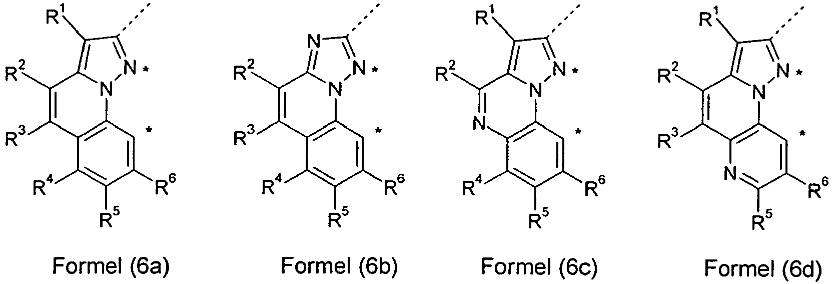 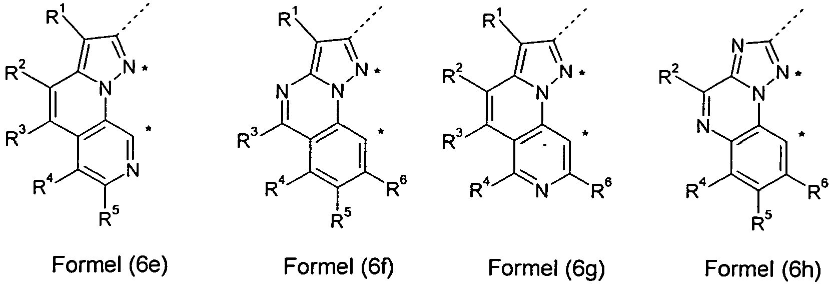 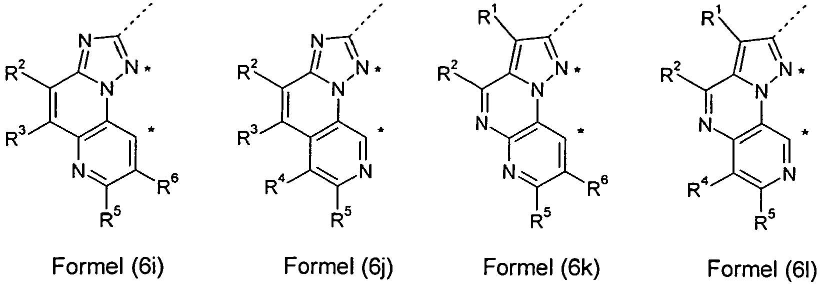 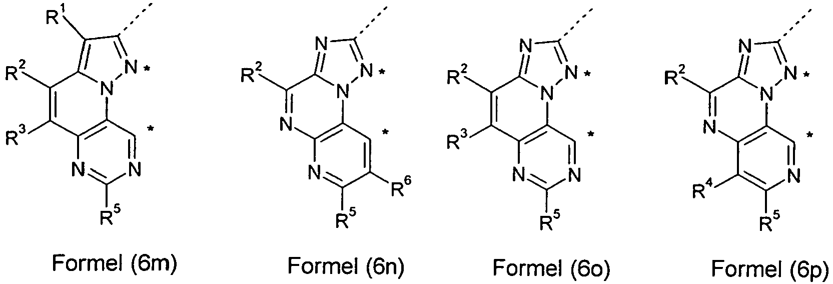 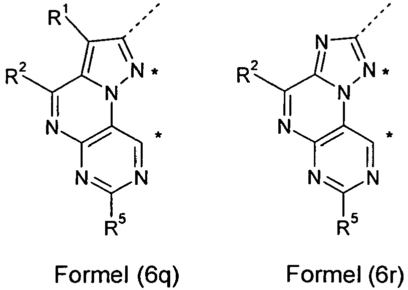 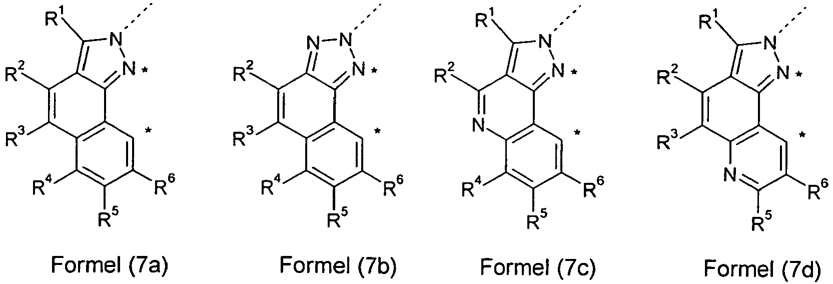 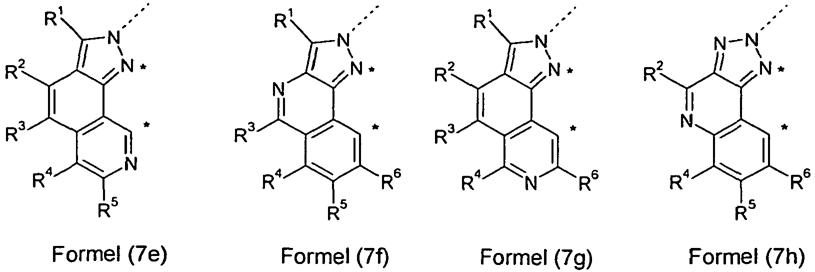 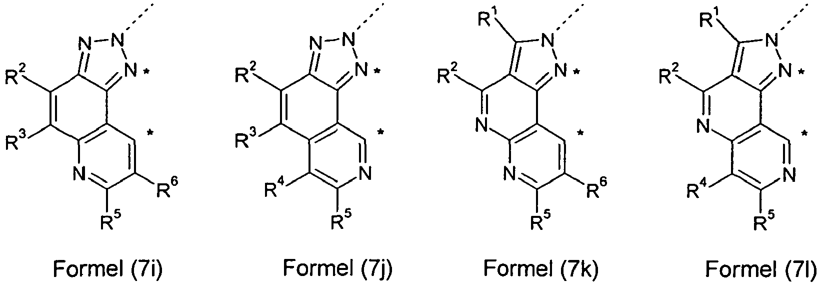 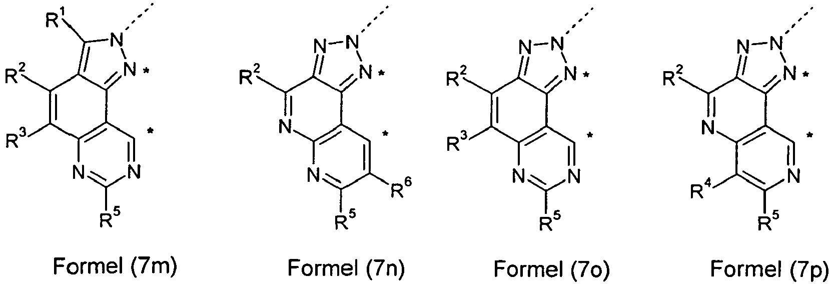 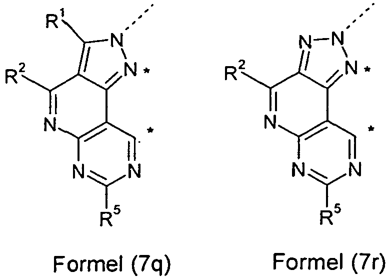 wobei die verwendeten Symbole die oben genannten Bedeutungen aufweisen.

Dabei eignen sich die Strukturen der oben abgebildeten Formeln (5f) und (5g) insbesondere für grüne Emission, während sich die Strukturen (5a) bis (5e) und (5h) bis (5r), abhängig von den weiteren Teilliganden L², insbesondere auch für blaue Emission eignen. Auch die Strukturen der Formeln (6) und (7) eignen sich für blaue und grüne Emission.

In einer bevorzugten Ausführungsform der Erfindung weist der Teilligand gemäß Formel (2), (3) und (4) insgesamt 3, 4 oder 5 Stickstoffatome auf, besonders bevorzugt 3 oder 4 Stickstoffatome, ganz besonders bevorzugt 3 Stickstoffatome.

Wenn der Teilligand gemäß Formel (2), (3) oder (4) drei oder mehr Stickstoffatome enthält, so ist es bevorzugt, wenn an ein Kohlenstoffatom, welches benachbart ist zu einem Stickstoffatom, das nicht an das Metall koordiniert ist und das nicht gleichzeitig in einem Fünfring und einem Sechsring gebunden ist, ein sterisch anspruchsvoller Rest gebunden ist. Dabei bedeutet "Kohlenstoffatom, welches benachbart ist zu einem Stickstoffatom", dass dieses Kohlenstoffatom direkt an den Stickstoff binden kann oder dass es sich um die nächstmögliche Position handelt, in der in Formel (2), (3) bzw. (4) ein Kohlenstoffatom vorhanden ist. Dies wird anhand von einem spezifischen Liganden in der folgenden schematischen Darstellung nochmals erläutert:

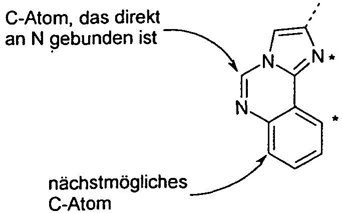

In dieser Darstellung ist sowohl das Kohlenstoffatom markiert, welches direkt an den Stickstoff gebunden ist, wie auch das nächstmögliche Kohlenstoffatom, wenn dieses nicht direkt an den Stickstoff gebunden ist. Beide Positionen gelten im Sinne der vorliegenden Anmeldung als benachbarte Positionen zu dem Stickstoffatom.

Der sterisch anspruchsvolle Rest in dieser Position ist gleich oder verschieden bei jedem Auftreten ausgewählt aus der Gruppe bestehend aus N(R⁸)₂, einer geradkettigen Alkyl-, Alkoxy- oder Thioalkoxygruppe mit 1 bis 40 C-Atomen oder einer Alkenyl- oder Alkinylgruppe mit 2 bis 40 C-Atomen oder einer verzweigten oder cyclischen Alkyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C=C, Si(R⁸)₂, C=O, C=S, C=NR⁸, P(=O)(R⁷), SO, SO₂, NR⁸, O, S oder CONR⁸ ersetzt sein können und wobei ein oder mehrere H-Atome durch D, F, Cl, Br, I oder CN ersetzt sein können, oder einem aromatischen oder heteroaromatischen Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁸ substituiert sein kann, oder eine Aralkyl- oder Heteroaralkylgruppe mit 5 bis 60 aromatischen Ringatomen, die durch einen oder mehrere Reste R⁸ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann. Jeder dieser Reste wird als "sterisch anspruchsvoller Rest" im Sinne dieser Anmeldung verstanden.

Bevorzugt ist der sterisch anspruchsvolle Rest gleich oder verschieden bei jedem Auftreten ausgewählt aus der Gruppe bestehend aus CF₃, OCF₃, einer verzweigten oder cyclischen Alkyl- oder Alkoxygruppe mit 3 bis 20 C-Atomen, die jeweils mit einem oder mehreren Resten R⁸ substituiert sein kann, wobei eine oder mehrere nicht benachbarte CH₂-Gruppen, die nicht direkt an den Liganden binden, durch R⁸C=CR⁸, C=C, Si(R⁸)₂, C=O, NR⁸, O, S oder CONR⁸ ersetzt sein können und wobei ein oder mehrere H-Atome durch D, F, Cl, Br, I oder CN ersetzt sein können, oder Si(R⁸)₃, wobei R⁸ ungleich H oder D ist, einer Dialkylaminogruppe, wobei die Alkylgruppen jeweils 1 bis 10 C-Atome aufweisen und linear, verzweigt oder cyclisch sein können, oder einem aromatischen oder heteroaromatischen Ringsystem mit 5 bis 60 aromatischen Ringatomen, das jeweils durch einen oder mehrere Reste R⁸ substituiert sein kann, oder einer Aralkyloder Heteroaralkylgruppe mit 5 bis 40 aromatischen Ringatomen, die durch einen oder mehrere Reste R⁸ substituiert sein kann.

Wenn der sterisch anspruchsvolle Rest für eine Alkylgruppe steht, dann weist diese Alkylgruppe bevorzugt 4 bis 10 C-Atome auf. Bevorzugt handelt es sich weiterhin um eine sekundäre oder tertiäre Alkylgruppe, bei der das sekundäre oder tertiäre C-Atom entweder direkt an den Liganden gebunden ist oder über eine CH₂-Gruppe an den Liganden gebunden ist. Besonders bevorzugt ist diese Alkylgruppe ausgewählt aus den Strukturen der folgenden Formeln (R-1) bis (R-33), wobei jeweils auch die Anknüpfung dieser Gruppen an den Liganden mit eingezeichnet ist: 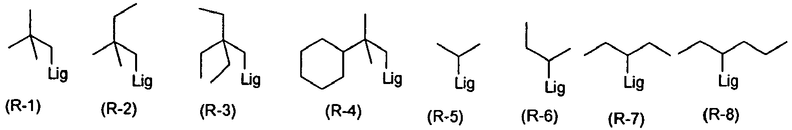 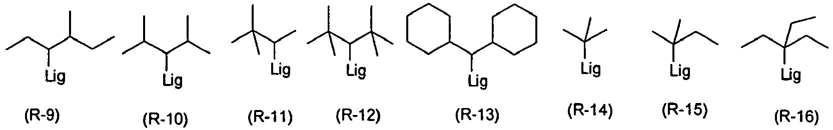 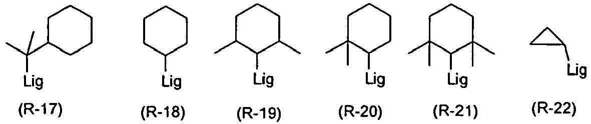 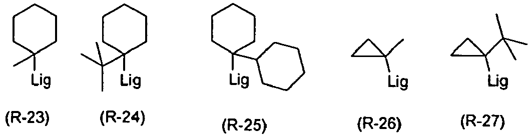 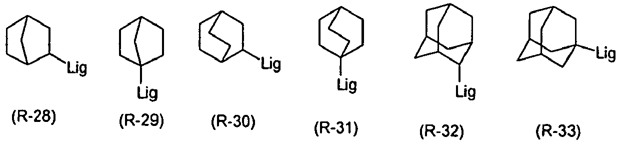 wobei Lig die Anknüpfung der Alkylgruppe an den Liganden kennzeichnet.

Wenn der sterisch anspruchsvolle Rest für eine Alkoxygruppe steht, dann weist diese Alkoxygruppe bevorzugt 3 bis 10 C-Atome auf. Bevorzugt ist diese Alkoxygruppe ausgewählt aus den Strukturen der folgenden Formeln (R-34) bis (R-47), wobei jeweils auch die Anknüpfung dieser Gruppen an den Liganden mit eingezeichnet ist: 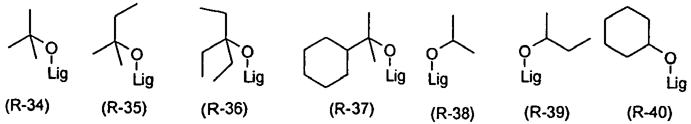 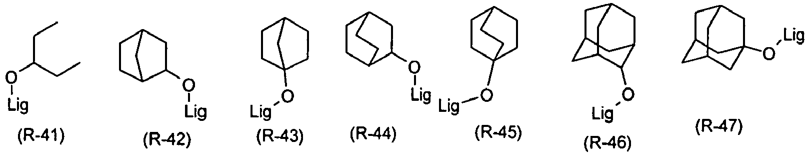 wobei Lig die Anknüpfung der Alkylgruppe an den Liganden kennzeichnet.

Wenn der sterisch anspruchsvolle Rest für eine Dialkylaminogruppe steht, dann weist jede dieser Alkylgruppen bevorzugt 1 bis 8 C-Atome auf, besonders bevorzugt 1 bis 6 C-Atome. Beispiele für geeignete Alkylgruppen sind Methyl, Ethyl oder die oben als Gruppen (R-1) bis (R-33) aufgeführten Strukturen. Besonders bevorzugt ist die Dialkylaminogruppe ausgewählt aus den Strukturen der folgenden Formeln (R-48) bis (R-55), wobei jeweils auch die Anknüpfung dieser Gruppen an den Liganden mit eingezeichnet ist: 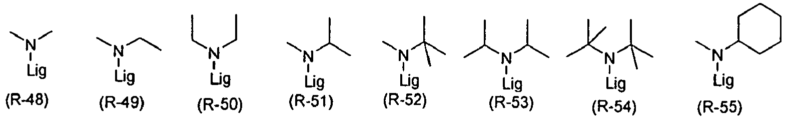 wobei Lig die Anknüpfung der Alkylgruppe an den Liganden kennzeichnet.

Wenn der sterisch anspruchsvolle Rest für eine Aralkylgruppe steht, dann ist diese Aralkylgruppe bevorzugt ausgewählt aus den Strukturen der folgenden Formeln (R-56) bis (R-69), wobei jeweils auch die Anknüpfung dieser Gruppen an den Liganden eingezeichnet ist: 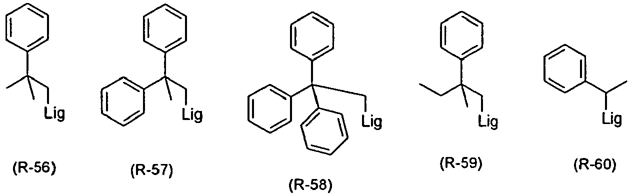 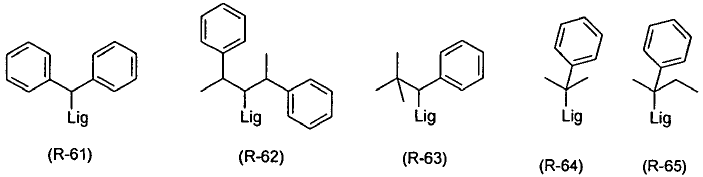 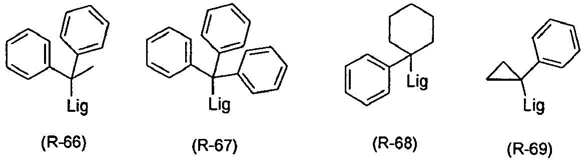 wobei Lig die Anknüpfung der Aralkylgruppe an den Liganden kennzeichnet und die Phenylgruppen jeweils durch einen oder mehrere Reste R⁸ substituiert sein können.

Die Alkyl-, Alkoxy-, Dialkylamino- und Aralkylgruppen können, je nach genauer Struktur, auch ein oder mehrere Stereozentren aufweisen. Dadurch kann die Bildung von Diastereomeren möglich sein, wenn mehrere solcher Alkyl-, Alkoxy-, Dialkylamino- und Aralkylgruppen mit Stereozentren vorliegen. Gegenstand der Erfindung sind sowohl die Mischungen der verschiedenen Diastereomere bzw. die entsprechenden Racemate wie auch die einzelnen isolierten Diastereomere bzw. Enantiomere.

Wenn der sterisch anspruchsvolle Rest für ein aromatisches bzw. heteroaromatisches Ringsystem steht, dann weist dieses aromatische bzw. heteroaromatische Ringsystem bevorzugt 5 bis 30 aromatische Ringatome auf, besonders bevorzugt 5 bis 24 aromatische Ringatome. Weiterhin enthält dieses aromatische bzw. heteroaromatische Ringsystem bevorzugt keine Aryl- bzw. Heteroarylgruppen, in denen mehr als zwei aromatische Sechsringe direkt aneinander kondensiert sind. Besonders bevorzugt enthält das aromatische bzw. heteroaromatische Ringsystem überhaupt keine kondensierten Aryl- bzw. Heteroarylgruppen, und ganz besonders bevorzugt enthält es nur Phenylgruppen. Dabei ist das aromatische Ringsystem bevorzugt ausgewählt aus den Strukturen der folgenden Formeln (R-70) bis (R-84), wobei jeweils auch die Anknüpfung dieser Gruppen an den Liganden eingezeichnet ist: 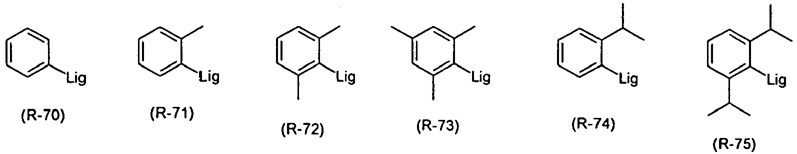 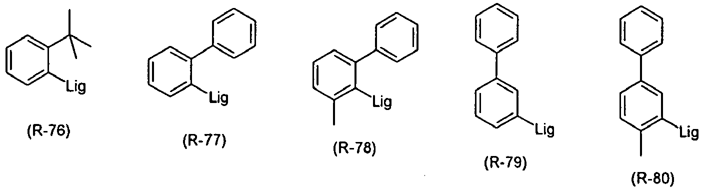 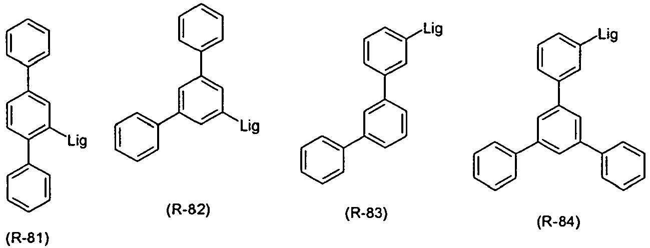 wobei Lig die Anknüpfung des aromatischen oder heteroaromatischen Ringsystems an den Liganden kennzeichnet und die Phenylgruppen jeweils durch einen oder mehrere Reste R⁸ substituiert sein können.

Weiterhin ist das heteroaromatische Ringsystem bevorzugt ausgewählt aus den Strukturen der folgenden Formeln (R-85) bis (R-112), wobei jeweils auch die Anknüpfung dieser Gruppen an den Liganden eingezeichnet ist: 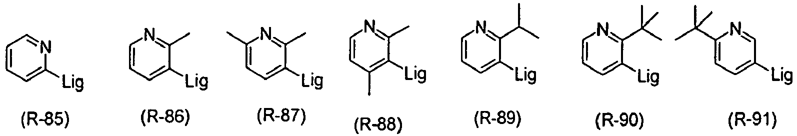 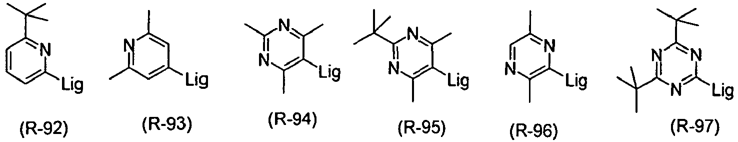 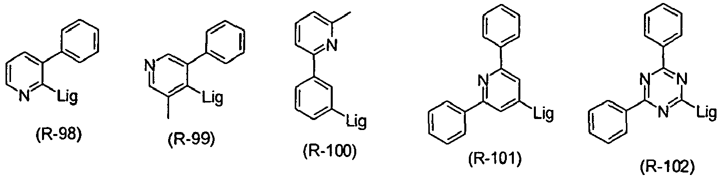 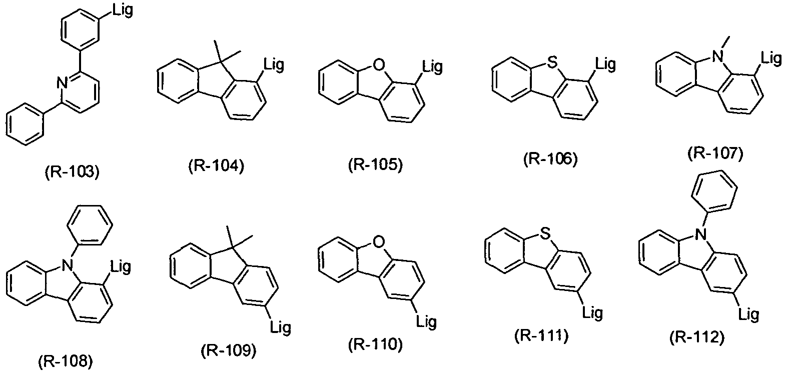 wobei Lig die Anknüpfung des aromatischen oder heteroaromatischen Ringsystems an den Liganden kennzeichnet und die aromatischen und heteroaromatischen Gruppen jeweils durch einen oder mehrere Reste R⁸ substituiert sein können.

Wenn in der Teilstruktur der Formel (2) außer den oben genannten sterisch anspruchsvollen Resten noch weitere Reste R¹ bis R⁶ gebunden sind, so sind diese Reste bei jedem Auftreten gleich oder verschieden bevorzugt ausgewählt aus der Gruppe bestehend aus H, D, F, Br, I, N(R⁸)₂, CN, Si(R⁸)₃, B(OR⁸)₂, C(=O)R⁸, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, die jeweils mit einem oder mehreren Resten R⁸ substituiert sein kann, wobei ein oder mehrere H-Atome durch D oder F ersetzt sein können, oder einem aromatischen oder heteroaromatischen Ringsystem mit 5 bis 30 aromatischen Ringatomen, das jeweils durch einen oder mehrere Reste R⁸ substituiert sein kann. Besonders bevorzugt sind diese Reste bei jedem Auftreten gleich oder verschieden ausgewählt aus der Gruppe bestehend aus H, D, F, N(R⁸)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R⁸ substituiert sein kann.

Der Index n in den erfindungsgemäßen Komplexen ist 1 oder 2, das heißt, der Komplex gemäß Formel (1) enthält ein oder zwei Teilliganden gemäß Formel (2). Wenn n = 2 ist, können die beiden Teiliganden gemäß Formel (2) gleich oder verschieden sind. Bevorzugt ist n = 2. Besonders bevorzugt sind dann die beiden Teilliganden gemäß Formel (2) gleich.

Wenn n = 1 ist, enthält der Komplex einen bidentaten Teilliganden L². Dabei ist es bevorzugt, wenn der bidentate Teilligand L² mit dem Metall M einen cyclometallierten Fünfring oder einen cyclometallierten Sechsring mit mindestens einer Metall-Kohlenstoffbindung bildet, besonders bevorzugt einen cyclometallierten Fünfring. L² ist dabei bevorzugt monoanionisch. Generell eignet sich dafür besonders die Kombination aus zwei Gruppen, wie sie durch die folgenden Formeln (8) bis (35) dargestellt sind, wobei eine Gruppe bevorzugt über ein neutrales Stickstoffatom oder ein Carbenatom bindet und die andere Gruppe bevorzugt über ein negativ geladenes Kohlenstoffatom oder ein negativ geladenes Stickstoffatom bindet. Der Teilligand L² kann dann aus den Gruppen der Formeln (8) bis (35) gebildet werden, indem diese Gruppen jeweils an der durch # gekennzeichneten Position aneinander binden. Die Position, an der die Gruppen an das Metall koordinieren, sind durch * gekennzeichnet. Dabei bindet eine der beiden Gruppen der Formeln (8) bis (35), die den Teilliganden L² bilden, an V. Diese potenziell vorhandene Bindung an V ist durch das Symbol (#) dargestellt, wobei dann in dieser Position kein Substituent gebunden ist.

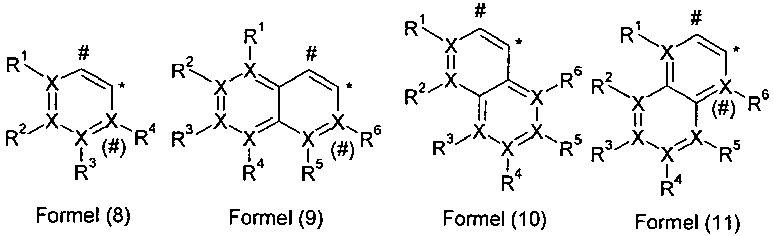

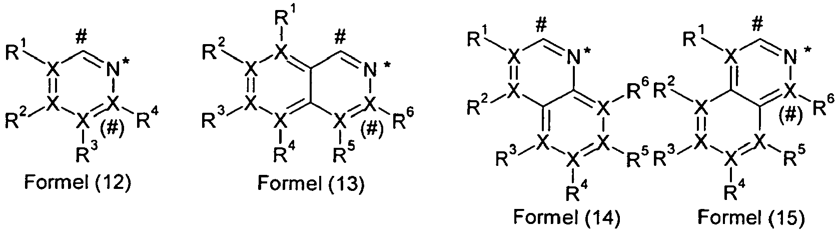

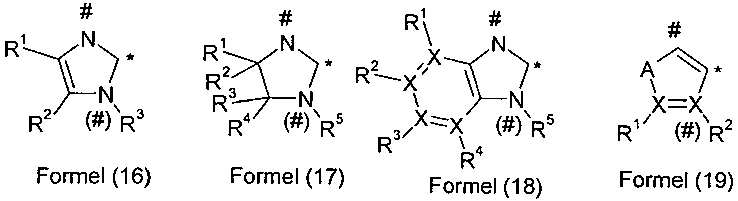

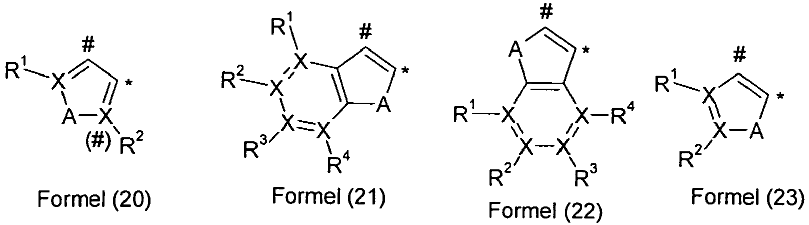

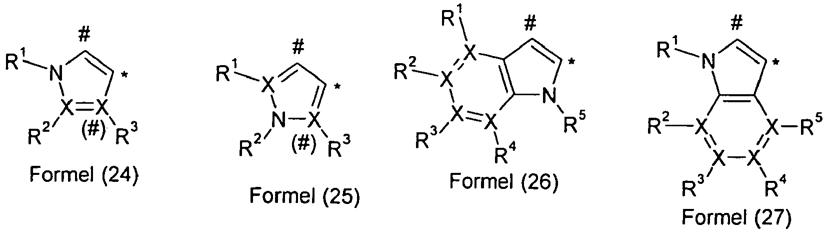

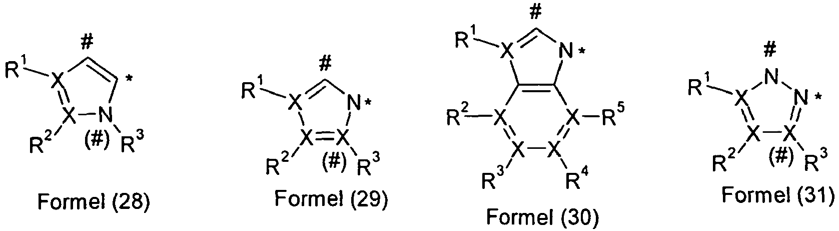

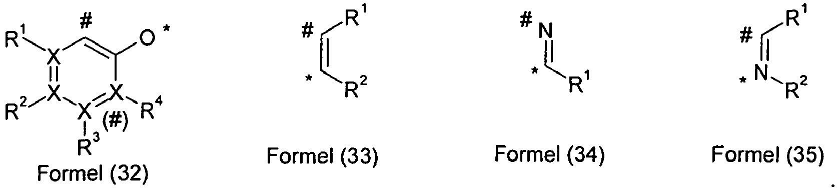

Dabei haben die verwendeten Symbole dieselbe Bedeutung wie oben beschrieben, A steht gleich oder verschieden bei jedem Auftreten für O oder S, und bevorzugt stehen maximal drei Symbole X in jeder Gruppe für N, besonders bevorzugt stehen maximal zwei Symbole X in jeder Gruppe für N, ganz besonders bevorzugt steht maximal ein Symbol X in jeder Gruppe für N. Insbesondere bevorzugt stehen alle Symbole X für C.

Bevorzugte Reste R¹ bis R⁶ in den Strukturen der Formel (8) bis (35) sind bei jedem Auftreten gleich oder verschieden ausgewählt aus der Gruppe bestehend aus H, D, F, Br, N(R⁸)₂, CN, B(OR⁸)₂, C(=O)R⁸, P(=O)(R⁸)₂, einer geradkettigen Alkylgruppe mit 1 bis 10 C-Atomen oder einer Alkenyl- oder Alkinylgruppe mit 2 bis 10 C-Atomen oder einer verzweigten oder cyclischen Alkylgruppe mit 3 bis 10 C-Atomen, die jeweils mit einem oder mehreren Resten R⁸ substituiert sein kann, wobei ein oder mehrere H-Atome durch D oder F ersetzt sein können, oder einem aromatischen oder heteroaromatischen Ringsystem mit 5 bis 14 aromatischen Ringatomen, das jeweils durch einen oder mehrere Reste R⁸ substituiert sein kann; dabei können benachbarte Reste, auch zwischen zwei der oben genannten Gruppen gemäß Formel (8) bis (35), auch miteinander ein mono- oder polycyclisches, aliphatisches, aromatisches und/oder benzoannelliertes Ringsystem bilden. Besonders bevorzugte Reste R¹ bis R⁶ sind bei jedem Auftreten gleich oder verschieden ausgewählt aus der Gruppe bestehend aus H, D, F, Br, CN, B(OR⁸)₂, einer geradkettigen Alkylgruppe mit 1 bis 5 C-Atomen, insbesondere Methyl, oder einer verzweigten oder cyclischen Alkylgruppe mit 3 bis 5 C-Atomen, insbesondere iso-Propyl oder tert-Butyl, wobei ein oder mehrere H-Atome durch D oder F ersetzt sein können, oder einem aromatischen oder heteroaromatischen Ringsystem mit 5 bis 12 aromatischen Ringatomen, das jeweils durch einen oder mehrere Reste R⁸ substituiert sein kann; dabei können benachbarte Reste, auch zwischen zwei der oben genannten Gruppen gemäß Formel (8) bis (35), auch miteinander ein mono- oder polycyclisches, aliphatisches, aromatisches und/oder benzoannelliertes Ringsystem bilden.

In einer bevorzugten Ausführungsform der Erfindung ist das Metall M Pt(II), Ir(I) oder Au(III), besonders bevorzugt Pt(II).

In einer weiteren bevorzugten Ausführungsform der Erfindung ist die verbrückende Einheit V ausgewählt aus der Gruppe bestehend aus NR⁷, O und S, besonders bevorzugt NR⁷.

Dabei ist der Substituent R⁷ bevorzugt ausgewählt aus der Gruppe bestehend aus einer geradkettigen Alkylgruppe mit 1 bis 20 C-Atomen oder einer verzweigten oder cyclischen Alkylgruppe mit 3 bis 20 C-Atomen, die jeweils mit einem oder mehreren Resten R⁸ substituiert sein kann, wobei ein oder mehrere H-Atome durch D, F oder CN ersetzt sein können, oder einem aromatischen oder heteroaromatischen Ringsystem mit 5 bis 60 aromatischen Ringatomen, das jeweils durch einen oder mehrere Reste R⁸ substituiert sein kann. Besonders bevorzugt ist R⁷ ausgewählt der einer Arylgruppe, welche in mindestens einer ortho-Position, bevorzugt in beiden ortho-Positionen zur Bindung an N mit einem Substituenten R⁸ ungleich H oder D substituiert ist und welche in den anderen Positionen ebenfalls durch Substituenten R⁸ substituiert sein kann. Ganz besonders bevorzugt steht R⁷ für eine Phenylgruppe, welche in mindestens einer und bevorzugt in beiden ortho-Positionen zur Bindung an den Stickstoff mit einer Alkylgruppe mit 1 bis 4 C-Atomen substituiert ist, insbesondere Methyl, Ethyl, iso-Propyl oder tert-Butyl, und welche an den weiteren Positionen durch weitere Substituenten R⁸ substituiert sein kann, oder für eine lineare oder verzweigte Oligophenylgruppe mit 2 bis 5 Phenylgruppen. Besonders geeignete Substituenten R⁷ sind ausgewählt aus den Gruppen der folgenden Formeln (36) bis (45), 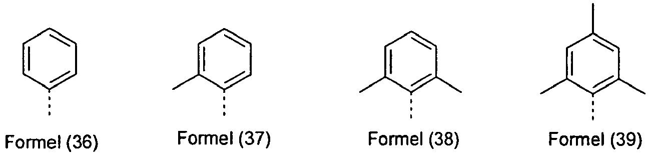 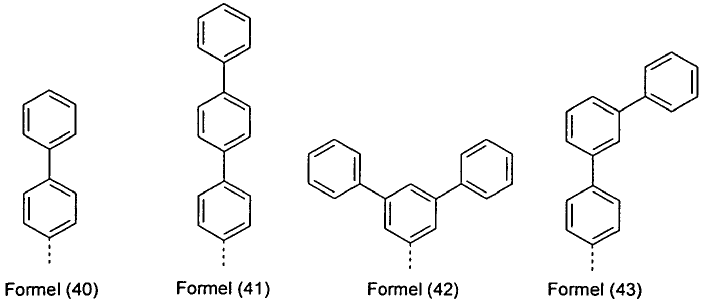 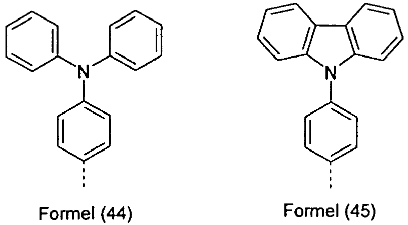 wobei die gestrichelte Bindung die Bindung an das Boratom bzw. das Stickstoffatom darstellt und die terminalen Phenylgruppen in Formel (44) auch durch ein oder mehrere Alkylgruppen mit 1 bis 5 C-Atomen substituiert sein können. Besonders bevorzugt sind unter diesen Gruppen die Gruppen die Formeln (39), (40) und (45).

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die erfindungsgemäßen Metallkomplexe sind prinzipiell durch verschiedene Verfahren darstellbar. Es haben sich jedoch die im Folgenden beschriebenen Verfahren als besonders geeignet herausgestellt.

Daher ist ein weiterer Gegenstand der vorliegenden Erfindung ein Verfahren zur Herstellung der Verbindungen gemäß Formel (1) durch Umsetzung der entsprechenden freien Liganden mit Metallalkoholaten der Formel (46), mit Metallketoketonaten der Formel (47) oder mit Metallhalogeniden der Formel (48),

M(OR⁸)ₚ Formel (46)

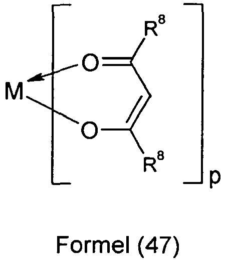

MHaIₚ Formel (48)

wobei die Symbole M und R⁸ die oben angegebenen Bedeutungen haben, Hal = F, Cl, Br oder I ist und p je nach Wertigkeit des Metalls M für 1, 2 oder 3 steht.

Geeignete Platin-Edukte sind beispielsweise PtCl₂, K₂[PtCl₄], PtCl₂(DMSO)₂, Pt(Me)₂(DMSO)₂ oder PtCl₂(Benzonitril)₂. Geeignete Gold-Edukte sind beispielsweise AuCl₃, HAuCl₄, KAuCl₄ oder (PPh₃)AuCl. Geeignete Iridium-Edukte sind beispielsweise [Ir(COD)Cl)]₂, Ir(COD)₂BF₄ oder Ir(PPh₃)₂(CO)Cl.

Geeignete Syntheseverfahren der Komplexe können beispielsweise die Umsetzung von K₂PtCl₄ mit einem Äquivalent des Liganden und einem Überschuss von ca. 40 Äquivalenten Lithiumacetat in Eisessig oder die Umsetzung von PtCl₂ mit einem Äquivalent des Liganden in Benzonitril unter Rückfluss sein.

Dabei kann die Synthese beispielsweise auch thermisch, photochemisch und/oder durch Mikrowellenstrahlung aktiviert werden. Dabei kann die Reaktion auch ohne die Verwendung eines zusätzlichen Lösemittels in der Schmelze durchgeführt werden. Dabei bedeutet "Schmelze", dass der Ligand geschmolzen vorliegt und die Metall-Vorstufe in dieser Schmelze gelöst oder suspendiert ist.

Durch diese Verfahren lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die Synthese der Ligandenvorstufen, der Liganden und der erfindungsgemäßen Verbindungen ist in Schema 1, 2 und 3 zusammengefasst.

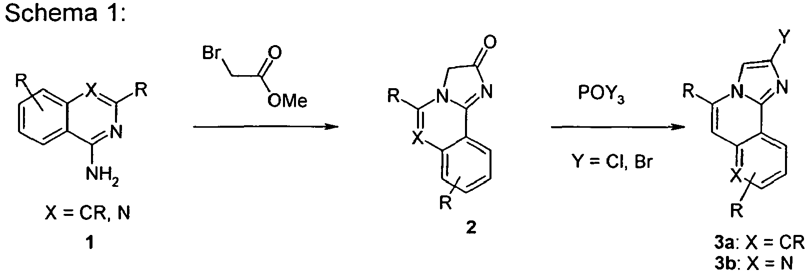

Ausgehend von 1-Aminoisochinolinen bzw. 4-Aminochinazolinen 1 sind durch Umsetzung dieser mit Bromessigsäuremethylester Imidazo[2,1-a]isochinolin-2-on bzw. Imidazo[1,2-c]chinazolin-2-on **2** zugänglich, die dann mit POCl₃ bzw. POBr₃ in die 2-Halogen-imidazo[2,1-a]isochinoline **3a** bzw. die 2-Halogen-imidazo[1,2-c]chinazoline **3b** umgesetzt werden können (T. A. Kuzmenko et al., Khimiya Geterotsiklicheskikh Soedinenii 1992, 12, 1698-705; C. Hamadouchi et al. Boorg. & Med. Chem. Lett. 2005,15, 1943).

3-Substituierte 2-Halogenimidazo[2,1-a]isochinoline, 2-Halogenimidazo-[1,2-c]chinazoline, Imidazo[2,1-f][1,6]naphthyridine bzw. 1,3a,5,6-Tetraazacyclopenta[a]naphthaline (6, 10, 14) können gemäß Schema 2 dargestellt werden.

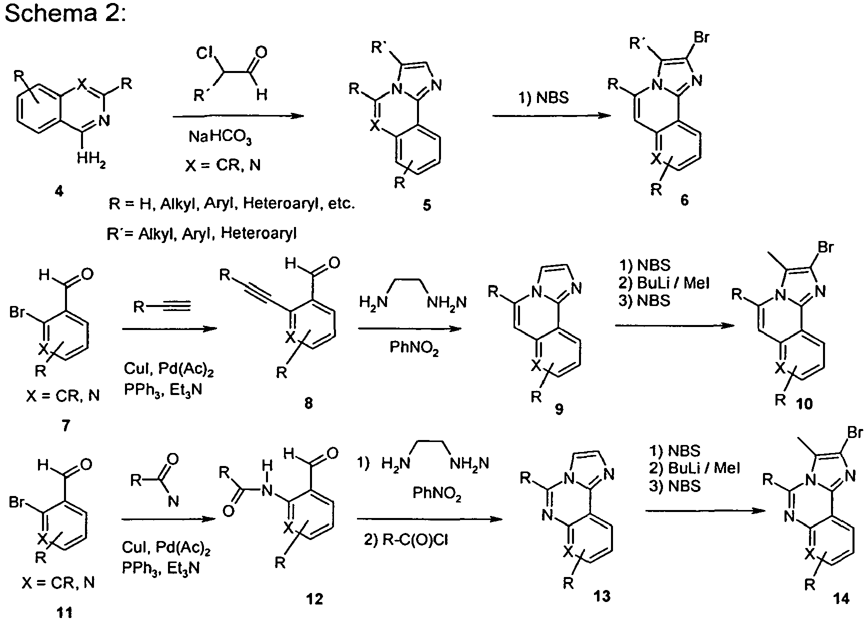

Die halogenierten Verbindungen **3a,b, 6, 10, 14** können dann, wie in Schema 3 gezeigt, durch Etherbildung, Aminierung nach Ullmann oder Buchwald bzw. durch Lithiierung und Boranylierung zu tetradentaten Liganden **(15, 16, 17)** umgewandelt werden, die durch Umsetzung mit geeigneten Metall-Precursoren zu den erfindungsgemäßen Komplexen **(18, 19, 20)** umgesetzt werden können.

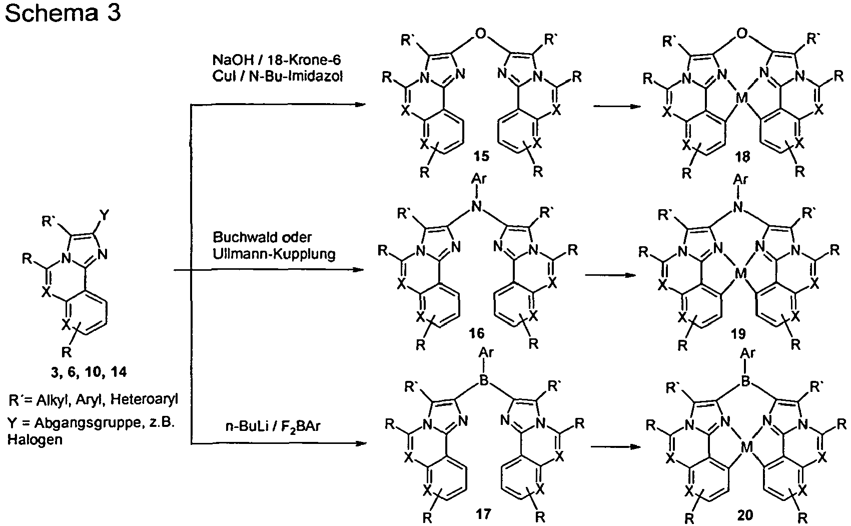

Die erfindungsgemäßen Verbindungen können auch durch geeignete Substitution, beispielsweise durch Alkylgruppen, insbesondere verzweigte Alkylgruppen, oder gegebenenfalls substituierte Arylgruppen, beispielsweise Xylyl-, Mesityl- oder verzweigte Terphenyl- bzw. Quaterphenylgruppen, löslich gemacht werden. Diese löslichen Verbindungen eignen sich besonders gut für die Verarbeitung aus Lösung, beispielsweise durch Druckverfahren.

Ein weiterer Gegenstand der vorliegenden Erfindung ist daher eine Formulierung, insbesondere eine Lösung, Suspension oder Miniemulsion, enthaltend ein oder mehrere Verbindungen gemäß Formel (1) und mindestens eine Lösemittel.

Die oben beschriebenen Komplexe gemäß Formel (1) bzw. die oben aufgeführten bevorzugten Ausführungsformen können in der elektronischen Vorrichtung als aktive Komponente verwendet werden. Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens eine Verbindung der oben aufgeführten Formel (1) enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs) oder organischen Laserdioden (O-Laser), enthaltend in mindestens einer Schicht mindestens eine Verbindung gemäß der oben aufgeführten Formel (1). Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Ebenso können zwischen zwei emittierende Schichten Interlayers eingebracht sein, welche beispielsweise eine Excitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

In einer bevorzugten Ausführungsform der Erfindung enthält die organische Elektrolumineszenzvorrichtung die Verbindung gemäß Formel (1) bzw. die oben aufgeführten bevorzugten Ausführungsformen als emittierende Verbindung in einer oder mehreren emittierenden Schichten.

Wenn die Verbindung gemäß Formel (1) als emittierende Verbindung in einer emittierenden Schicht eingesetzt wird, wird sie bevorzugt in Kombination mit einem oder mehreren Matrixmaterialien eingesetzt. Die Mischung aus der Verbindung gemäß Formel (1) und dem Matrixmaterial enthält zwischen 1 und 99 Vol.-%, vorzugsweise zwischen 2 und 90 Vol.-%, besonders bevorzugt zwischen 3 und 40 Vol.-%, insbesondere zwischen 5 und 15 Vol.-% der Verbindung gemäß Formel (1) bezogen auf die Gesamtmischung aus Emitter und Matrixmaterial. Entsprechend enthält die Mischung zwischen 99 und 1 Vol.-%, vorzugsweise zwischen 98 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zink komplexe, z. B. gemäß EP 652273 oder WO 2009/062578, Dibenzofuranderivate, z. B. gemäß WO 2009/148015, oder verbrückte Carbazolderivate, z. B. gemäß US 2009/0136779, WO 2010/050778, WO 2011/042107 oder der nicht offen gelegten Anmeldung DE 102010005697.9.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Komplexe gemäß Formel (1) als Co-Matrix für längerwellig emittierende Triplettemitter, beispielsweise für grün oder rot emittierende Triplettemitter, eingesetzt werden.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial oder als Elektronenblockiermaterial.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, AI, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent sein, um entweder die Bestrahlung des organischen Materials (O-SC) oder die Auskopplung von Licht (OLED/PLED, O-LASER) zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere, z. B. PEDOT, PANI oder Derivate dieser Polymere.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold *et al., Appl. Phys. Lett.* **2008,** *92*, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend eine Verbindung gemäß Formel (1) und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch folgende überraschende Vorteile gegenüber dem Stand der Technik aus:
1. Organische Elektrolumineszenzvorrichtungen enthaltend Verbindungen gemäß Formel (1) als emittierende Materialien weisen eine exzellente Lebensdauer auf.
2. Organische Elektrolumineszenzvorrichtungen enthaltend Verbindungen gemäß Formel (1) als emittierende Materialien weisen eine hervorragende Effizienz auf.
3. Mit den erfindungsgemäßen Metallkomplexen sind organische Elektrolumineszenzvorrichtungen zugänglich, welche im blauen Farbbereich phosphoreszieren. Insbesondere blaue Phosphoreszenz ist gemäß dem Stand der Technik nur sehr schwierig mit guten Effizienzen und Lebensdauern zu verwirklichen.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht gehandhabt. Die Lösungsmittel und Reagenzien können z.B. von Sigma-ALDRICH bzw. ABCR bezogen werden. Die Zahlen in eckigen Klammern beziehen sich auf die CAS-Nummern der literaturbekannten Verbindungen.

### A: Synthese von Synthonen S:

### 1) 3-Methyl-6-(2,4,6-trimethyl-phenyl)-imidazo[2,1-a]isochinolin S1

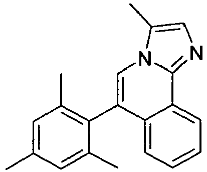

### 1a) 4-Brom-isochinolin-1-ylamin

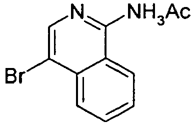

Eine Suspension von 36.0 g (250 mmol) 1-Amino-isochinolin [1532-84-9] in 450 ml Eisessig wird portionsweise mit 47.2 g (265 mmol) N-Bromsuccinimid versetzt und 6 h bei 20 °C gerührt. Man saugt vom ausgefallenen Feststoff ab, wäscht diesen zweimal mit je 100 ml Eisessig, zweimal mit je 100 ml Diethylether und trocknet im Vakuum. Ausbeute: 67.5 g (238 mmol), 95.4 %. Reinheit: ca. 98 %ig nach ¹H-NMR.

### 1b) 6-Brom-imidazo[2,1-a]isochinolin

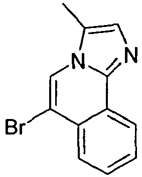

Eine Mischung von 28.4 g (100 mmol) 4-Brom-1-amino-isochinolin x HAc, 25.2 ml (300 mmol) 2-Chlorpropanal, 33.6 g (400 mmol) Natriumhydrogencarbonat, 300 ml Ethanol und 50 ml Wasser wird 24 h unter Rückfluss erhitzt. Man engt die Reaktionsmischung komplett ein, nimmt den Rückstand in 300 ml Dichlormethan auf, wäscht die organische Phase zweimal mit Wasser und einmal mit gesättigter Kochsalzlösung, trocknet über Natriumsulfat und entfernt das Lösungsmittel im Vakuum. Das so erhaltene Öl wird im Ölpumpenvakuum durch Kugelrohrdestillation von Leichtsiedern und nicht flüchtigen Anteilen befreit. Ausbeute: 23.0 g (88 mmol) 88.0 %. Reinheit: ca. 98 %ig nach ¹H-NMR.

### 1c) 6-(2,4,6-Trimethyl-phenyl)-imidazo[2,1-a]isochinolin, S1

Ein Gemisch aus 13.1 g (50 mmol) 6-Brom-imidazo[2,1-a]isochinolin, 24.6 g (150 mmol) Mesitylboronsäure, 53.1 g (250 mmol) Trikaliumphosphat, 4.1 g (10 mmol) Dicyclohexyl-phosphino-2',6'-dimethoxybiphenyl, 1.1 g (5 mmol) Palladium(II)acetat, 100 g Glaskugeln (3 mm Durchmesser) und 200 ml Touol wird 48 h bei 80 °C gerührt. Nach Erkalten saugt man von den Glasperlen und den Salzen ab, wäscht diese zweimal mit Toluol nach, wäscht die organische Phase dreimal mit 300 ml Wasser, trocknet über Natriumsulfat, entfernt dann das Toluol im Vakuum, und chromatographiert den Rückstand mit Ethylacetat : Heptan an Kieselgel. Ausbeute: 8.5 g (28 mmol) 56.1 %. Reinheit: ca. 98 %ig nach ¹H-NMR.

### 2) 5-tert-Butyl-imidazo[1,2-c]chinazolin, S8

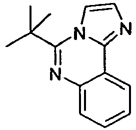

### 2a) N-(2-Formyl-phenyl)-2,2-dimethyl-propionamid, S2

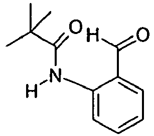

Ein Gemisch aus 18.5 g (100 mmol) 2-Brombenzaldehyd [6630-33-7], 14.2 g (140 mmol) Pivalinsäureamid [754-10-9], 81.5 g (250 mmol) Cäsiumcarbonat, 1.7 g (3 mmol) 9,9-Dimethyl-4,5-bis(diphenylphosphino)-xanthen und 630 mg (2.8 mmol) Palladium(II)acetat in 400 ml Dioxan wird 4 h bei 100 °C gerührt. Nach Erkalten wird das Lösungsmittel im Vakuum entfernt, der Rückstand wird in 1000 ml Ethylacetat aufgenommen, die organische Phase wird dreimal mit je 300 ml Wasser und einmal mit 300 ml gesättigter Kochsalzlösung gewaschen, über eine kurze KieselgelSäule filtriert und das Lösungsmittel im Vakuum entfernt. Ausbeute: 18.7 g (91 mmol), 91.1 %. Reinheit: ca. 95 %ig nach ¹H-NMR.

Analog werden folgende Verbindungen dargestellt:

| Bsp. | Edukt | Produkt | Ausbeute |
|---|---|---|---|
| S3 | 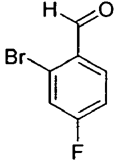 | 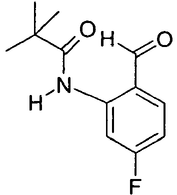 | 93 % |
| | [59142-68-6] | | |
| S4 | 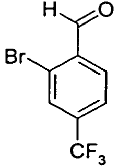 | 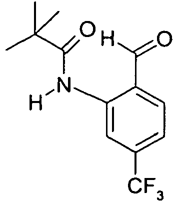 | 88 % |
| | [85118-24-7] | | |
| S5 | 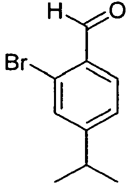 | 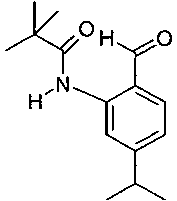 | 90% |
| | [861897-63-4] | | |
| S6 | 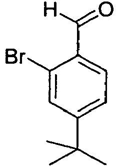 | 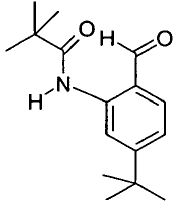 | 94 % |
| | [246139-77-5] | | |
| S7 | 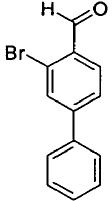 | 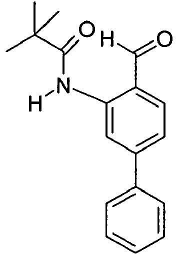 | 89% |
| | [1237125-81-3] | | |

### 2b) 5-tert-Butyl-imidazo[1,2-c]chinazolin, S8

Ein Gemisch aus 20.5 g (100 mmol) N-(2-Formyl-phenyl)-2,2-dimethylpropionamid, S2, 8.0 ml (120 mmol) Ethylendiamin, 50 ml Ethanol und 50 ml Nitrobenzol wird 30 min. bei Raumtemperatur gerührt. Anschließend erhitzt man die Reaktionsmischung langsam auf 200 °C, wobei das Ethanol, überschüssiges Ethylendiamin und Wasser sukzessive abdestillieren. Man rührt 6 h bei 200 °C nach und lässt auf Raumtemperatur erkalten, wobei das N-[2-(1H-Imidazol-2-yl)-phenyl]-2,2-dimethylpropionamid ausfällt. Nach Absaugen und Waschen mit Ethanol wird der Feststoff in einem Gemisch aus 150 ml Dioxan und 12.0 ml (100 mmol) Pivalinsäurechorid [3282-340-2] suspendiert. Die Suspension wird 20 h unter Rückfluss erhitzt, nach Erkalten auf 500 ml Eiswasser gegeben, das ausgefallene Öl wird in 500 ml Ethylacetat aufgenommen, die organische Phase wird dreimal mit je 300 ml Wasser und einmal mit gesättigter Kochsalzlösung gewaschen und über Natriumsulfat getrocknet. Das nach Einengen erhaltene rote Öl wird an Aluminiumoxid (basisch Aktivitätsstufe 1) mit Dichlormethan chromatographiert. Ausbeute: 10.6 g (47 mmol), 47.0 %. Reinheit: ca. 97 % nach ¹H-NMR.

Analog werden folgende Verbindungen dargestellt:

| Bsp. | Edukt | Produkt | Ausbeute |
|---|---|---|---|
| S9 | 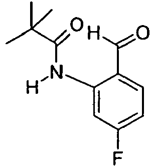 | 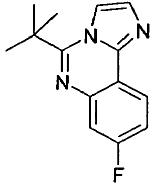 | 39% |
| | S3 | | |
| S10 | 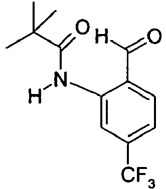 | 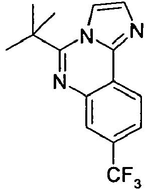 | 40% |
| | S4 | | |
| S11 | 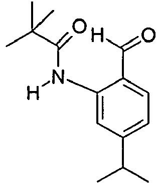 | 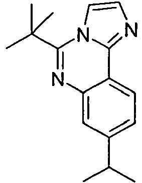 | 28% |
| | S5 | | |
| S12 | 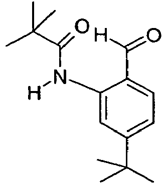 | 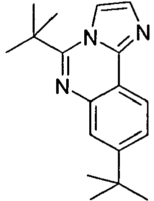 | 44 % |
| | S6 | | |
| S13 | 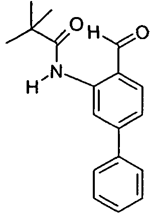 | 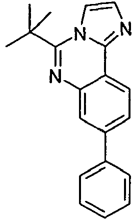 | 46% |
| | S7 | | |

### 3) 5,8-Di-tert-butyl-imidazo[2,1-f][1,6]naphthyridin, S14

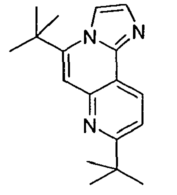

Ein Gemisch aus 24.3 g (100 mmol) 6-tert-Butyl-2-(3,3-dimethyl-but-1-inyl)-pyridin-3-carboxaldehyd (EP 10006208.2), 8.0 ml (120 mmol) Ethylendiamin und 300 ml Nitrobenzol wird langsam auf 200 °C erhitzt und 8 h bei dieser Temperatur gerührt. Dann steigert man die Temperatur, destilliert das Nitrobenzol ab und legt gegen Ende ein Vakuum von ca. 50 mbar an, um letzte Reste an Nitrobenzol zu entfernen. Man nimmt den Rückstand in 50 ml Dichlormethan auf und chromatographiert an Kieselgel, wobei zunächst mit Dichlormethan Nebenprodukte und dann das Produkt mit Ethylacetat eluiert wird. Ausbeute: 21.2 g (75 mmol), 75.2 %. Reinheit: ca. 97 % nach ¹H-NMR.

Analog werden folgende Verbindungen dargestellt:

| Bsp. | Edukt | Produkt | Ausbeute |
|---|---|---|---|
| S15 | 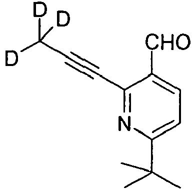 | 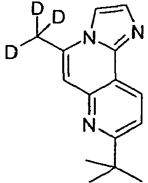 | 56 % |
| | gemäß EP 10006208.2 | | |
| S16 | 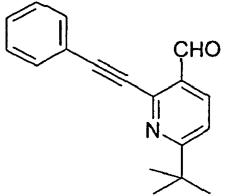 | 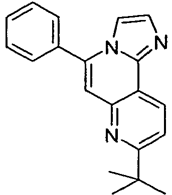 | 68 % |
| | gemäß EP 10006208.2 | | |
| S17 | 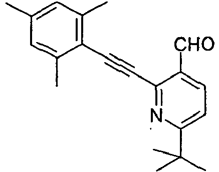 | 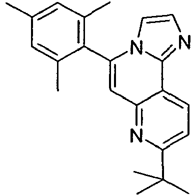 | 59% |
| | gemäß EP 10006208.2 | | |
| S18 | 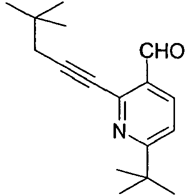 | 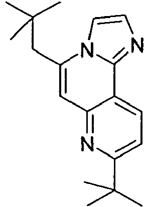 | 48 % |
| | gemäß EP 10006208.2 | | |

### 4) 4,7-Di-tert-butyl-1,3a,5,6-tetraazacyclopenta[a]naphthalin, S19

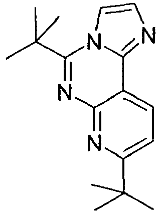

Durchführung analog 2b), jedoch wird statt N-(2-Formyl-phenyl)-2,2-dimethylpropionamid 2-N-Pivaloylamido-3-cyano-6-tert-butyl-pyridin (gemäß EP 10006208.2) eingesetzt. Ausbeute: 8.4 g (30 mmol), 29.7 %. Reinheit: ca. 97 % nach ¹H-NMR.

### 5) 4,7-Di-tert-butyl-1,3a,5,8-pentaazacyclopenta[a]naphthalin, S20

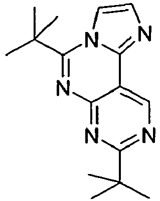

Durchführung analog 2b) jedoch wird statt N-(2-Formyl-phenyl)-2,2-dimethyl-propionamid 2-tert-Butyl-4-(2,2-dimethyl-propinylamino)-pyrimidin-5-carbonsäuremethylester (gemäß EP 10006208.2) eingesetzt. Ausbeute: 9.2 g (32 mmol), 32.4 %. Reinheit: ca. 97 % nach ¹H-NMR.

### 6) 5-tert-Butyl-3-methyl-imidazo[1,2-c]chinazolin, S21

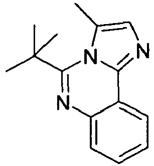

Eine gut gerührte Lösung von 22.5 g (100 mmol) 5-tert-Butyl-imidazo[1,2-c]chinazolin, S8 in 300 ml THF wird bei 20 °C portionsweise mit 18.8 g (105 mmol) N-Bromsuccinimid versetzt. Nach 2 h wird das THF im Vakuum entfernt, der Rückstand wird in 500 ml Ethylacetat gelöst, dreimal mit je 300 ml Wasser und einmal mit 300 ml gesättigter Kochsalzlösung gewaschen. Nach Entfernen des Ethylacetats wird der Rückstand mit Dichlormethan an Kieselgel chromatographiert. Die so erhaltenen 20.0 g (66 mmol) 5-tert-Butyl-3-brom-imidazo[1,2-c]chinazolin werden in 500 ml Diethylether gelöst, die Lösung wird auf -78 °C gekühlt, tropfenweise mit 28.0 ml (70 mmol) n-Buthyllithium, 2.5 M in n-Hexan versetzt und 15 min. nachgerührt. Die so erhaltene gelbe Suspension wird unter gutem Rühren auf ein Mal mit 6.2 ml (100 mmol) Methyliodid versetzt. Man entfernt das Kältebad und lässt langsam auf Raumtemperatur erwärmen, wäscht die gelbe Lösung zweimal mit je 200 ml 5 Gew.-%iger Ammoniaklösung, trocknet über Natriumsulfat und entfernt dann den Diethylether im Vakuum. Der Rückstand wird aus ca. 50 ml Cyclohexan umkristallisiert. Ausbeute: 8.5 g (35 mmol), 35.5 %. Reinheit: ca. 97 % nach ¹H-NMR.

Analog werden folgende Verbindungen dargestellt:

| Bsp. | Edukt | Produkt | Ausbeute |
|---|---|---|---|
| S22 | 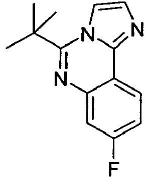 | 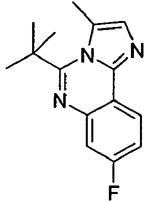 | 38 % |
| | S9 | | |
| S23 | 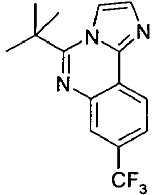 | 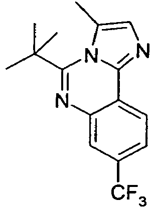 | 36 % |
| | S10 | | |
| S24 | 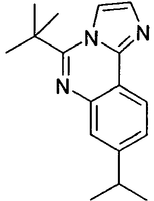 | 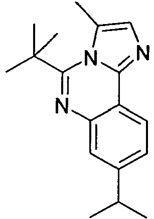 | 28 % |
| | S11 | | |
| S25 | 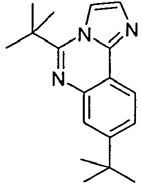 | 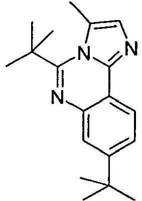 | 37 % |
| | S12 | | |
| S26 | 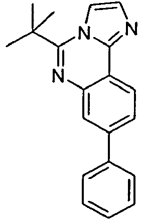 | 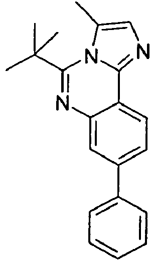 | 41 % |
| | S13 | | |
| S27 | 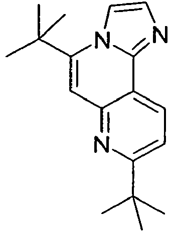 | 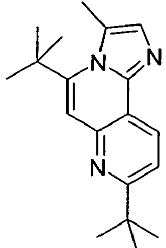 | 42% |
| | S14 | | |
| S28 | 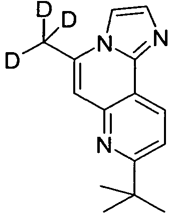 | 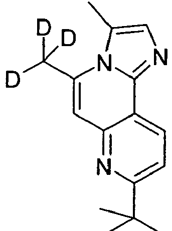 | 33 % |
| | S15 | | |
| S29 | 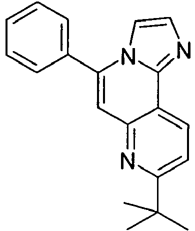 | 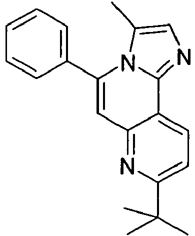 | 36% |
| | S16 | | |
| S30 | 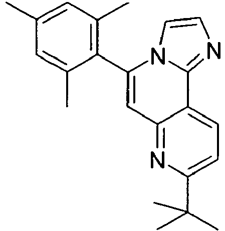 | 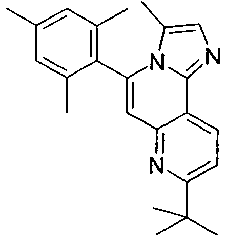 | 40% |
| | S17 | | |
| S31 | 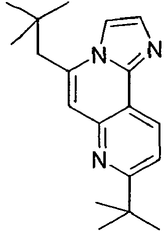 | 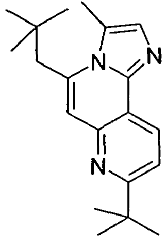 | 33 % |
| | S18 | | |
| S32 | 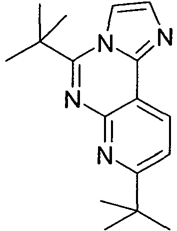 | 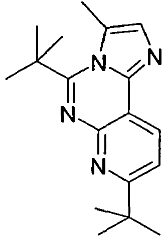 | 35 % |
| | S19 | | |
| S33 | 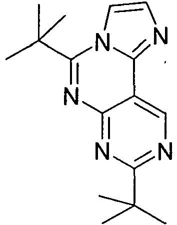 | 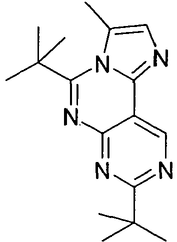 | 27% |
| | S20 | | |

### 6) 2-Brom-3-methyl-6-(2,4,6-trimethylphenyl)-imidazo[2,1-a]isochinolin, S34

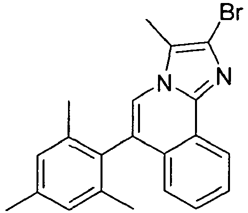

Zu einer gut gerührten Lösung von 18.8 g (105 mmol) N-Bromsuccinimid in 400 ml DMF tropft man langsam eine Lösung von 30.0 g (100 mmol) 3-Methyl-6-(2,4,6-trimethylphenyl)-imidazo[2,1-a]isochinolin, S1 in 200 ml DMF. Man rührt 1 h nach, entfernt dann das DMF im Vakuum und kristallisiert den Rückstand aus Ethylacetat / Methanol um. Ausbeute: 22.9 g (60 mmol), 60.4 %. Reinheit: ca. 97 % nach ¹H-NMR.

| Bsp. | Edukt | Produkt | Ausbeute |
|---|---|---|---|
| S35 | 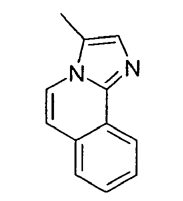 | 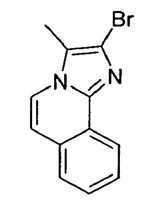 | 45 % |
| | gemäß WO 2010/086089 | | |
| S36 | 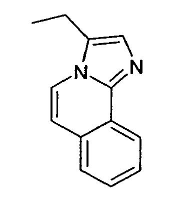 | 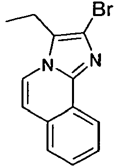 | 48 % |
| | gemäß WO 2010/086089 | | |
| S37 | 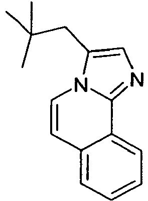 | 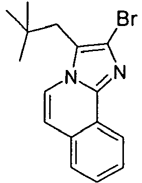 | 37 % |
| | gemäß WO 2010/086089 | | |
| S38 | 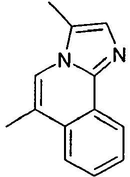 | 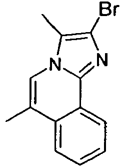 | 45 % |
| | gemäß WO 2010/086089 | | |
| S39 | 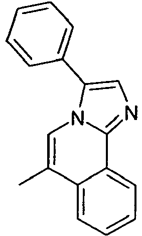 | 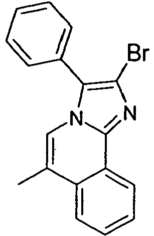 | 51 % |
| | gemäß WO 2010/086089 | | |
| S40 | 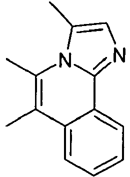 | 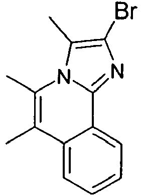 | 56 % |
| | gemäß WO 2010/086089 | | |
| S41 | 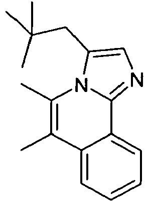 | 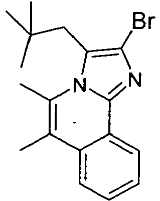 | 33 % |
| | gemäß WO 2010/086089 | | |
| S42 | 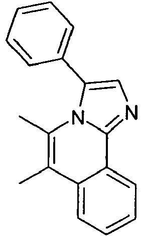 | 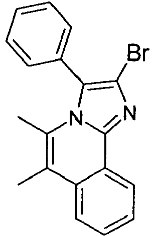 | 52 % |
| | gemäß WO 2010/086089 | | |
| S43 | 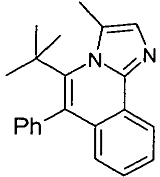 | 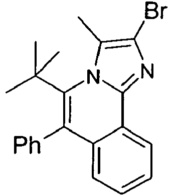 | 46 % |
| | gemäß WO 2010/086089 | | |
| S44 | 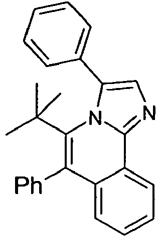 | 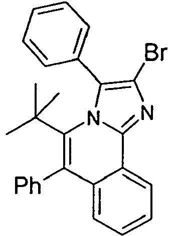 | 58 % |
| | gemäß WO 2010/086089 | | |
| S45 | 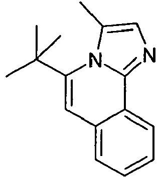 | 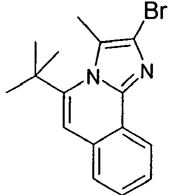 | 45 % |
| | gemäß WO 2010/086089 | | |
| S46 | 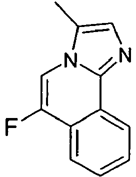 | 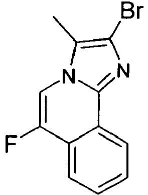 | 49 % |
| | gemäß WO 2010/086089 | | |
| S47 | 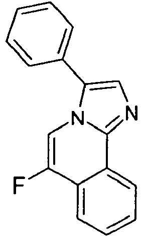 | 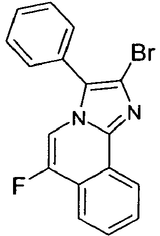 | 55 % |
| | gemäß WO 2010/086089 | | |
| S48 | 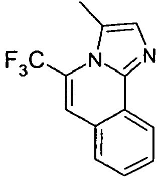 | 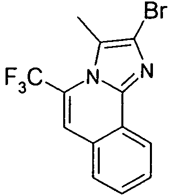 | 34 % |
| | gemäß WO 2010/086089 | | |
| S49 | 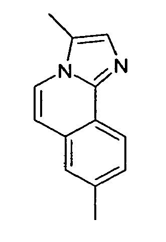 | 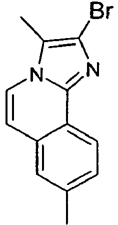 | 50 % |
| | gemäß WO 2010/086089 | | |
| S50 | 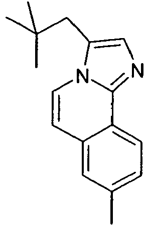 | 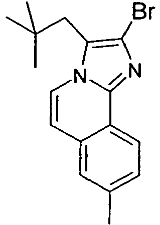 | 31 % |
| | gemäß WO 2010/086089 | | |
| S51 | 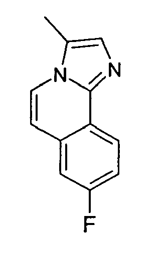 | 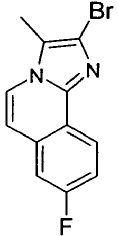 | 47 % |
| | gemäß WO 2010/086089 | | |
| S52 | 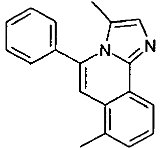 | 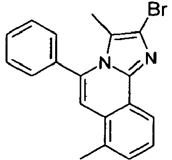 | 44 % |
| | gemäß WO 2010/086089 | | |
| S53 | 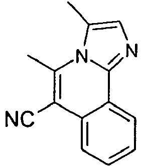 | 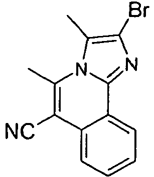 | 42 % |
| | gemäß WO 2010/086089 | | |
| S54 | 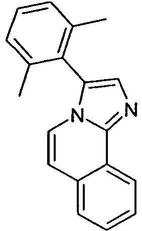 | 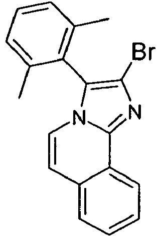 | 38 % |
| | gemäß WO 2010/086089 | | |
| S55 | 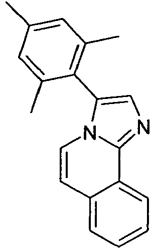 | 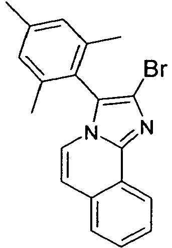 | 40 % |
| | gemäß WO 2010/086089 | | |
| S56 | 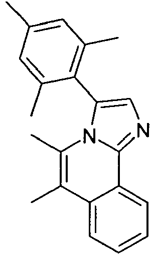 | 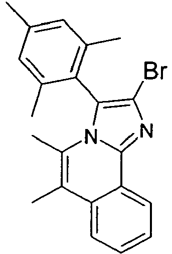 | 45 % |
| | gemäß WO 2010/086089 | | |
| S57 | 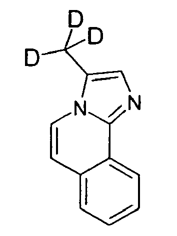 | 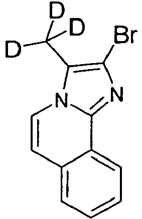 | 46 % |
| | gemäß WO 2010/086089 | | |
| S58 | 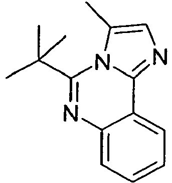 | 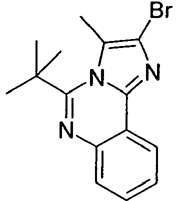 | 48 % |
| | S21 | | |
| S59 | 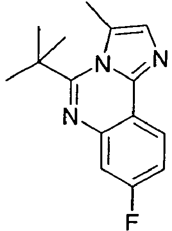 | 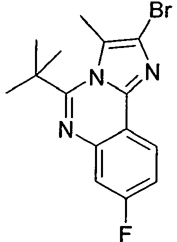 | 45 % |
| | S22 | | |
| S60 | 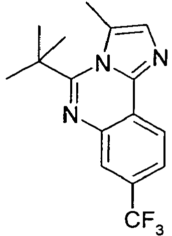 | 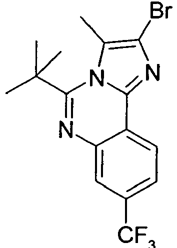 | 51 % |
| | S23 | | |
| S61 | 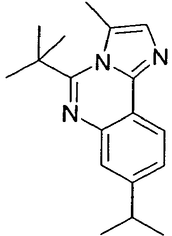 | 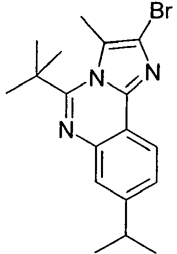 | 44 % |
| | S24 | | |
| S62 | 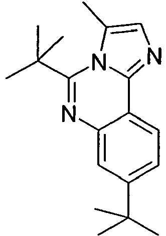 | 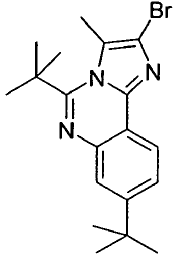 | 46 % |
| | S25 | | |
| S63 | 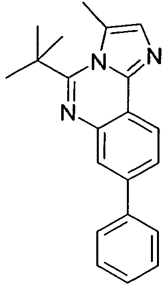 | 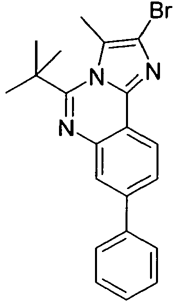 | 52 % |
| | S26 | | |
| S64 | 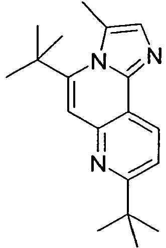 | 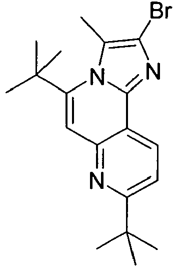 | 55 % |
| | S27 | | |
| S65 | 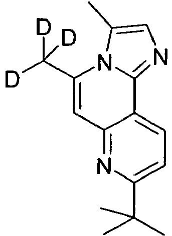 | 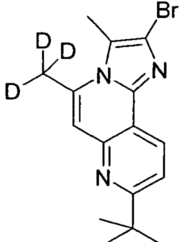 | 57 % |
| | S28 | | |
| S66 | 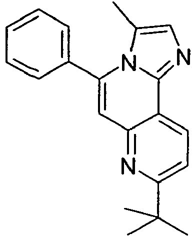 | 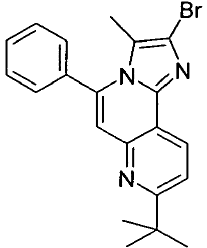 | 53 % |
| | S29 | | |
| S67 | 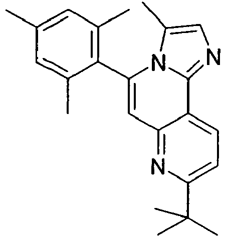 | 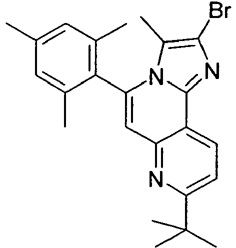 | 41 % |
| | S30 | | |
| S68 | 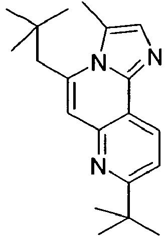 | 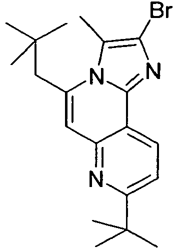 | 37 % |
| | S31 | | |
| S69 | 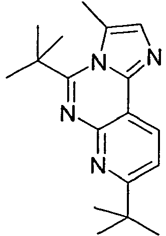 | 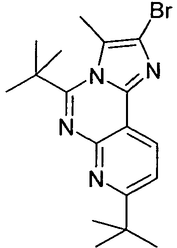 | 50 % |
| | S32 | | |
| S70 | 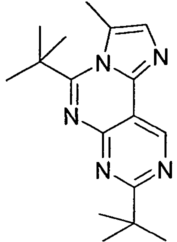 | 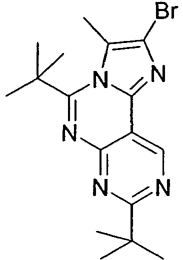 | 61 % |
| | S33 | | |

### 7) 2-Brom-imidazo[2,1-a]isochinolin, S71

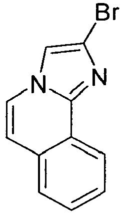

Ein Gemisch aus 14.4 g (100 mmol) 1-Amino-isochinolin[1532-84-9], 15.3 g (100 mmol) 2-Bromessigsäuremethylester [96-32-2], 15.2 ml (110 mmol) Triethylamin und 150 ml Ethanol wird 8 h unter Rückfluss erhitzt. Nach Erkalten filtriert man vom ausgefallenen Feststoff ab, wäscht diesen einmal mit 40 ml Ethanol und trocknet im Vakuum. Das so erhaltene Imidazo[2,1-a]isochinolin-2-on wird mit 57.3 g (200 mmol) Phosphorylbromid versetzt und 5 h auf 100° C erhitzt. Nach Erkalten verdünnt man die Schmelze mit 500 ml Toluol, versetzt unter gutem Rühren mit 500 g Eiswasser und stellt mit 5 % iger NaOH schwach alkalisch. Man trennt die organische Phase ab, wäscht diese mit Wasser und trocknet über Natriumsulfat. Nach Entfernen des Lösungsmittels im Vakuum wird der Rückstand mit Dichlormethan an Kieselgel chromatographiert. Ausbeute: 18.7 g (76 mmol), 75.7 %. Reinheit: ca. 96 % nach ¹H-NMR.

Analog werden folgende Verbindungen dargestellt:

| Bsp. | Edukt | Produkt | Ausbeute |
|---|---|---|---|
| S72 | 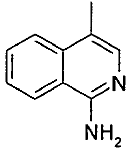 | 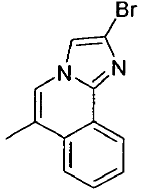 | 70 % |
| | gemäß WO 2010/086089 | | |
| S73 | 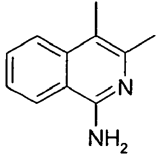 | 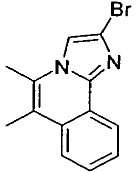 | 73 % |
| | gemäß WO 2010/086089 | | |
| S74 | 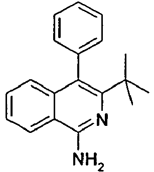 | 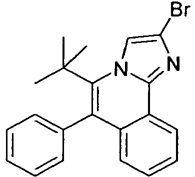 | 64 % |
| | gemäß WO 2010/086089 | | |
| S75 | 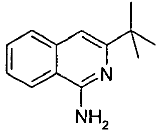 | 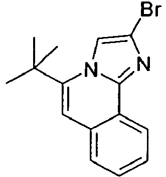 | 74 % |
| | gemäß WO 2010/086089 | | |
| S76 | 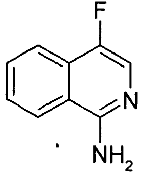 | 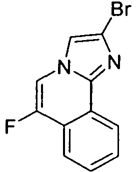 | 68 % |
| | gemäß WO 2010/086089 | | |
| S77 | 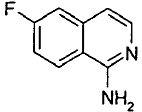 | 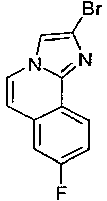 | 62 % |
| | gemäß WO 2010/086089 | | |
| S78 | 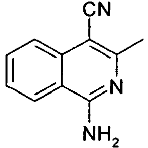 | 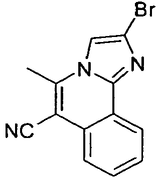 | 31 % |
| | gemäß WO 2010/086089 | | |
| S79 | 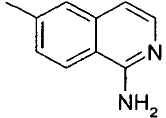 | 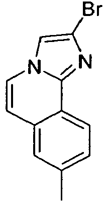 | 66 % |
| | gemäß WO 2010/086089 | | |

### B: Synthese von Liganden L:

### 1) Liganden mit V = NR:

Eine Mischung aus 100 mmol des Bromids, 50 mmol des Anilins / Amins, 12.5 g (130 mmol) Natrium-tert-butylat, 10.0 ml (10 mmol) Tri-tert-butylphosphin, 1 M in Toluol und 1.1 g (5 mmol) Palladium(II)acetat in 300 ml Toluol wird 24 h unter Rückfluss erhitzt. Nach Erkalten wäscht man die organische Phase zweimal mit je 200 ml Wasser, trocknet über Natriumsulfat, entfernt das Toluol im Vakuum, chromatographiert den Rückstand mit Ethylacetat / Heptan an Kieselgel und befreit den Feststoff anschließend durch fraktionierte Sublimation (p ca. 10⁻⁵ mbar, T ca. 260 - 300 °C) von leichtflüchtigen und nicht flüchtigen Komponenten. Reinheit: ca. 99 %ig n. ¹H-NMR.

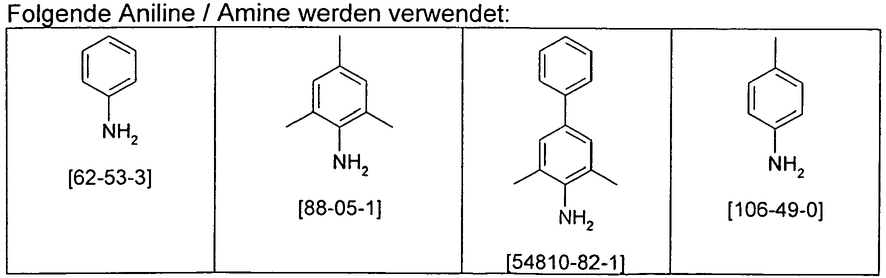

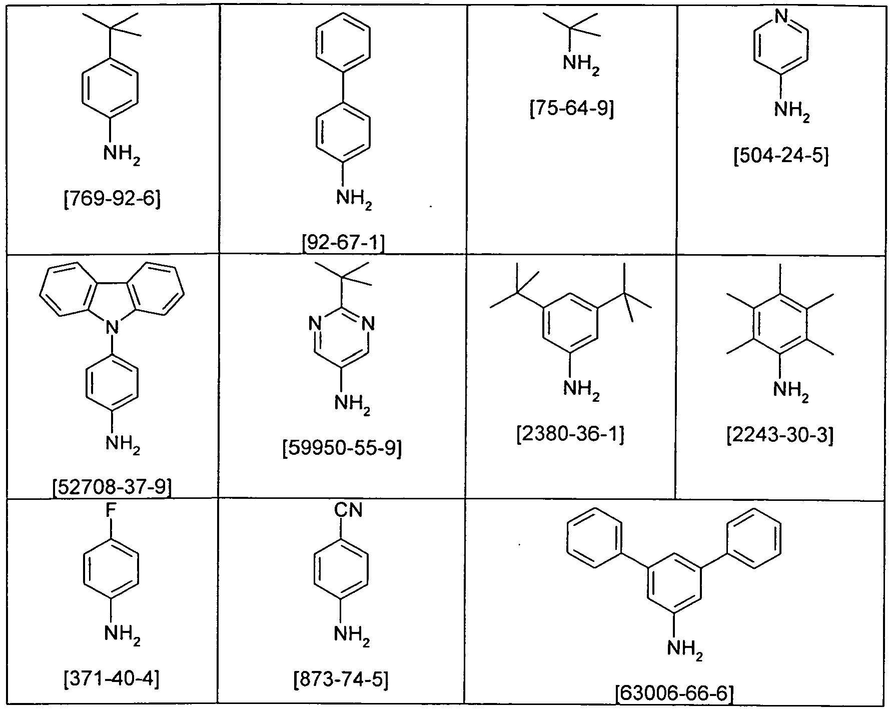

| Bsp. | Edukt | Produkt | Ausbeute |
|---|---|---|---|
| L1 | 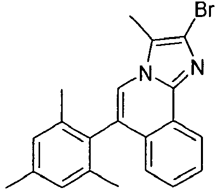 | 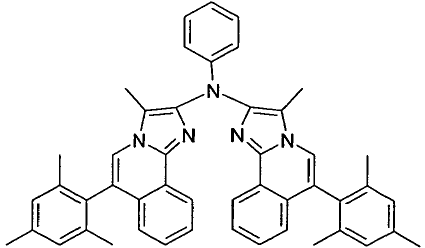 | 38 % |
| | S34 | | |
| L2 | 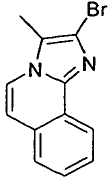 | 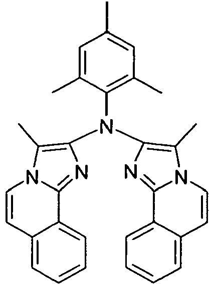 | 31 % |
| | S35 | | |
| L3 | 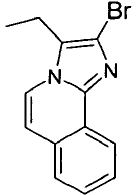 | 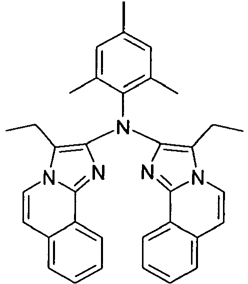 | 30 % |
| | S36 | | |
| L4 | 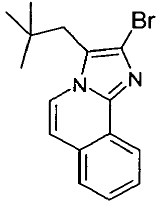 | 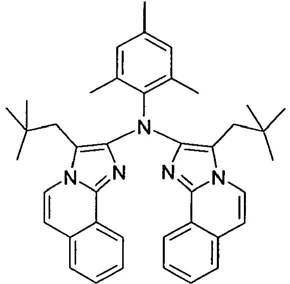 | 26 % |
| | S37 | | |
| L5 | 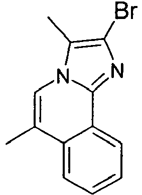 | 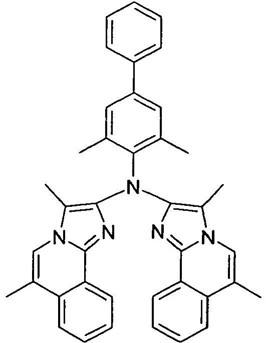 | 34 % |
| | S38 | | |
| L6 | 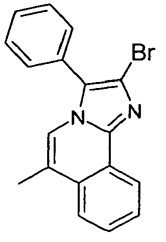 S39 | 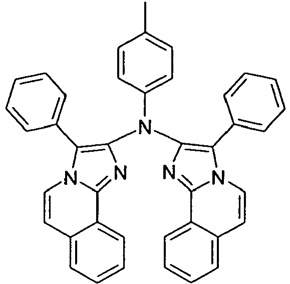 | 44 % |
| L7 | 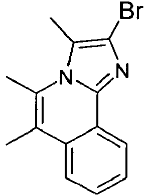 | 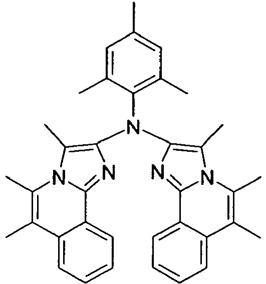 | 30 % |
| | S40 | | |
| L8 | 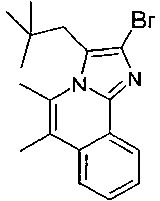 | 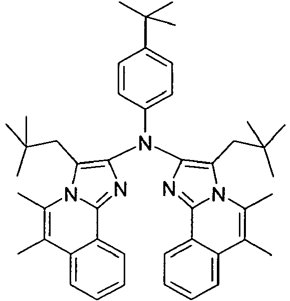 | 41 % |
| | S41 | | |
| L9 | 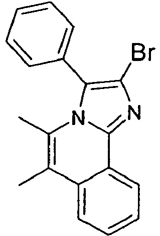 | 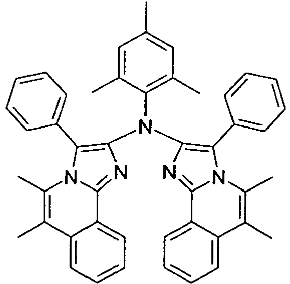 | 22 % |
| | S42 | | |
| L10 | 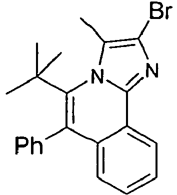 | 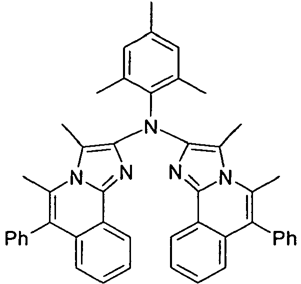 | 33 % |
| | S43 | | |
| L11 | 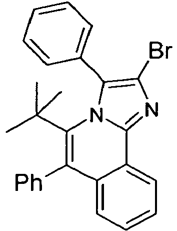 | 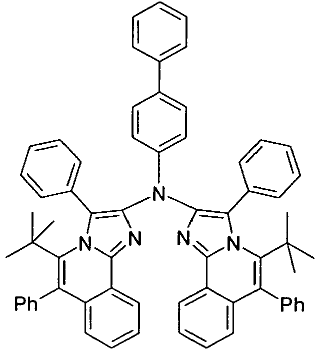 | 30 % |
| | S44 | | |
| L12 | 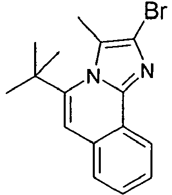 | 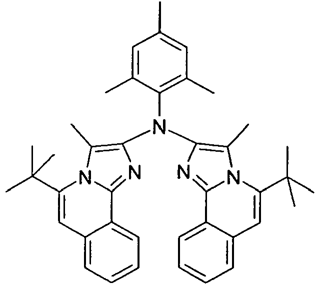 | 36 % |
| | S45 | | |
| L13 | 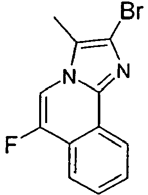 | 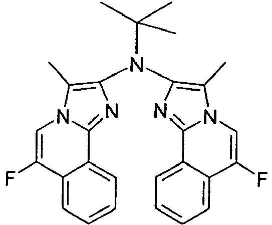 | 12 % |
| | S46 | | |
| L14 | 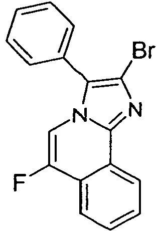 | 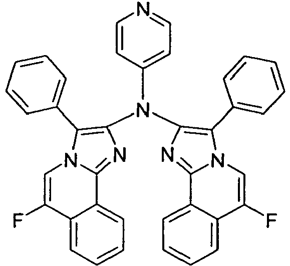 | 27 % |
| | S47 | | |
| L15 | 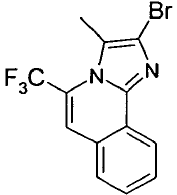 | 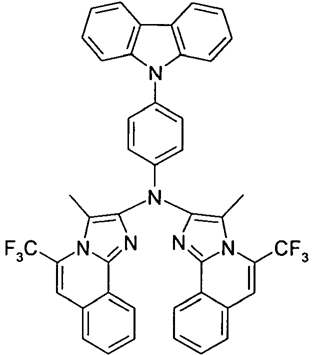 | 45 % |
| | S48 | | |
| L16 | 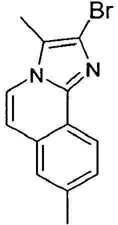 | 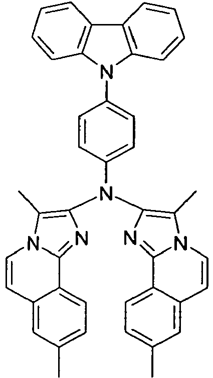 | 46% |
| | S49 | | |
| L17 | 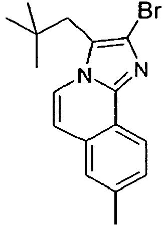 | 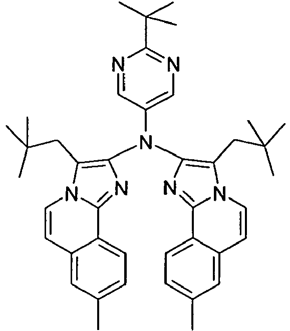 | 34 % |
| | S50 | | |
| L18 | 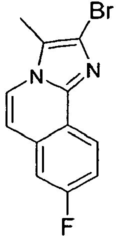 | 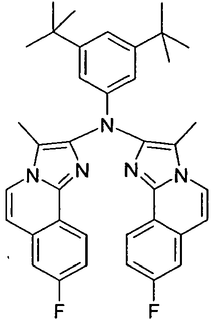 | 45 % |
| | S51 | | |
| L19 | 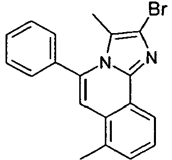 | 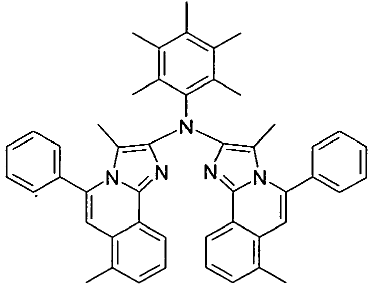 | 28 % |
| | S52 | | |
| L20 | 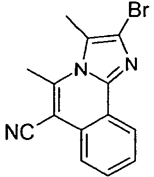 | 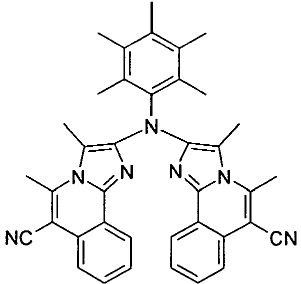 | 26% |
| | S53 | | |
| L21 | 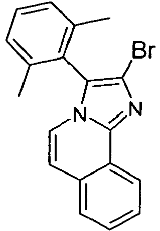 | 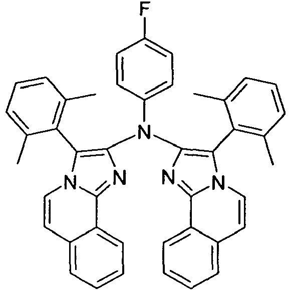 | 43 % |
| | S54 | | |
| L22 | 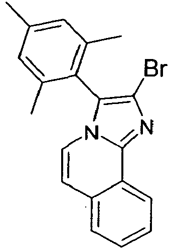 | 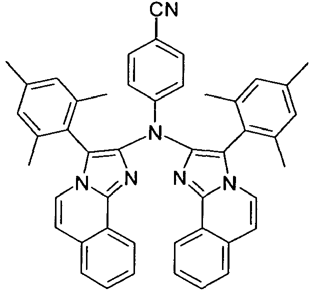 | 45 % |
| | S55 | | |
| L23 | 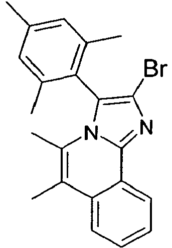 | 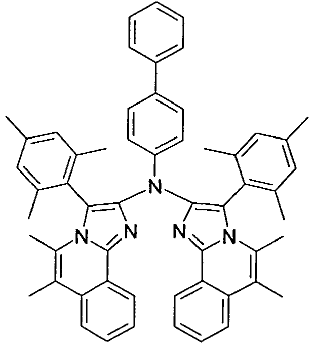 | 29 % |
| | S56 | | |
| L24 | 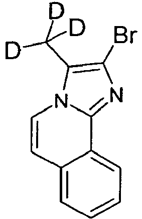 | 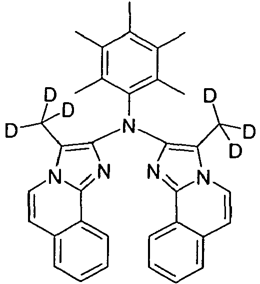 | 32 % |
| | S57 | | |
| L25 | 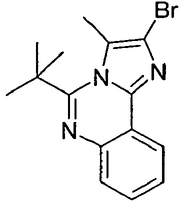 | 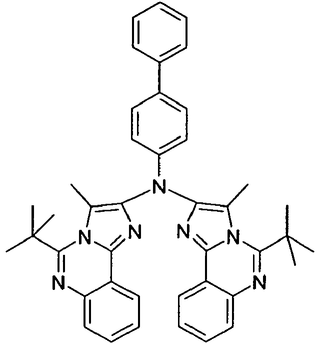 | 44 % |
| | S58 | | |
| L26 | 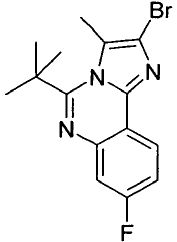 | 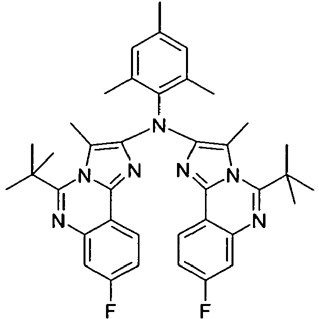 | 35 % |
| | S59 | | |
| L27 | 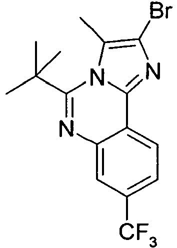 | 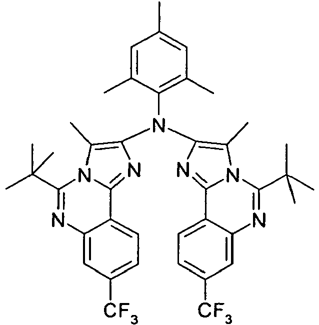 | 34 % |
| | S60 | | |
| L28 | 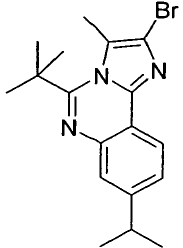 | 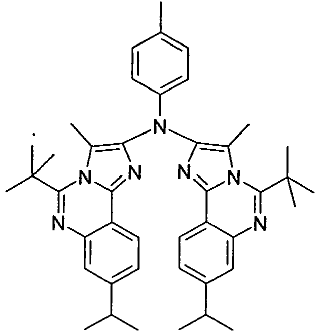 | 46 % |
| | S61 | | |
| L29 | 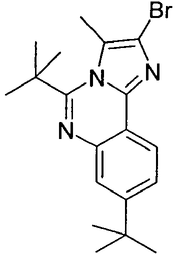 | 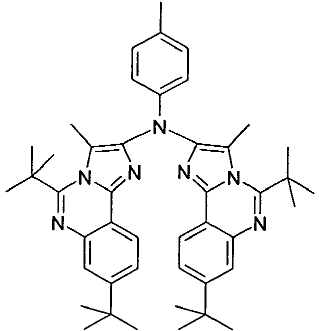 | 44 % |
| | S62 | | |
| L30 | 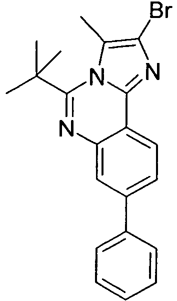 | 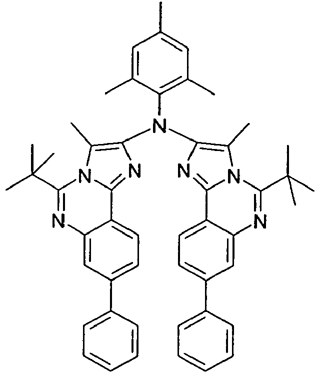 | 36 % |
| | S63 | | |
| L31 | 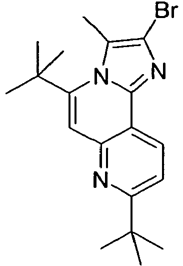 | 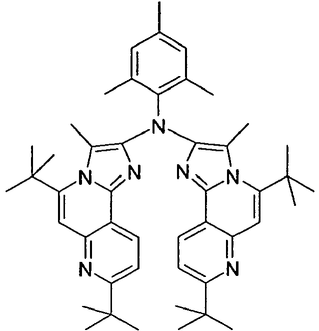 | 38 % |
| | S64 | | |
| L32 | 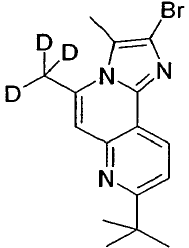 | 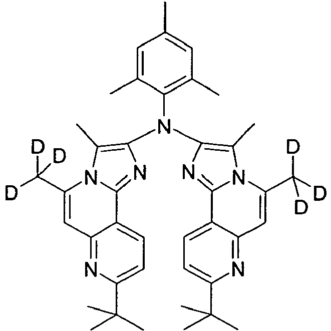 | 39 % |
| | S65 | | |
| L33 | 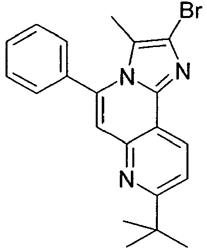 | 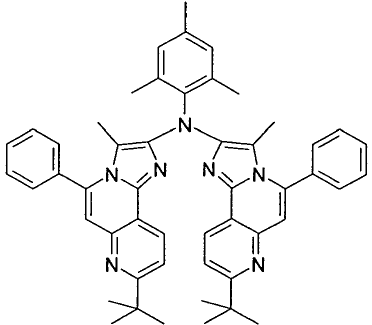 | 36 % |
| | S66 | | |
| L34 | 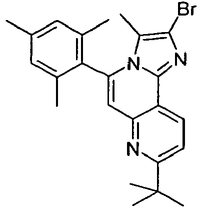 | 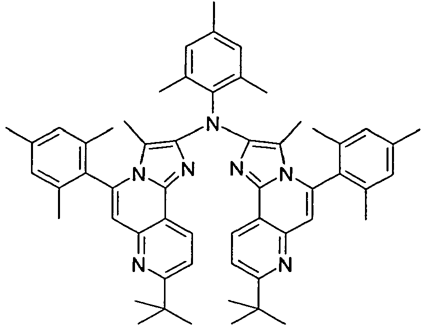 | 33 % |
| | S67 | | |
| L35 | 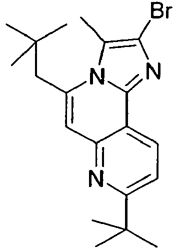 | 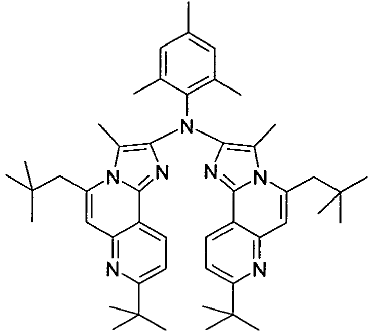 | 32 % |
| | S68 | | |
| L36 | 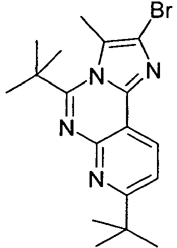 | 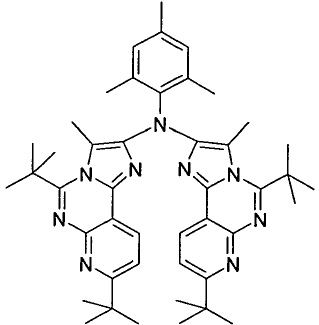 | 35 % |
| | S69 | | |
| L37 | 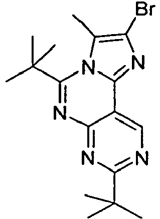 | 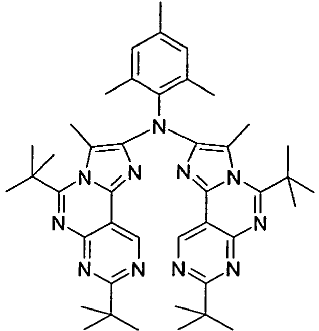 | 30 % |
| | S70 | | |
| L38 | 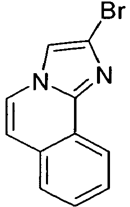 | 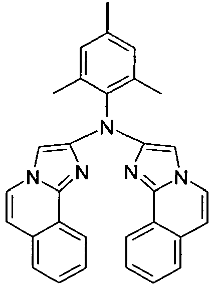 | 48 % |
| | S71 | | |
| L39 | 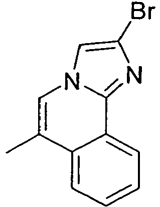 | 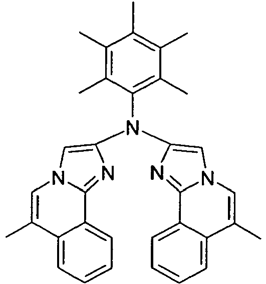 | 45 % |
| | S72 | | |
| L40 | 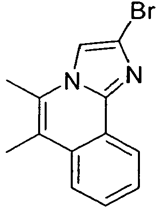 | 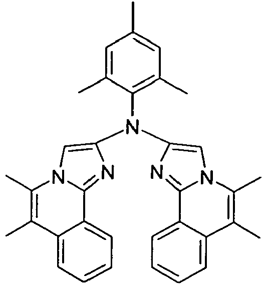 | 50 % |
| | S73 | | |
| L41 | 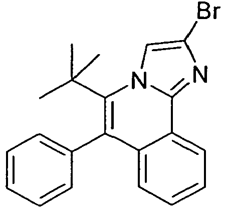 | 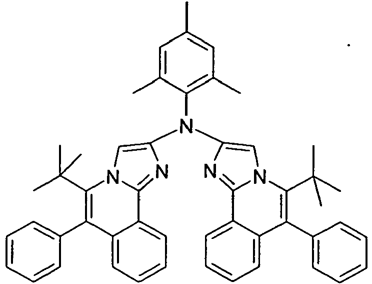 | 47 % |
| | S74 | | |
| L42 | 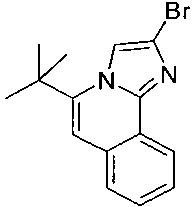 | 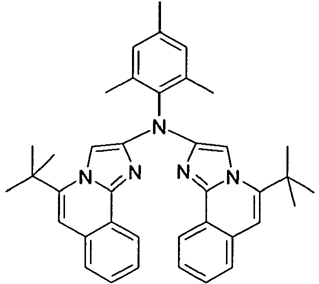 | 50 % |
| | S75 | | |
| L43 | 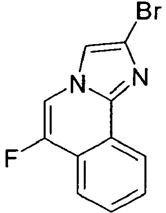 | 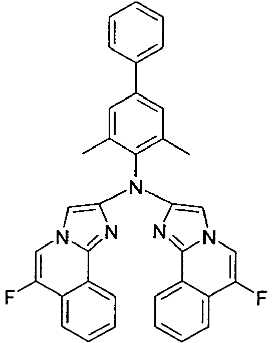 | 47 % |
| | S76 | | |
| L44 | 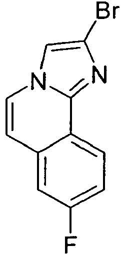 | 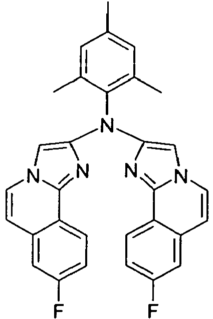 | 45 % |
| | S77 | | |
| L45 | 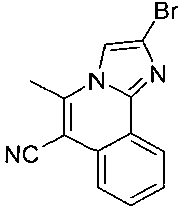 | 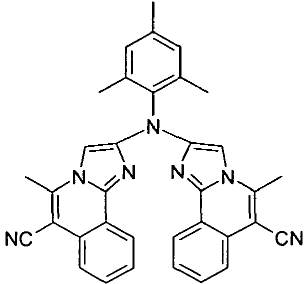 | 36 % |
| | S78 | | |
| L46 | 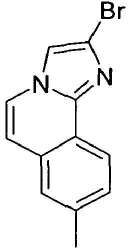 | 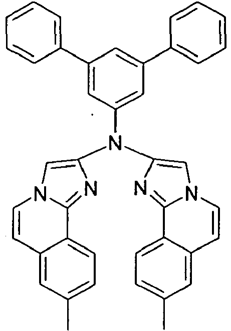 | 51 % |
| | S79 | | |

### 2) Liganden mit V = BR:

Eine auf -78 °C gekühlte Lösung von 100 mmol des Bromids in 300 ml THF wird tropfenweise mit 40.0 ml (100 mmol) n-Butyllithium, 2.5 M in N-Hexan versetzt. Die Reaktionsmischung wird 30 min. nachgerührt und dann tropfenweise mit einer Lösung von 840 mg (50 mmol) Difluormesitylboran in 100 ml THF versetzt. Man rührt die Reaktionsmischung 1 h bei - 78 °C nach, lässt dann auf Raumtemperatur erwärmen, entfernt das THF im Vakuum, nimmt den Rücksand in 300 ml Dichlormethan auf, wäscht zweimal mit je 100 ml Wasser, trocknet über Natriumsulfat, entfernt das Lösungsmittel im Vakuum, kristallisiert den öligen Rückstand aus Ethylacetat / Methanol um und befreit den Feststoff anschließend durch fraktionierte Sublimation (p ca. 10⁻⁵ mbar, T ca. 260 - 300 °C) von leichtflüchtigen und nicht flüchtigen Komponenten. Reinheit: ca. 99 %ig n. ¹H-NMR.

| Bsp. | Edukt | Produkt | Ausbeute |
|---|---|---|---|
| L47 | 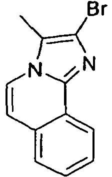 | 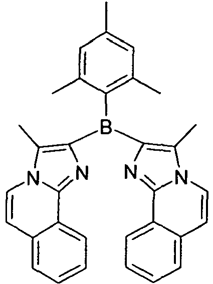 | 46 % |
| | S35 | | |
| L48 | 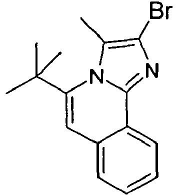 | 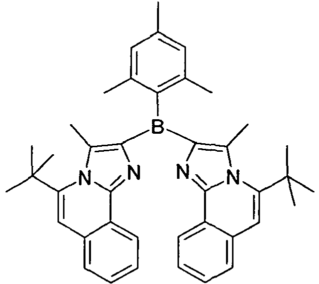 | 40 % |
| | S45 | | |
| L49 | 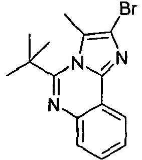 | 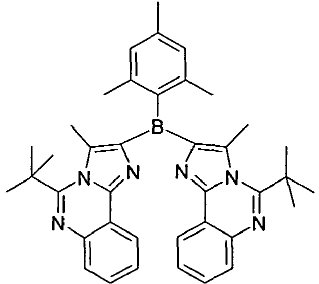 | 38 % |
| | S58 | | |

### 3) Liganden mit V = O:

Ein Gemisch aus 100 mmol des Bromids, 4.0 g (100 mmol) Natriumhydroxid, 14.9 g (120 mmol) n-Butylimidazol, 26.4 g (100 mmol) 18-Krone- 6 und 1.9 g (10 mmol) Kupfer(I)iodid in 200 ml Diethylenglykoldimethylether wird 16 h auf 120 °C erhitzt. Nach Erkalten wäscht man die Reaktionsmischung dreimal mit je 300 ml Wasser, trocknet über Natriumsulfat, entfernt das Lösungsmittel im Vakuum, kristallisiert den öligen Rückstand aus Ethylacetat / Methanol um und befreit den Feststoff anschließend durch fraktionierte Sublimation (p ca. 10⁻⁵ mbar, T ca. 260 - 300 °C) von leichtflüchtigen und nicht flüchtigen Komponenten. Reinheit: ca. 99 %ig nach ¹H-NMR.

| Bsp. | Edukt | Produkt | Ausbeute |
|---|---|---|---|
| L50 | 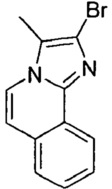 | 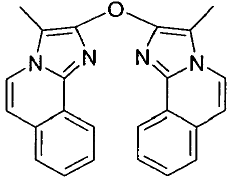 | 31 % |
| | S35 | | |
| L51 | 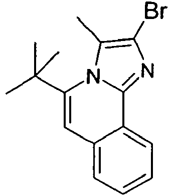 | 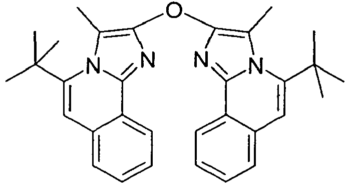 | 38 % |
| | S45 | | |
| L52 | 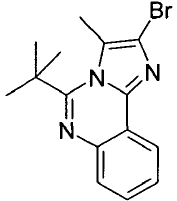 | 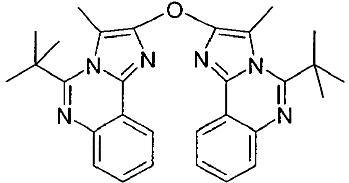 | 35 % |
| | S58 | | |
| L53 | 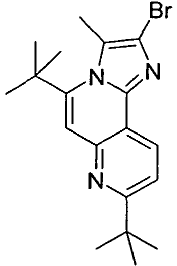 | 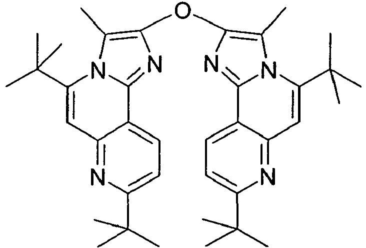 | 30 % |
| | S64 | | |
| L54 | 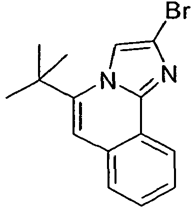 | 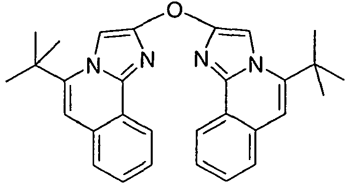 | 37 % |
| | S75 | | |

### C: Synthese von Metallkomplexen:

Ein Gemisch aus 10 mmol Bis(benzonitril)-dichloro-platin(II) und 10 mmol des Liganden L in 100 ml Benzonitril wird 16 h unter Rückfluss erhitzt. Nach tropfenweiser Zugabe von 100 ml Methanol zur erkalteten Reaktionsmischung wird vom Feststoff abgesaugt, dieser wird fünfmal mit je 25 ml Methanol gewaschen und im Vakuum getrocknet. Der Feststoff wird in 100 ml Eisessig suspendiert, die Suspension wird mit 20 ml Pyridin und 1.5 g Zinkstaub versetzt und 5 h bei 90 °C gerührt. Nach Erkalten saugt man vom Feststoff ab, wäscht diesen dreimal mit je 25 ml Methanol und trocknet diesen im Vakuum. Der so erhaltene Feststoff wird in einem Heißextraktor auf einem 3 cm hohen Celite-Bett platziert und dann mit Toluol (Vorlagemenge ca. 300 ml) extrahiert. Nach beendeter Extraktion wird das Extraktionsmittel im Vakuum auf ca. 100 ml eingeengt. Metallkomplexe, die im Extraktionsmittel eine zu gute Löslichkeit aufweisen, werden durch Zutropfen von 200 ml Methanol zur Kristallisation gebracht. Der Feststoff der so erhaltenen Suspensionen wird abgesaugt, einmal mit ca. 50 ml Methanol gewaschen und getrocknet. Nach Trocknen wird die Reinheit des Metallkomplexes mittels NMR und/oder HPLC bestimmt. Liegt die Reinheit unter 99.5 % wird der Heißextraktionsschritt wiederholt; ist eine Reinheit von 99.5 - 99.9 % erreicht, wird der Pt-Komplex sublimiert. Die Sublimation erfolgt im Hochvakuum (p ca. 10⁻⁶ mbar) im Temperaturbereich von ca. 320 bis ca. 390 °C, wobei die Sublimation bevorzugt in Form einer fraktionierten Sublimation durchgeführt wird.

| **Ligand** | **Pt-Komplex** | **Ausbeute** |
|---|---|---|
| L1 | 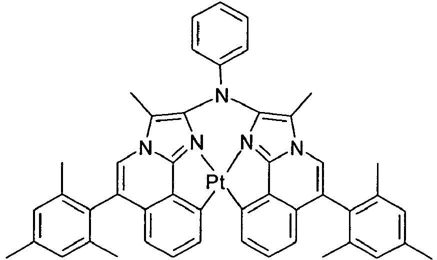 | 32 % |
| | PtL1 | |
| L2 | PtL2 | 30 % |
| L3 | PtL3 | 30 % |
| L4 | PtL4 | 28 % |
| L5 | PtL5 | 36 % |
| L6 | PtL6 | 38 % |
| L7 | PtL7 | 35 % |
| L8 | PtL8 | 41 % |
| L9 | PtL9 | 33 % |
| L10 | PtL10 | 37 % |
| L11 | PtL11 | 30 % |
| L12 | PtL12 | 40 % |
| L13 | PtL13 | 39 % |
| L14 | PtL14 | 44 % |
| L15 | PtL15 | 31 % |
| L16 | PtL16 | 35 % |
| L17 | PtL17 | 35 % |
| L18 | PtL18 | 36 % |
| L19 | PtL19 | 38 % |
| L20 | PtL20 | 33 % |
| L21 | PtL21 | 40 % |
| L22 | PtL22 | 38 % |
| L23 | PtL23 | 39 % |
| L24 | PtL24 | 34 % |
| L25 | PtL25 | 35 % |
| L26 | PtL26 | 33 % |
| L27 | PtL27 | 35 % |
| L28 | PtL28 | 35 % |
| L29 | PtL29 | 36 % |
| L30 | PtL30 | 38 % |
| L31 | PtL31 | 40 % |
| L32 | PtL32 | 41 % |
| L33 | PtL33 | 40 % |
| L34 | PtL34 | 35 % |
| L35 | PtL35 | 34 % |
| L36 | PtL36 | 33 % |
| L37 | PtL37 | 34 % |
| L38 | PtL38 | 39 % |
| L39 | PtL39 | 45 % |
| L40 | PtL40 | 44 % |
| L41 | PtL41 | 45 % |
| L42 | PtL42 | 47 % |
| L43 | PtL43 | 44 % |
| L44 | PtL44 | 45 % |
| L45 | PtL45 | 43 % |
| L46 | PtL46 | 46 % |
| L47 | 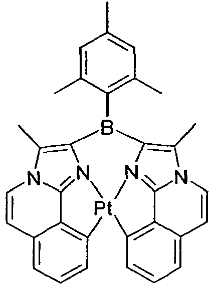 | 27 % |
| | PtL47 | |
| L48 | PtL48 | 23 % |
| L49 | PtL49 | 25 % |
| L50 | 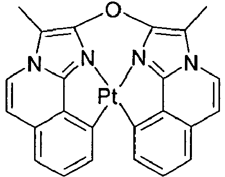 | 38 % |
| | PtL50 | |
| L51 | PtL51 | 40 % |
| L52 | PtL52 | 43 % |
| L53 | PtL53 | 39 % |
| L54 | PtL54 | 40 % |

### Beispiel: Herstellung der OLEDs

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen (siehe Tabellen 1 und 2) werden die Ergebnisse verschiedener OLEDs vorgestellt. Glasplättchen, die mit strukturiertem ITO (Indium Zinn Oxid) der Dicke 150 nm beschichtet sind, werden zur verbesserten Prozessierung mit 20 nm PEDOT beschichtet (Poly(3,4-ethylendioxy-2,5-thiophen), aus Wasser aufgeschleudert; bezogen von H. C. Starck, Goslar, Deutschland). Diese beschichteten Glasplättchen bilden die Substrate, auf welche die OLEDs aufgebracht werden. Die OLEDs haben prinzipiell folgenden Schichtaufbau: Substrat / optionale Lochinjektionsschicht (HIL1) / optionale Lochinjektionsschicht (HIL2) / Lochtransportschicht (HTL) / Elektronenblockerschicht (EBL) / Emissionsschicht (EML) / optionale Lochblockierschicht (HBL) / Elektronentransportschicht (ETL) und abschließend eine Kathode. Die Kathode wird durch eine 100 nm dicke Aluminiumschicht gebildet

Zunächst werden vakuumprozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1:M2:PtL (55%:35%:10%) bedeutet hierbei, dass das Material M1 in einem Volumenanteil von 55%, M2 in einem Anteil von 35% und PtL in einem Anteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 3 gezeigt.

Die OLEDs werden standardmäßig charakterisiert. Hierfür werden die Elektrolumineszenzspektren, die Stromeffizienz (gemessen in cd/A) und die Spannung (gemessen bei 1000 cd/m² in V) bestimmt aus Strom-Spannungs-Helligkeits-Kennlinien (IUL-Kennlinien). Für ausgewählte Versuche wird die Lebensdauer bestimmt. Als Lebensdauer wird die Zeit definiert, nach der die Leuchtdichte von einer bestimmten Startleuchtdichte aus auf einen gewissen Anteil abgesunken ist. Die Angabe LD50 bedeutet, dass es sich bei der genannten Lebensdauer um die Zeit handelt, bei der die Leuchtdichte auf 50 % der Startleuchtdichte abgefallen ist, also von z. B. 4000 cd/m² auf 2000 cd/m². Je nach Emissionsfarbe wurden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Bei den OLEDs zeigt sich hier, dass die erfindungsgemäßen Materialien zu effizienten blau bis grün emittierenden OLEDs führen.

**Tabelle 1: Verwendung von erfindungsgemäßen Verbindungen als Emitter in phosphoreszenten OLEDs**

| Bsp. | HIL1 Dicke | HIL2 Dicke | HTL Dicke | EML Dicke | HBL Dicke | ETL Dicke |
|---|---|---|---|---|---|---|
| 1 Vgl. | HIL1 | HIL3 | HTL1 | M1:HIL1:Pt-Vgl. | M1 | ETM1:LiQ |
| | 20 nm | 5 nm | 15 nm | (80%:10%:10%) | 10 nm | (50%:50%) |
| | | | | 40 nm | | 20 nm |
| | HIL1 | HIL3 | HTL1 | M1:HIL1:PtL42 | M1 | ETM1:LiQ |
| 2 | 20 nm | 5 nm | 15 nm | (80%:10%:10%) | 10 nm | (50%:50%) |
| | | | | 40 nm | | 20 nm |
| 3 | HIL1 | HIL2 | HTL2 | M1:PtL25 | ETM1 | ETM1:LiQ |
| | 80 nm | 10 nm | 20 nm | (90%:10%) | 5 nm | (50%:50%) |
| | | | | 40 nm | | 25 nm |
| 4 | HIL1 | HIL2 | HTL2 | M1:M2:PtL31 | ETM1 | ETM1:LiQ |
| | 80 nm | 10 nm | 20 nm | (20%:70%:10%) | 5nm | (50%:50%) |
| | | | | 40 nm | | 25 nm |
| 5 | HIL1 | HIL2 | HTL2 | M1:M2:PtL54 | ETM1 | ETM1:LiQ |
| | 80 nm | 10 nm | 20 nm | (60%:40%:10%) | 5 nm | (50%:50%) |
| | | | | 40 nm | | 25 nm |

**Tabelle 2: Verwendung von erfindungsgemäßen Verbindungen als Emitter in phosphoreszenten OLEDs**

| Bsp. | EQE [%] bei 1000 cd/m² | Spannung (V) bei 1000 cd/m² | CIE x/y bei 1000 cd/m² | LD50 (h) bei 1000 cd/m² |
|---|---|---|---|---|
| 1 | 16.1 | 5.1 | 0.19 / 0.24 | 1100 |
| 2 | 16.4 | 4.7 | 0.17 / 0.23 | 1500 |
| 3 | 15.3 | 4.5 | 0.16 / 0.25 | 1400 |
| 4 | 12.2 | 5.6 | 0.15 / 0.16 | 600 |
| 5 | 15.0 | 5.0 | 0.15 / 0.22 | 800 |

**Tabelle 3: Strukturformeln der verwendeten Materialien**

| | |
|---|---|
| 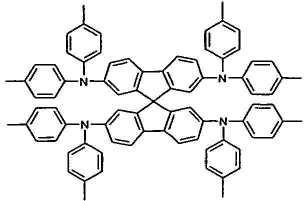 | 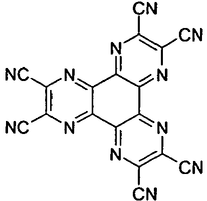 |
| HIL1 | HIL2 |
| 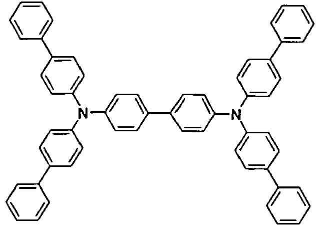 | 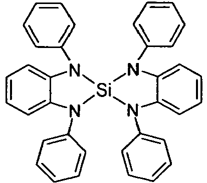 |
| HIL3 | HTL1 |
| 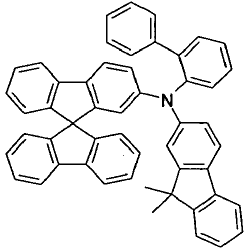 | 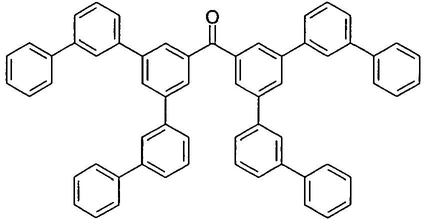 |
| HTL2 | M1 |
| 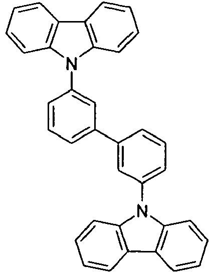 | 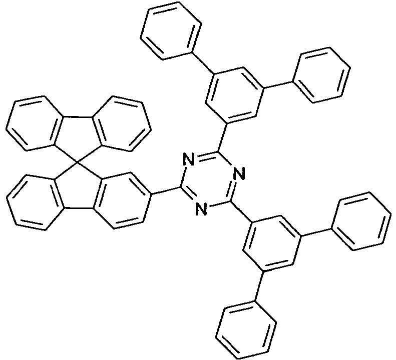 |
| M2 | ETM1 |
| 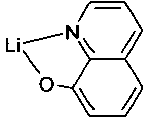 | 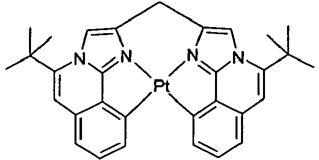 |
| | gemäß WO 2010/086089 |
| LiQ | Vergleich: Pt-Vgl. |

## Patentansprüche

1. Verbindung gemäß Formel (1), 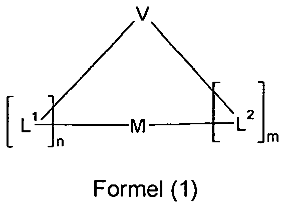 wobei L¹ gleich oder verschieden bei jedem Auftreten für einen Teilliganden der folgenden Formel (2) steht, 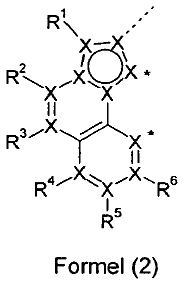 wobei die gestrichelte Bindung die Bindung an V andeutet, * die Position der Koordination an M kennzeichnet und für die verwendeten Symbole und Indizes gilt:
M ist ausgewählt aus der Gruppe bestehend aus Pt, Ir und Au;
V ist ausgewählt aus der Gruppe bestehend aus NR⁷, N⁻, BR⁷, B(R⁷)₂⁻, O, S und Se;
X ist bei jedem Auftreten gleich oder verschieden C oder N, wobei alle X im Teilliganden gemäß Formel (2) gemeinsam ein 14 π-Elektronensystem bilden, mit der Maßgabe, dass mindestens zwei Gruppen X und höchstens 6 Gruppen X in jedem Teilliganden der Formel (2) für N stehen;
R¹ bis R⁶ ist bei jedem Auftreten gleich oder verschieden H, D, F, Cl, Br, I, N(R⁸)₂, CN, NO₂, Si(R⁸)₃, B(OR⁸)₂, C(=O)R⁸, P(=O)(R⁸)₂, S(=O)R⁸, S(=O)₂R⁸, OSO₂R⁸, eine geradkettige Alkyl-, Alkoxy-oder Thioalkoxygruppe mit 1 bis 40 C-Atomen oder eine Alkenyl-oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C=C, Si(R⁸)₂, C=O, C=S, C=NR⁸, P(=O)(R⁸), SO, SO₂, NR⁸, O, S oder CONR⁸ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁸ substituiert sein kann, oder eine Aralkyl- oder Heteroaralkylgruppe mit 5 bis 60 aromatischen Ringatomen, die durch einen oder mehrere Reste R⁸ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann; dabei können R⁴ und R⁵ und/oder R⁵ und R⁶ und/oder R¹ und R⁷ auch miteinander ein mono- oder polycyclisches, aliphatisches, aromatisches und/oder benzoannelliertes Ringsystem bilden; weiterhin können R² und R³ miteinander ein mono- oder polycyclisches, aliphatisches Ringsystem bilden;
mit der Maßgabe, dass R¹ bis R⁶ ein freies Elektronenpaar darstellt, wenn die Gruppe X, an welche dieser Rest R¹ bis R⁶ gebunden ist, ein Stickstoffatom mit abgesättigter Valenz ist;
R⁷ ist bei jedem Auftreten gleich oder verschieden H, D, Si(R⁸)₃, C(=O)R⁸, eine geradkettige Alkyl- oder Alkoxygruppe mit 1 bis 40 C-Atomen oder eine Alkenyl- oder Alkinylgruppe mit 2 bis 40 C-Atomen oder eine verzweigte oder cyclische Alkyl- oder Alkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C=C, Si(R⁸)₂, C=O, C=S, C=NR⁸, P(=O)(R⁸), SO, SO₂, NR⁸, O, S oder CONR⁸ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁸ substituiert sein kann, oder eine Aralkyl-oder Heteroaralkylgruppe mit 5 bis 60 aromatischen Ringatomen, die durch einen oder mehrere Reste R⁸ substituiert sein kann; dabei können R¹ und R⁷ auch miteinander ein mono- oder polycyclisches, aliphatisches, aromatisches und/oder benzoannelliertes Ringsystem bilden;
R⁸ ist bei jedem Auftreten gleich oder verschieden H, D, F, Cl, Br, I, N(R⁹)₂, CN, NO₂, Si(R⁹)₃, B(OR⁹)₂, C(=O)R⁹, P(=O)(R⁹)₂, S(=O)R⁹, S(=O)₂R⁹, OSO₂R⁹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R⁹ substituiert sein kann, wobei eine oder mehrere nicht benachbarte CH₂-Gruppen durch R⁹C=CR⁹, C=C, Si(R⁹)₂, C=O, C=S, C=NR⁹, P(=O)(R⁹), SO, SO₂, NR⁹, O, S oder CONR⁹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Aralkyl- oder Heteroaralkylgruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann; dabei können zwei oder mehrere benachbarte Reste R⁸ miteinander ein mono- oder polycyclisches, aliphatisches oder aromatisches Ringsystem bilden;
R⁹ ist bei jedem Auftreten gleich oder verschieden H, D, F oder ein aliphatischer, aromatischer und/oder heteroaromatischer Kohlenwasserstoffrest mit 1 bis 20 C-Atomen, in dem auch ein oder mehrere H-Atome durch F ersetzt sein können; dabei können zwei oder mehrere Substituenten R⁹ auch miteinander ein mono- oder polycyclisches, aliphatisches oder aromatisches Ringsystem bilden;
L² ist ein bidentater Teilligand, der an V gebunden ist;
n ist 1 oder 2;
m ist (2 - n).

2. Verbindung nach Anspruch 1, **dadurch gekennzeichnet, dass** der Teilligand der Formel (2) ausgewählt ist aus Strukturen gemäß Formel (4), 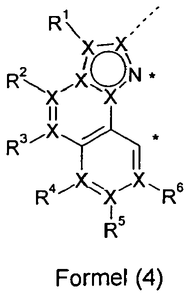 wobei die verwendeten Symbole die in Anspruch 1 genannten Bedeutungen aufweisen und mindestens ein Symbol X und höchstens 5 Symbole X für N stehen.

3. Verbindung nach Anspruch 1 oder 2, **dadurch gekennzeichnet, dass** der Teilligand gemäß Formel (2) ausgewählt ist aus den Teilliganden gemäß den Formeln (5), (6) oder (7), 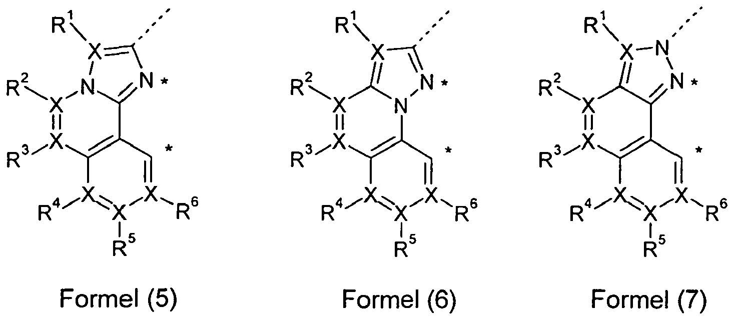 wobei die verwendeten Symbole die in Anspruch 1 genannten Bedeutungen aufweisen, bei Verwendung der Teilliganden gemäß Formel (7) die verbrückende Einheit V ausgewählt ist aus BR⁷ und B(R⁷)₂ und die Teilliganden zwei, drei, vier, fünf oder sechs Stickstoffatome enthalten.

4. Verbindung nach einem oder mehreren der Ansprüche 1 bis 3, **dadurch gekennzeichnet, dass** die Teilliganden der Formel (2) ausgewählt sind aus den Teilliganden der Formeln (5a) bis (5r), (6a) bis (6r) oder (7a) bis (7r), 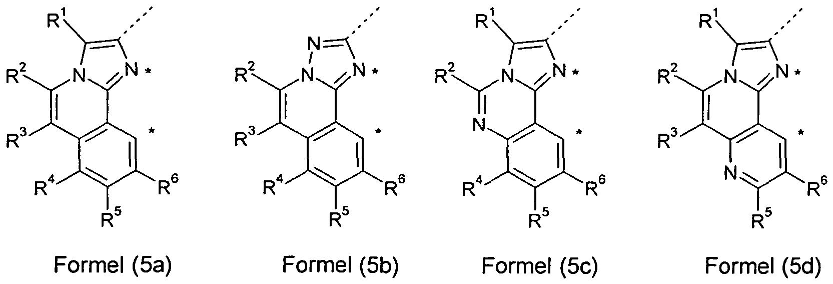 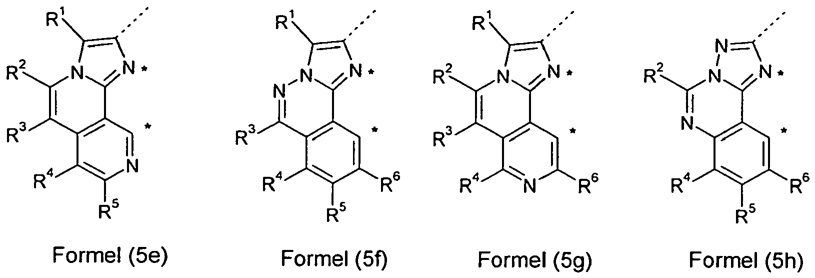 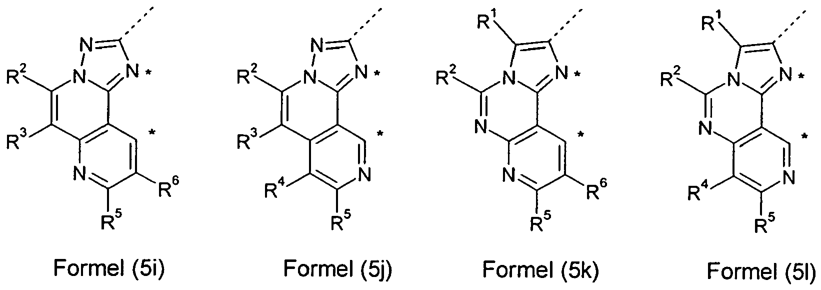 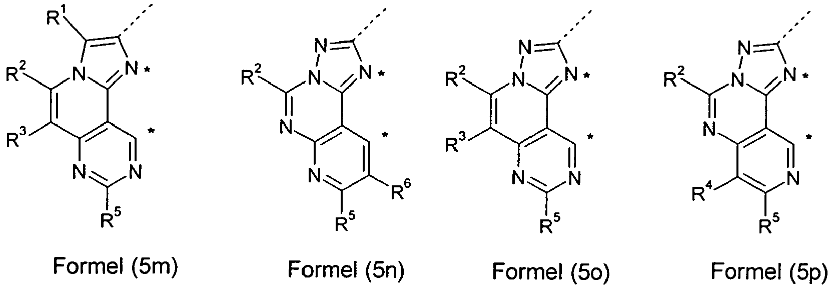 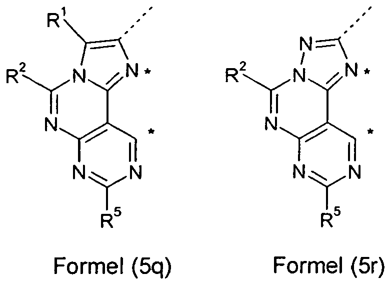 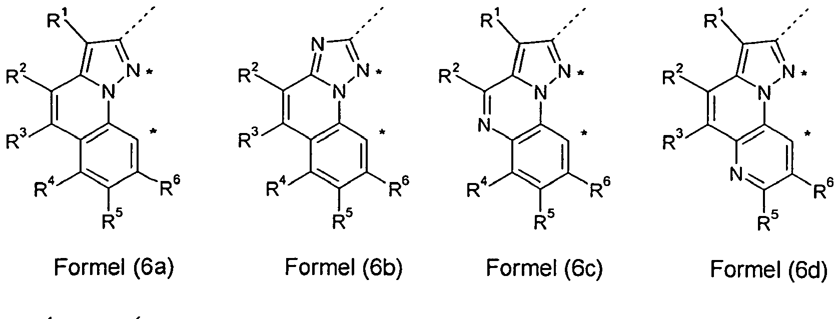 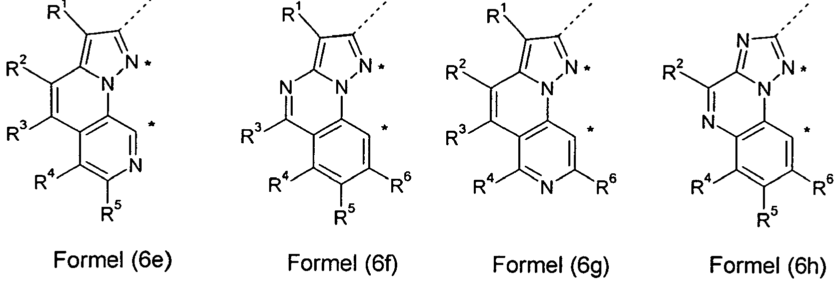 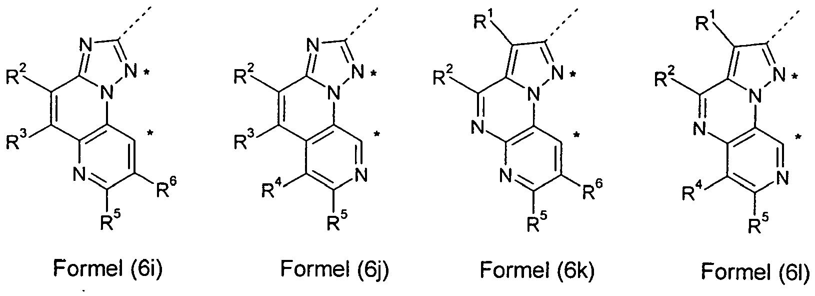 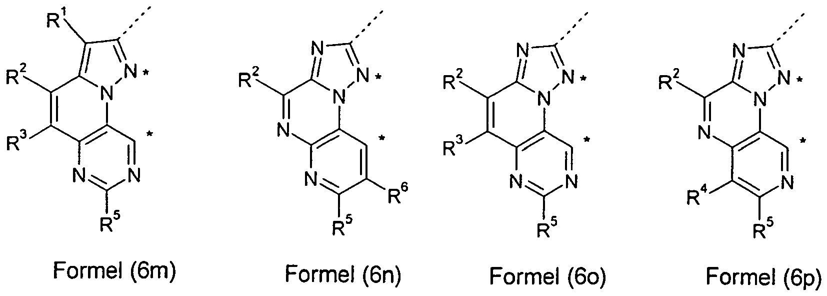 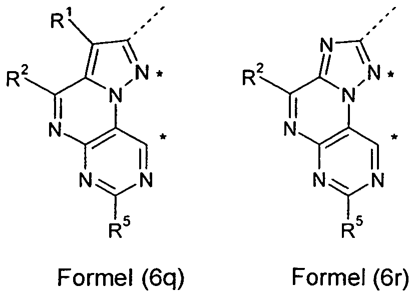 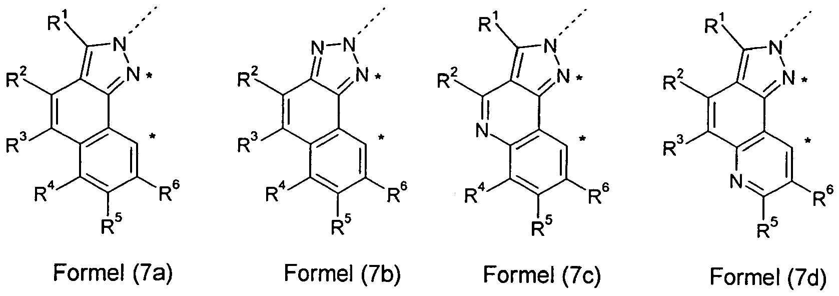 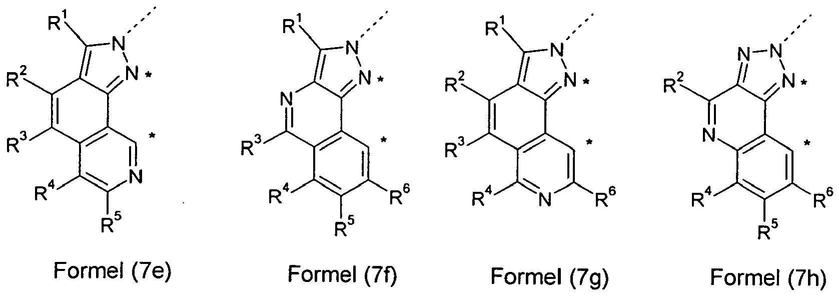 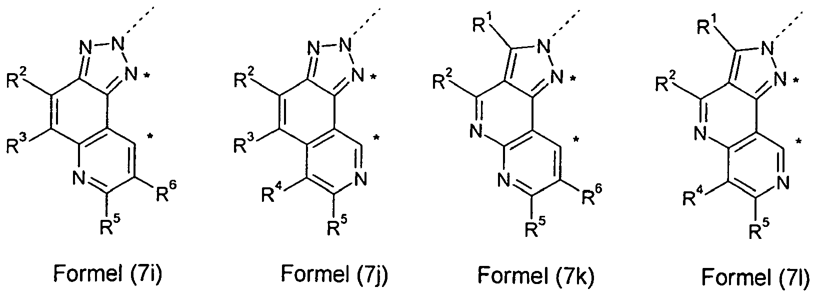 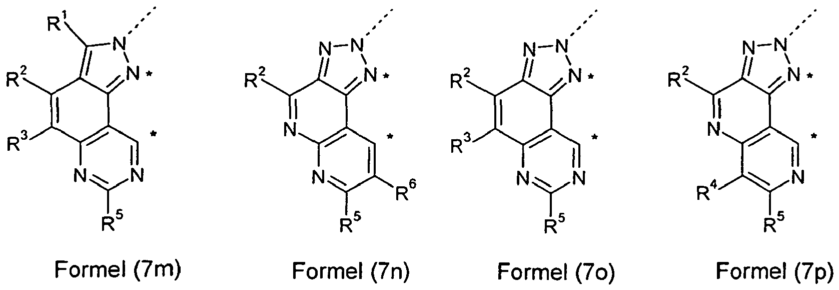 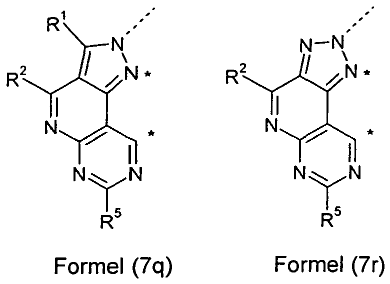 wobei die verwendeten Symbole die in Anspruch 1 genannten Bedeutungen aufweisen.

5. Verbindung nach einem oder mehreren der Ansprüche 1 bis 4, **dadurch gekennzeichnet, dass**, wenn der Teilligand gemäß Formel (2) 3 oder mehr Stickstoffatome enthält, an ein Kohlenstoffatom, welches benachbart ist zu einem Stickstoffatom, das nicht an das Metall koordiniert ist und das nicht gleichzeitig in einem Fünfring und einem Sechsring gebunden ist, ein sterisch anspruchsvoller Rest gebunden ist, welcher gleich oder verschieden bei jedem Auftreten ausgewählt ist aus der Gruppe bestehend aus N(R⁸)₂, einer geradkettigen Alkyl-, Alkoxy- oder Thioalkoxygruppe mit 1 bis 40 C-Atomen oder einer Alkenyl- oder Alkinylgruppe mit 2 bis 40 C-Atomen oder einer verzweigten oder cyclischen Alkyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch R⁸C=CR⁸, C=C, Si(R⁸)₂, C=O, C=S, C=NR⁸, P(=O)(R⁷), SO, SO₂, NR⁸, O, S oder CONR⁸ ersetzt sein können und wobei ein oder mehrere H-Atome durch D, F, Cl, Br, I oder CN ersetzt sein können, oder einem aromatischen oder heteroaromatischen Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁸ substituiert sein kann, oder eine Aralkyl- oder Heteroaralkylgruppe mit 5 bis 60 aromatischen Ringatomen, die durch einen oder mehrere Reste R⁸ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann.

6. Verbindung gemäß Anspruch 5, **dadurch gekennzeichnet, dass** der sterisch anspruchsvolle Rest ausgewählt ist aus den Strukturen der Formeln (R-1) bis (R-112): 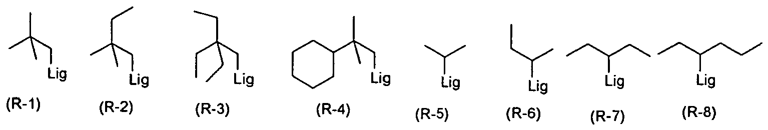 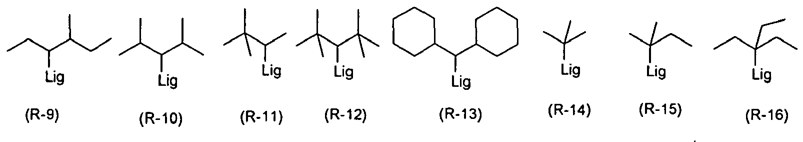 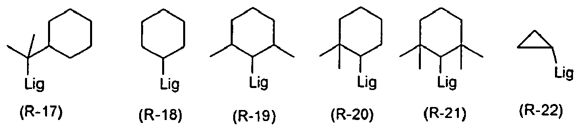 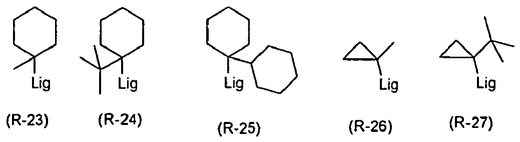 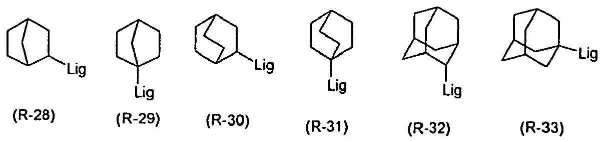 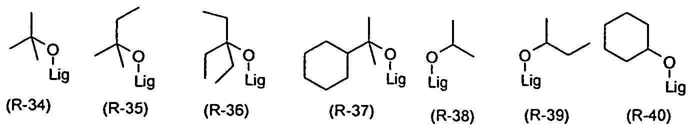 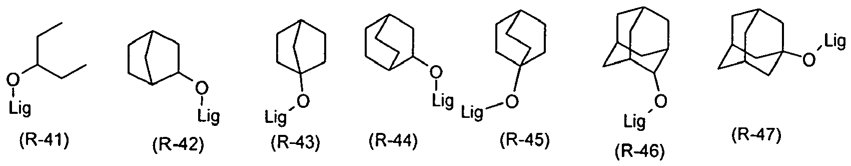 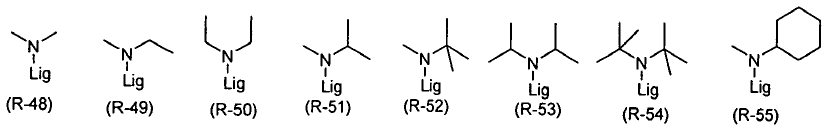 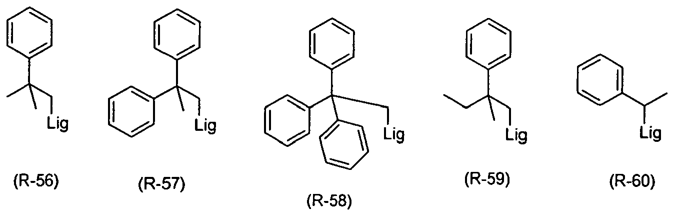 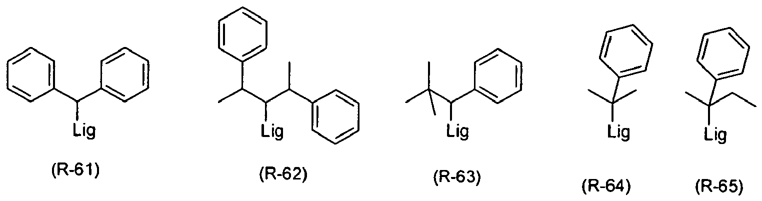 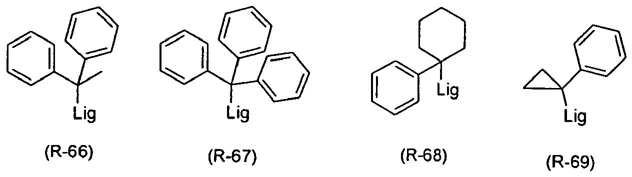 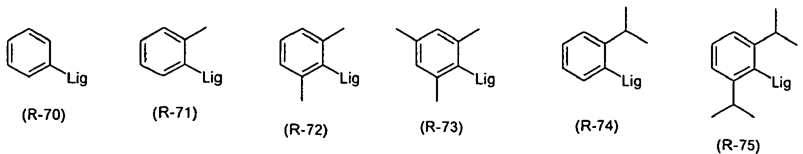 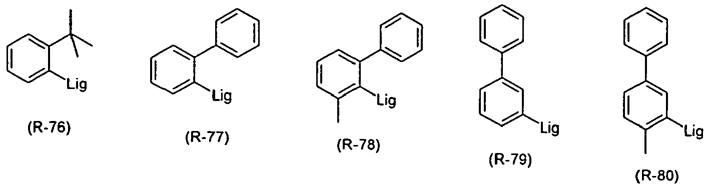 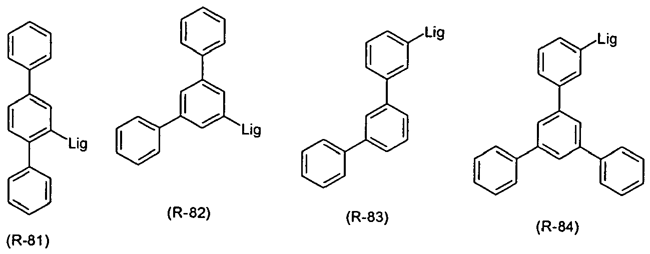 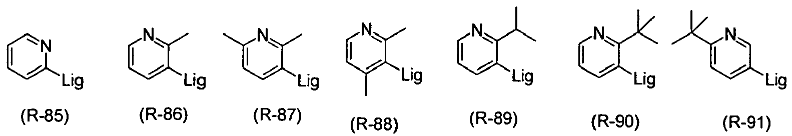 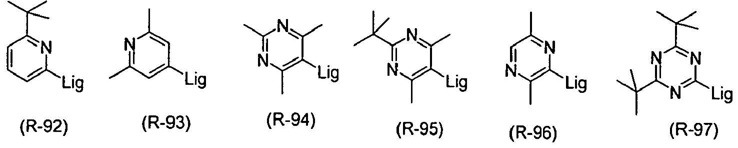 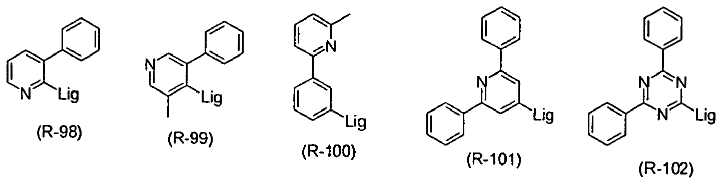 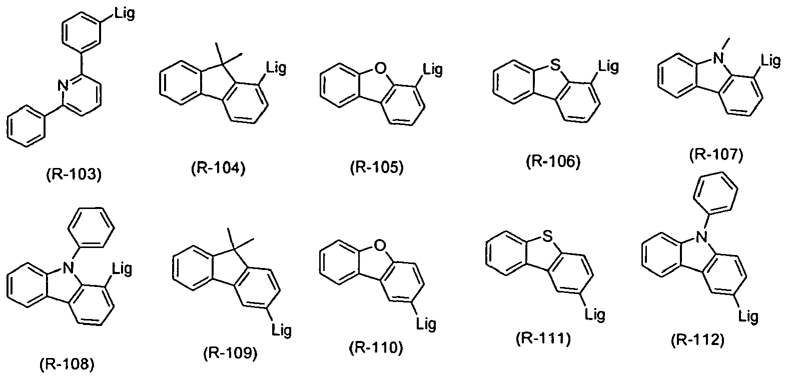 wobei Lig die Anknüpfung der Gruppe an den Liganden kennzeichnet und die aromatischen und heteroaromatischen Gruppen jeweils durch einen oder mehrere Reste R⁸ substituiert sein können.

7. Verbindung nach einem oder mehreren der Ansprüche 1 bis 6, **dadurch gekennzeichnet, dass** der Index n = 2 ist und die beiden Teilliganden gemäß Formel (2) gleich sind.

8. Verbindung nach einem oder mehreren der Ansprüche 1 bis 7, **dadurch gekennzeichnet, dass** V für NR⁷ steht und R⁷ ausgewählt ist aus der Gruppe bestehend aus einer geradkettigen Alkylgruppe mit 1 bis 20 C-Atomen oder einer verzweigten oder cyclischen Alkylgruppe mit 3 bis 20 C-Atomen, die jeweils mit einem oder mehreren Resten R⁸ substituiert sein kann, wobei ein oder mehrere H-Atome durch D, F oder CN ersetzt sein können, oder einem aromatischen oder heteroaromatischen Ringsystem mit 5 bis 60 aromatischen Ringatomen, das jeweils durch einen oder mehrere Reste R⁸ substituiert sein kann.

9. Verbindung nach Anspruch 8, **dadurch gekennzeichnet, dass** R⁷ ausgewählt ist aus den Gruppen der Formeln (36) bis (45), 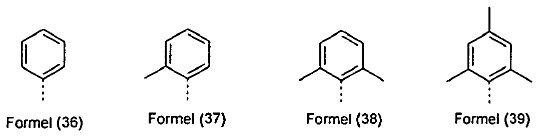 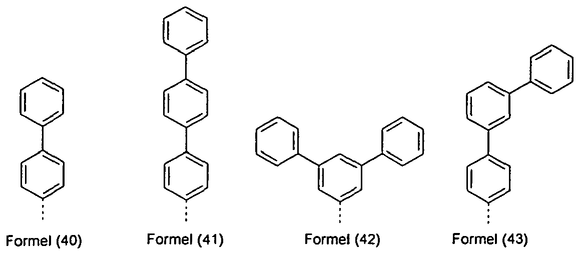 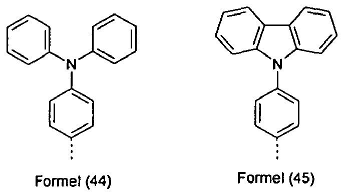 wobei die gestrichelte Bindung die Bindung an das Boratom bzw. das Stickstoffatom darstellt und die terminalen Phenylgruppen in Formel (44) auch durch ein oder mehrere Alkylgruppen mit 1 bis 5 C-Atomen substituiert sein können.

10. Verfahren zur Herstellung einer Verbindung nach einem oder mehreren der Ansprüche 1 bis 9 durch Umsetzung des entsprechenden freien Liganden mit Metallalkoholaten der Formel (46), mit Metallketoketonaten der Formel (47) oder mit Metallhalogeniden der Formel (48),
M(OR₈)ₚ Formel (46) 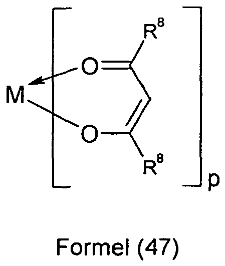
MHaIₚ Formel (48)
wobei die Symbole M und R⁸ die in Anspruch 1 angegebenen Bedeutungen haben, Hal = F, Cl, Br oder I ist und p je nach Wertigkeit des Metalls M für 1, 2 oder 3 steht.

11. Formulierung, insbesondere eine Lösung, Suspension oder Mini-emulsion, enthaltend ein oder mehrere Verbindungen nach einem oder mehreren der Ansprüche 1 bis 9 und mindestens eine Lösemittel.

12. Verwendung einer Verbindung nach einem oder mehreren der Ansprüche 1 bis 9 oder einer Formulierung nach Anspruch 11 in einer elektronischen Vorrichtung, bevorzugt ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden.

13. Elektronische Vorrichtung, bevorzugt ausgewählt aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen oder organischen Laserdioden, enthaltend eine oder mehrere Verbindungen nach einem oder mehreren der Ansprüche 1 bis 9.

14. Elektronische Vorrichtung nach Anspruch 13, **dadurch gekennzeichnet, dass** es sich um eine organische Elektrolumineszenzvorrichtung handelt und die Verbindung nach einem oder mehreren der Ansprüche 1 bis 9 als emittierende Verbindung in einer oder mehreren emittierenden Schichten enthält.

15. Elektronische Vorrichtung nach Anspruch 14, **dadurch gekennzeichnet, dass** die Verbindung nach einem oder mehreren der Ansprüche 1 bis 9 in Kombination mit einem Matrixmaterial eingesetzt wird, welches ausgewählt ist aus der Gruppe bestehend aus Ketonen, Phosphinoxiden, Sulfoxiden, Sulfonen, Triarylaminen, Carbazolderivaten, Indolocarbazolderivaten, Indenocarbazolderivaten, Azacarbazolen, bipolaren Matrixmaterialien, Azaborolen, Boronestern, Diazasilolderivaten, Diazaphospholderivaten, Triazinderivaten, Zinkkomplexen, Dibenzofuranderivaten oder verbrückten Carbazolderivaten.

## Claims

1. Compound of the formula (1), 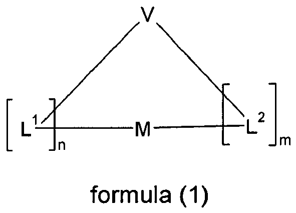 where L¹ stands, identically or differently on each occurrence, for a part-ligand of the following formula (2), 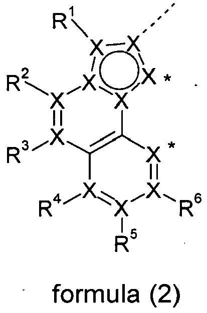 where the dashed bond indicates the bond to V, * denotes the position of the coordination to M and the following applies to the symbols and indices used:
M is selected from the group consisting of Pt, Ir and Au;
V is selected from the group consisting of NR⁷, N⁻, BR⁷, B(R⁷)₂⁻, O, S and Se;
X is on each occurrence, identically or differently, C or N, where all X in the part-ligand of the formula (2) together form a 14 π electron system, with the proviso that at least two groups X and at most 6 groups X in each part-ligand of the formula (2) stand for N;
R¹ to R⁶ is on each occurrence, identically or differently, H, D, F, Cl, Br, I, N(R⁸)₂, CN, NO₂, Si(R⁸)₃, B(OR⁸)₂, C(=O)R⁸, P(=O)(R⁸)₂, S(=O)R⁸, S(=O)₂R⁸, OSO₂R⁸, a straight-chain alkyl, alkoxy or thioalkoxy group having 1 to 40 C atoms or an alkenyl or alkynyl group having 2 to 40 C atoms or a branched or cyclic alkyl, alkoxy or thioalkoxy group having 3 to 40 C atoms, each of which may be substituted by one or more radicals R⁸, where one or more non-adjacent CH₂ groups may be replaced by R⁸C=CR⁸, C=C, Si(R⁸)₂, C=O, C=S, C=NR⁸, P(=O)(R⁸), SO, SO₂, NR⁸, O, S or CONR⁸ and where one or more H atoms may be replaced by D, F, Cl, Br, I or CN, or an aromatic or heteroaromatic ring system having 5 to 60 aromatic ring atoms, which may in each case be substituted by one or more radicals R⁸, or an aryloxy or heteroaryloxy group having 5 to 60 aromatic ring atoms, which may be substituted by one or more radicals R⁸, or an aralkyl or heteroaralkyl group having 5 to 60 aromatic ring atoms, which may be substituted by one or more radicals R⁸, or a diarylamino group, diheteroarylamino group or arylheteroarylamino group having 10 to 40 aromatic ring atoms, which may be substituted by one or more radicals R⁸; R⁴ and R⁵ and/or R⁵ and R⁶ and/or R¹ and R⁷ here may also form a mono- or polycyclic, aliphatic, aromatic and/or benzo-fused ring system with one another; furthermore, R² and R³ may form a mono- or polycyclic, aliphatic ring system with one another; with the proviso that R¹ to R⁶ represents a free electron pair if the group X to which this radical R¹ to R⁶ is bonded is a nitrogen atom with a saturated valence;
R⁷ is on each occurrence, identically or differently, H, D, Si(R⁸)₃, C(=O)R⁸, a straight-chain alkyl or alkoxy group having 1 to 40 C atoms or an alkenyl or alkynyl group having 2 to 40 C atoms or a branched or cyclic alkyl or alkoxy group having 3 to 40 C atoms, each of which may be substituted by one or more radicals R⁸, where one or more non-adjacent CH₂ groups may be replaced by R⁸C=CR⁸, C=C, Si(R⁸)₂, C=O, C=S, C=NR⁸, P(=O)(R⁸), SO, SO₂, NR⁸, O, S or CONR⁸ and where one or more H atoms may be replaced by D, F, Cl, Br, I or CN, or an aromatic or heteroaromatic ring system having 5 to 60 aromatic ring atoms, which may in each case be substituted by one or more radicals R⁸, or an aryloxy or heteroaryloxy group having 5 to 60 aromatic ring atoms, which may be substituted by one or more radicals R⁸, or an aralkyl or heteroaralkyl group having 5 to 60 aromatic ring atoms, which may be substituted by one or more radicals R⁸; R¹ and R⁷ here may also form a mono- or polycyclic, aliphatic, aromatic and/or benzo-fused ring system with one another;
R⁸ is on each occurrence, identically or differently, H, D, F, Cl, Br, I, N(R⁹)₂, CN, NO₂, Si(R⁹)₃, B(OR⁹)₂, C(=O)R⁹, P(=O)(R⁹)₂, S(=O)R⁹, S(=O)₂R⁹, OSO₂R⁹, a straight-chain alkyl, alkoxy or thioalkoxy group having 1 to 40 C atoms or an alkenyl or alkynyl group having 2 to 40 C atoms or a branched or cyclic alkyl, alkoxy or thioalkoxy group having 3 to 40 C atoms, each of which may be substituted by one or more radicals R⁹, where one or more non-adjacent CH₂ groups may be replaced by R⁹C=CR⁹, C=C, Si(R⁹)₂, C=O, C=S, C=NR⁹, P(=O)(R⁹), SO, SO₂, NR⁹, O, S or CONR⁹ and where one or more H atoms may be replaced by D, F, Cl, Br, I or CN, or an aromatic or heteroaromatic ring system having 5 to 60 aromatic ring atoms, which may in each case be substituted by one or more radicals R⁹, or an aryloxy or heteroaryloxy group having 5 to 60 aromatic ring atoms, which may be substituted by one or more radicals R⁹, or an aralkyl or heteroaralkyl group having 5 to 60 aromatic ring atoms, which may be substituted by one or more radicals R⁹, or a diarylamino group, diheteroarylamino group or arylheteroarylamino group having 10 to 40 aromatic ring atoms, which may be substituted by one or more radicals R⁹; two or more adjacent radicals R⁸ here may form a mono- or polycyclic, aliphatic or aromatic ring system with one another;
R⁹ is on each occurrence, identically or differently, H, D, F or an aliphatic, aromatic and/or heteroaromatic hydrocarbon radical having 1 to 20 C atoms, in which, in addition, one or more H atoms may be replaced by F; two or more substituents R⁹ here may also form a mono- or polycyclic, aliphatic or aromatic ring system with one another;
L² is a bidentate part-ligand which is bonded to V;
n is 1 or 2;
m is (2 - n).

2. Compound according to Claim 1, **characterised in that** the part-ligand of the formula (2) is selected from structures of the formula (4), 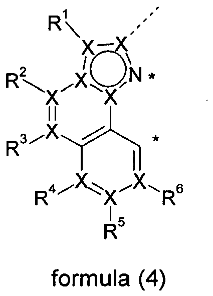 where the symbols used have the meanings given in Claim 1 and at least one symbol X and at most 5 symbols X stand for N.

3. Compound according to Claim 1 or 2, **characterised in that** the part-ligand of the formula (2) is selected from the part-ligands of the formulae (5), (6) or (7), 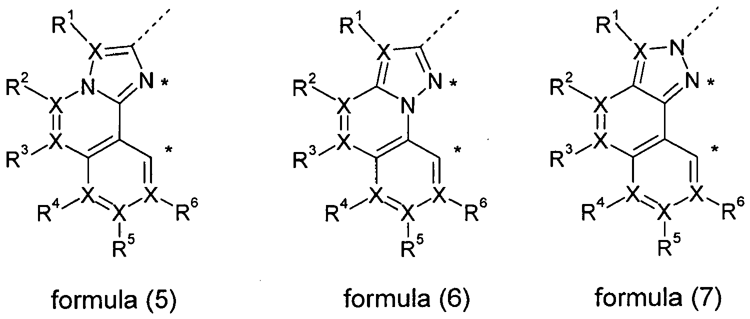 where the symbols used have the meanings given in Claim 1, in the case of the use of the part-ligands of the formula (7) the bridging unit V is selected from BR⁷ and B(R⁷)₂ and the part-ligands contain two, three, four, five or six nitrogen atoms.

4. Compound according to one or more of Claims 1 to 3, **characterised in that** the part-ligands of the formula (2) are selected from the part-ligands of the formulae (5a) to (5r), (6a) to (6r) or (7a) to (7r), 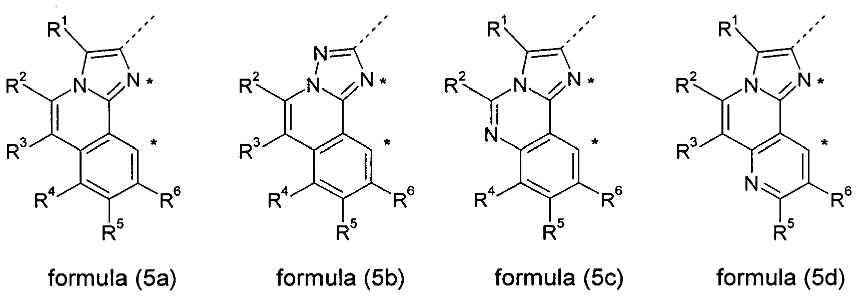 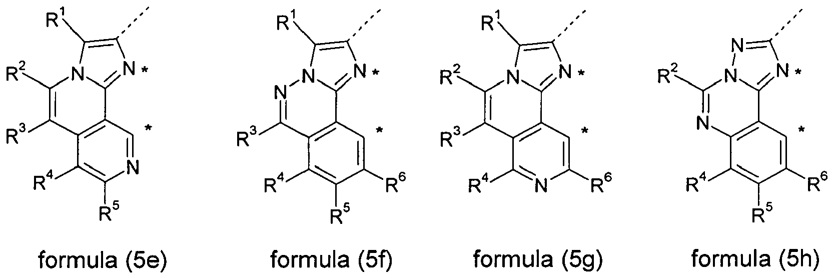 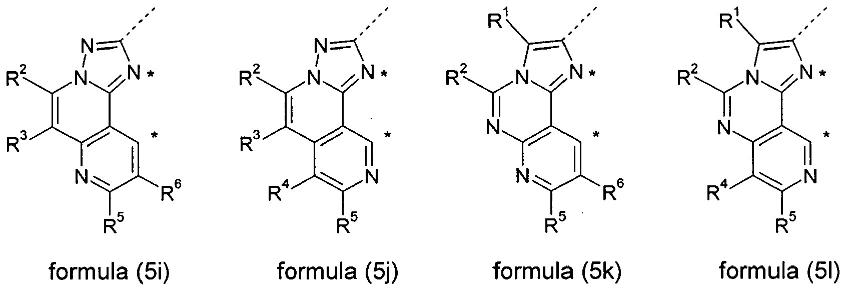 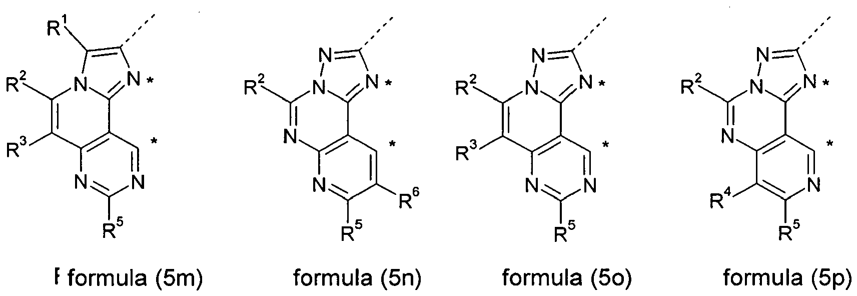 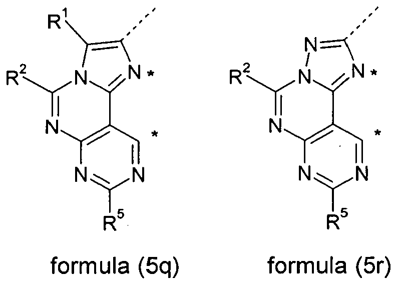 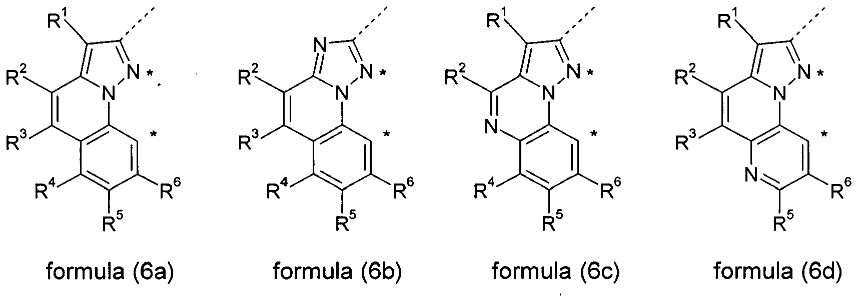 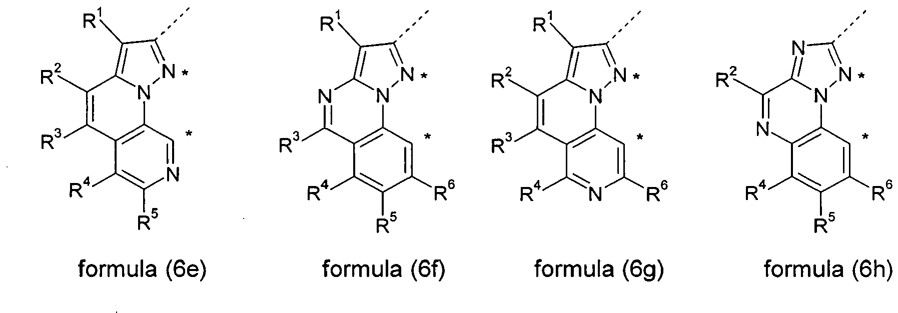 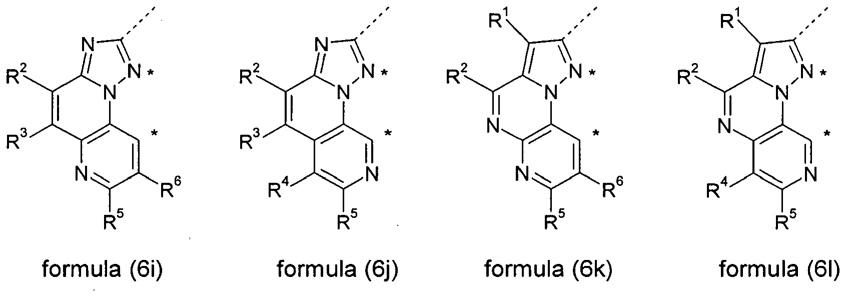 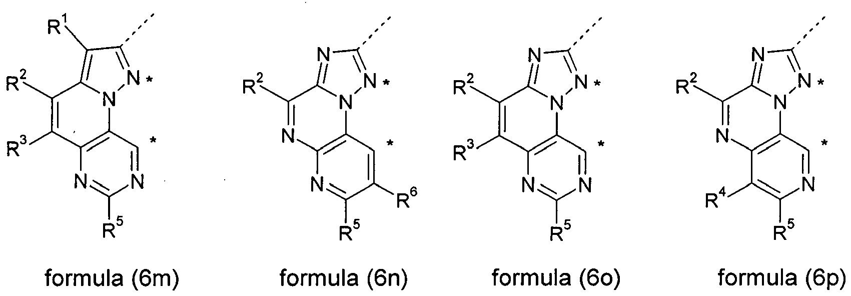 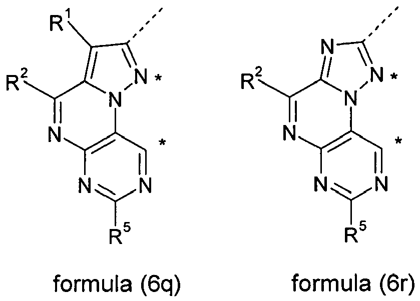 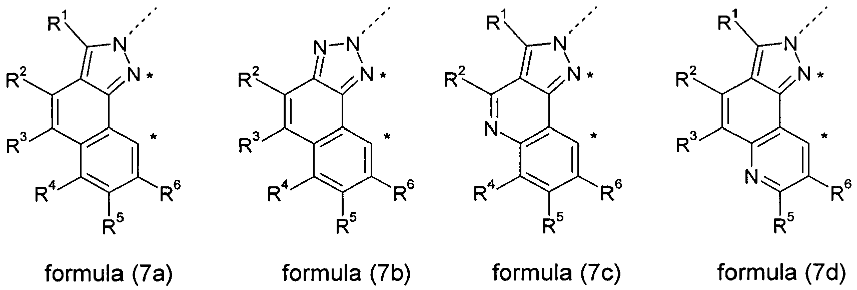 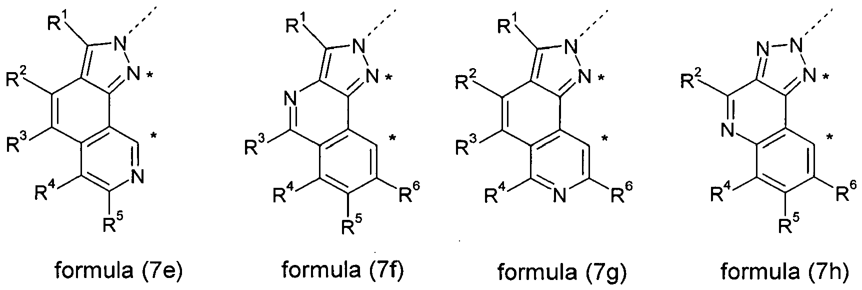 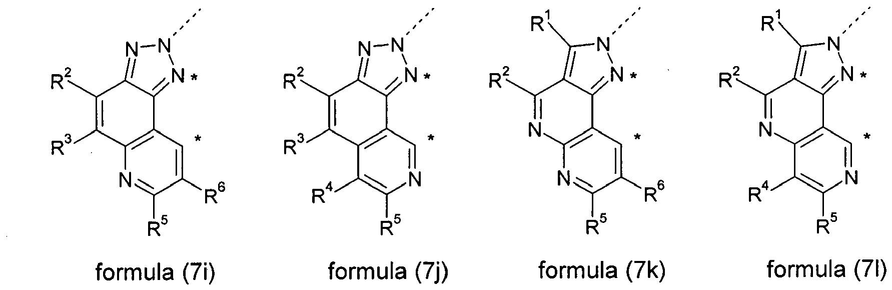 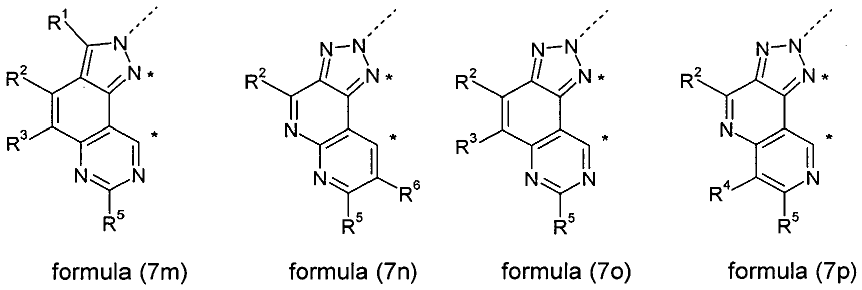 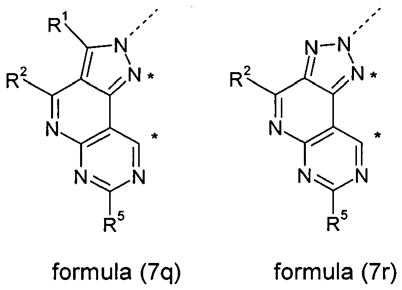 where the symbols used have the meanings given in Claim 1.

5. Compound according to one or more of Claims 1 to 4, **characterised in that**, if the part-ligand of the formula (2) contains 3 or more nitrogen atoms, a bulky radical which is selected, identically or differently on each occurrence, from the group consisting of N(R⁸)₂, a straight-chain alkyl, alkoxy or thioalkoxy group having 1 to 40 C atoms or an alkenyl or alkynyl group having 2 to 40 C atoms or a branched or cyclic alkyl, alkoxy or thioalkoxy group having 3 to 40 C atoms, each of which may be substituted by one or more radicals R⁸, where one or more non-adjacent CH₂ groups may be replaced by R⁸C=CR⁸, C=C, Si(R⁸)₂, C=O, C=S, C=NR⁸, P(=O)(R⁷), SO, SO₂, NR⁸, O, S or CONR⁸ and where one or more H atoms may be replaced by D, F, Cl, Br, I or CN, or an aromatic or heteroaromatic ring system having 5 to 60 aromatic ring atoms, which may in each case be substituted by one or more radicals R⁸, or an aryloxy or heteroaryloxy group having 5 to 60 aromatic ring atoms, which may be substituted by one or more radicals R⁸, or an aralkyl or heteroaralkyl group having 5 to 60 aromatic ring atoms, which may be substituted by one or more radicals R⁸, or a diarylamino group, diheteroarylamino group or arylheteroarylamino group having 10 to 40 aromatic ring atoms, which may be substituted by one or more radicals R⁸, is bonded to a carbon atom which is adjacent to a nitrogen atom which is not coordinated to the metal and which is not simultaneously bonded in a five-membered ring and a six-membered ring,

6. Compound according to Claim 5, **characterised in that** the bulky radical is selected from the structures of the formulae (R-1) to (R-112): 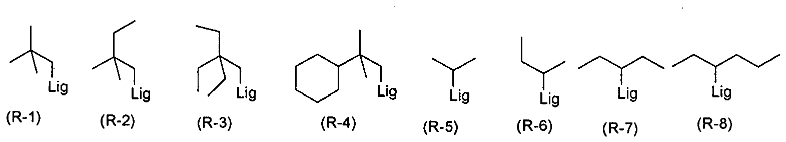 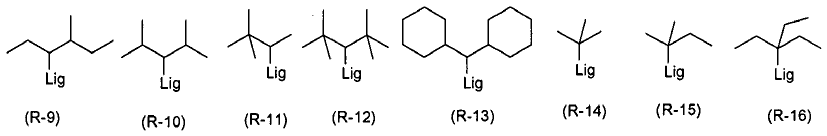 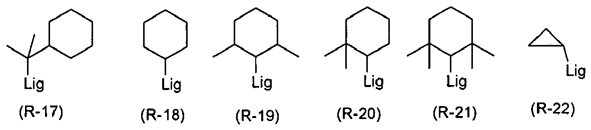 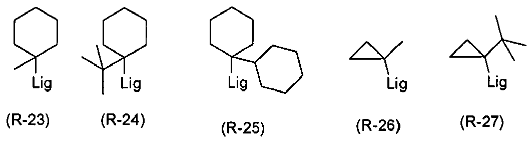 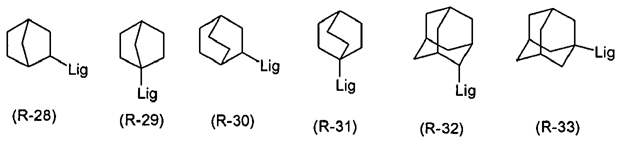 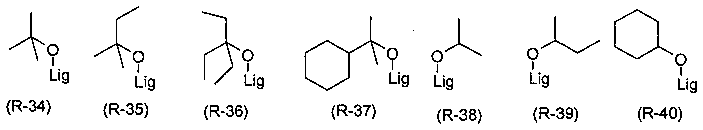 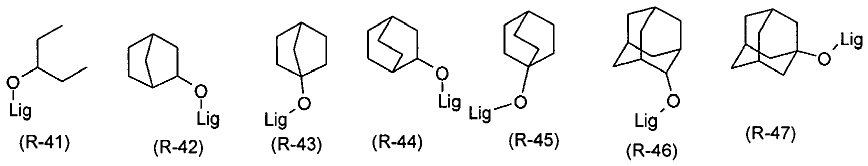 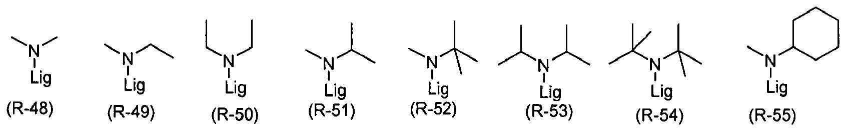 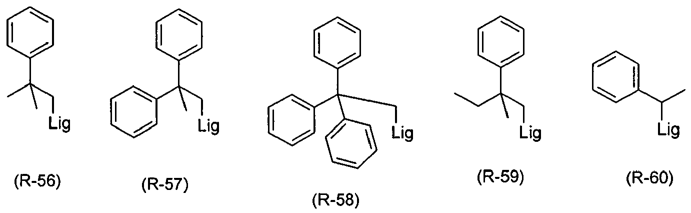 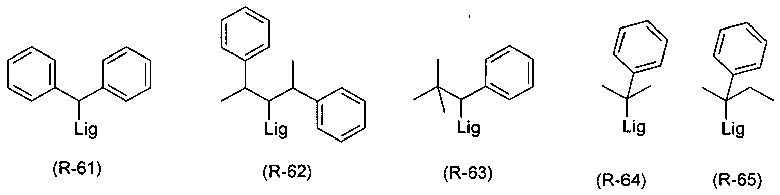 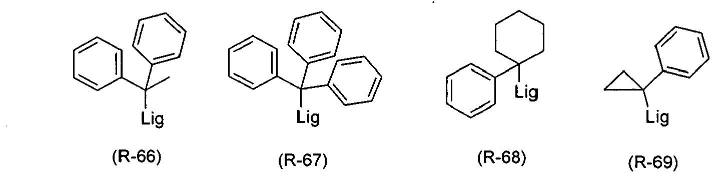 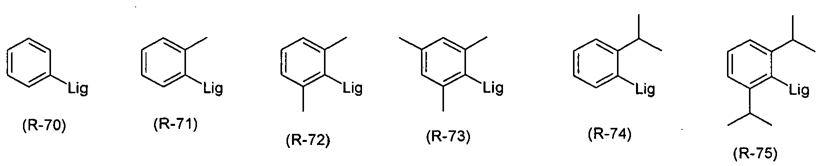 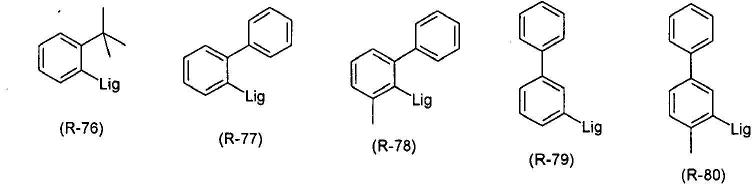 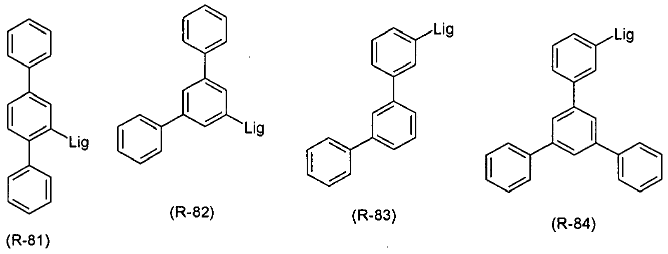 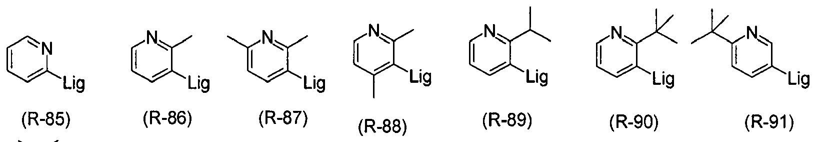 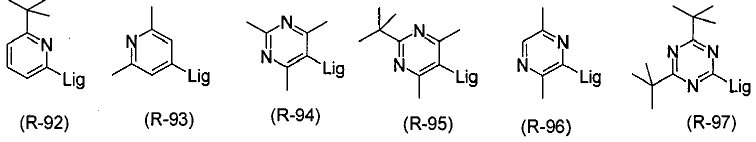 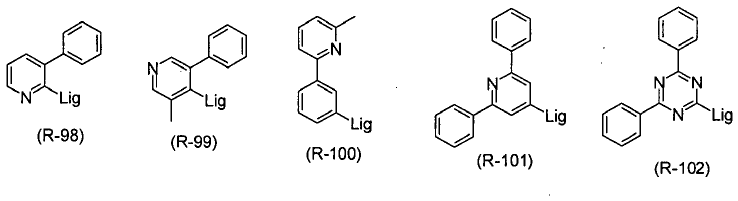 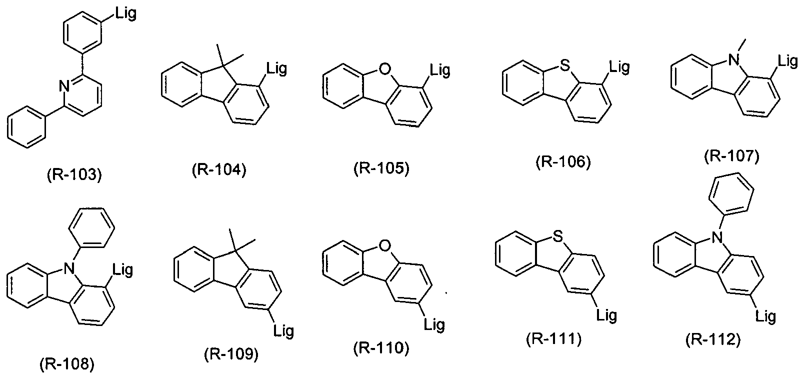 where Lig denotes the link from the group to the ligand and the aromatic and heteroaromatic groups may each be substituted by one or more radicals R⁸.

7. Compound according to one or more of Claims 1 to 6, **characterised in that** the index n = 2 and the two part-ligands of the formula (2) are identical.

8. Compound according to one or more of Claims 1 to 7, **characterised in that** V stands for NR⁷ and R⁷ is selected from the group consisting of a straight-chain alkyl group having 1 to 20 C atoms or a branched or cyclic alkyl group having 3 to 20 C atoms, each of which may be substituted by one or more radicals R⁸, where one or more H atoms may be replaced by D, F or CN, or an aromatic or heteroaromatic ring system having 5 to 60 aromatic ring atoms, which may in each case be substituted by one or more radicals R⁸.

9. Compound according to Claim 8, **characterised in that** R⁷ is selected from the groups of the formulae (36) to (45), 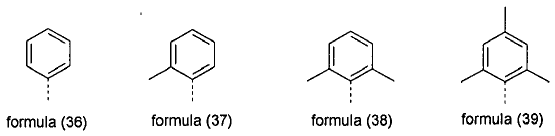 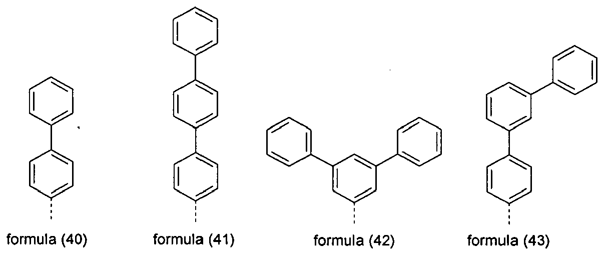 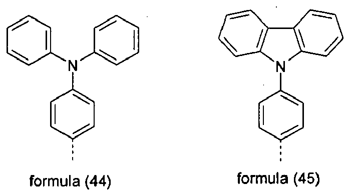 where the dashed bond represents the bond to the boron atom or the nitrogen atom and the terminal phenyl groups in formula (44) may also be substituted by one or more alkyl groups having 1 to 5 C atoms.

10. Process for the preparation of a compound according to one or more of Claims 1 to 9 by reaction of the corresponding free ligand with metal alkoxides of the formula (46), with metal ketoketonates of the formula (47) or with metal halides of the formula (48),
M(OR⁸)ₚ formula (46) 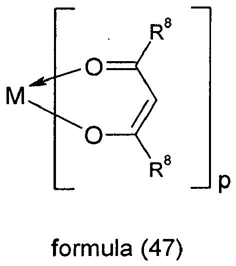
MHaIₚ formula (48)
where the symbols M and R⁸ have the meanings indicated in Claim 1, Hal = F, Cl, Br or I and p stands for 1, 2 or 3, depending on the valence of the metal M.

11. Formulation, in particular a solution, suspension or mini-emulsion, comprising one or more compounds according to one or more of Claims 1 to 9 and at least one solvent.

12. Use of a compound according to one or more of Claims 1 to 9 or a formulation according to Claim 11 in an electronic device, preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes.

13. Electronic device, preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells or organic laser diodes, comprising one or more compounds according to one or more of Claims 1 to 9.

14. Electronic device according to Claim 13, **characterised in that** it is an organic electroluminescent device and comprises the compound according to one or more of Claims 1 to 9 as emitting compound in one or more emitting layers.

15. Electronic device according to Claim 14, **characterised in that** the compound according to one or more of Claims 1 to 9 is employed in combination with a matrix material which is selected from the group consisting of ketones, phosphine oxides, sulfoxides, sulfones, triaryl-amines, carbazole derivatives, indolocarbazole derivatives, indeno-carbazole derivatives, azacarbazoles, bipolar matrix materials, azaboroles, boronic esters, diazasilole derivatives, diazaphosphole derivatives, triazine derivatives, zinc complexes, dibenzofuran derivatives or bridged carbazole derivatives.

## Revendications

1. Composé de la formule (1) : 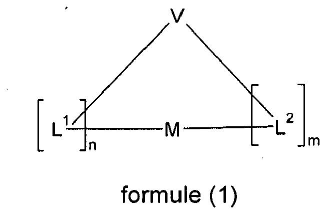 dans laquelle L¹ représente, de manière identique ou différente pour chaque occurrence, un ligand partiel de la formule (2) qui suit : 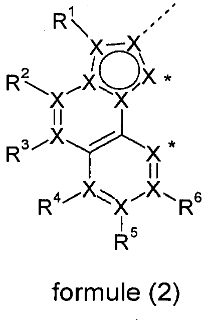 dans laquelle la liaison en pointillés indique la liaison sur V, * représente la position de la coordination sur M et ce qui suit s'applique aux symboles et indices utilisés :
M est choisi parmi le groupe constitué par Pt, Ir et Au ;
V est choisi parmi le groupe constitué par NR⁷, N⁻, BR⁷, B(R')₂⁻, O, S et Se;
X est, pour chaque occurrence, de manière identique ou différente, C ou N, où tous les X dans le ligand partiel de la formule (2) forment ensemble un système à 14 électrons π, étant entendu qu'au moins deux groupes X et au plus 6 groupes X dans chaque ligand partiel de la formule (2) représentent N ;
R¹ à R⁶ sont, pour chaque occurrence, de manière identique ou différente, H, D, F, CI, Br, I, N(R⁸)₂, CN, NO₂, Si(R⁸)₃, B(OR⁸)₂, C(=O)R⁸, P(=O)(R⁸)2, S(=O)R⁸, S(=O)₂R⁸, OSO₂R⁸, un groupe alkyle, alcoxy ou thioalcoxy en chaîne droite comportant de 1 à 40 atome(s) de C ou un groupe alkényle ou alkynyle comportant de 2 à 40 atomes de C ou un groupe alkyle, alcoxy ou thioalcoxy ramifié ou cyclique comportant de 3 à 40 atomes de C, dont chacun peut être substitué par un radical ou plusieurs radicaux R⁸, où un ou plusieurs groupes CH₂ non adjacents peut/peuvent être remplacé(s) par R⁸C=CR⁸, C=C, Si(R⁸)₂, C=O, C=S, C=NR⁸, P(=O)(R⁸), SO, SO₂, NR⁸, O, S ou CONR⁸ et où un ou plusieurs atome(s) de H peut/peuvent être remplacé(s) par D, F, CI, Br, I ou CN, ou un système de cycle aromatique ou hétéroaromatique comportant de 5 à 60 atomes de cycle aromatique, lequel peut dans chaque cas être substitué par un radical ou plusieurs radicaux R⁸, ou un groupe aryloxy ou hétéroaryloxy comportant de 5 à 60 atomes de cycle aromatique, lequel peut être substitué par un radical ou plusieurs radicaux R⁸, ou un groupe aralkyle ou hétéroaralkyle comportant de 5 à 60 atomes de cycle aromatique, lequel peut être substitué par un radical ou plusieurs radicaux R⁸, ou un groupe diarylamino, un groupe dihétéroarylamino, un groupe arylhétéroarylamino comportant de 10 à 40 atomes de cycle aromatique, lesquels peuvent être substitués par un radical ou plusieurs radicaux R⁸ ; R⁴ et R⁵ et/ou R⁵ et R⁶ et/ou R¹ et R⁷ peuvent également ici former un système de cycle aliphatique, aromatique et/ou benzo-fusionné monocyclique ou polycyclique l'un avec l'autre ou les uns avec les autres ; en outre, R² et R³ peuvent former un système de cycle aliphatique monocyclique ou polycyclique l'un avec l'autre ;
étant entendu que R¹ à R⁶ représentent une paire d'électrons libres si le groupe X auquel ce radical R¹ à R⁶ est lié est un atome d'azote présentant une valence saturée ;
R⁷ est, pour chaque occurrence, de manière identique ou différente, H, D, Si(R⁸)₃, C(=O)R⁸, un groupe alkyle ou alcoxy en chaîne droite comportant de 1 à 40 atome(s) de C ou un groupe alkényle ou alkynyle comportant de 2 à 40 atomes de C ou un groupe alkyle ou alcoxy ramifié ou cyclique comportant de 3 à 40 atomes de C, dont chacun peut être substitué par un radical ou plusieurs radicaux R⁸, où un ou plusieurs groupes CH₂ non adjacents peut/peuvent être remplacé(s) par R⁸C=CR⁸, C=C, Si(R⁸)₂, C=O, C=S, C=NR⁸, P(=O)(R⁸), SO, SO₂, NR⁸, O, S ou CONR⁸ et où un ou plusieurs atome(s) de H peut/peuvent être remplacé(s) par D, F, Cl, Br, I ou CN, ou un système de cycle aromatique ou hétéroaromatique comportant de 5 à 60 atomes de cycle aromatique, lequel peut dans chaque cas être substitué par un radical ou plusieurs radicaux R⁸, ou un groupe aryloxy ou hétéroaryloxy comportant de 5 à 60 atomes de cycle aromatique, lequel peut être substitué par un radical ou plusieurs radicaux R⁸, ou un groupe aralkyle ou hétéroaralkyle comportant de 5 à 60 atomes de cycle aromatique, lequel peut être substitué par un radical ou plusieurs radicaux R⁸ ; R¹ et R⁷ peuvent également ici former un système de cycle aliphatique, aromatique et/ou benzo-fusionné monocyclique ou polycyclique l'un avec l'autre ;
R⁸ est, pour chaque occurrence, de manière identique ou différente, H, D, F, Cl, Br, I, N(R⁹)₂, CN, NO₂, Si(R⁹)₃, B(OR⁹)₂, C(=O)R⁹, P(=O)(R⁹)₂, S(=O)R⁹, S(=O)₂R⁹, OSO₂R⁹, un groupe alkyle, alcoxy ou thioalcoxy en chaîne droite comportant de 1 à 40 atome(s) de C ou un groupe alkényle ou alkynyle comportant de 2 à 40 atomes de C ou un groupe alkyle, alcoxy ou thioalcoxy ramifié ou cyclique comportant de 3 à 40 atomes de C, dont chacun peut être substitué par un radical ou plusieurs radicaux R⁹, où un ou plusieurs groupes CH₂ non adjacents peut/peuvent être remplacé(s) par R⁹C=CR⁹, C≡C, Si(R⁹)₂, C=O, C=S, C=NR⁹, P(=O)(R⁹), SO, SO₂, NR⁹, O, S ou CONR⁹ et où un ou plusieurs atome(s) de H peut/ peuvent être remplacé(s) par D, F, Cl, Br, I ou CN, ou un système de cycle aromatique ou hétéroaromatique comportant de 5 à 60 atomes de cycle aromatique, lequel peut dans chaque cas être substitué par un radical ou plusieurs radicaux R⁹, ou un groupe aryloxy ou hétéroaryloxy comportant de 5 à 60 atomes de cycle aromatique, lequel peut être substitué par un radical ou plusieurs radicaux R⁹, ou un groupe aralkyle ou hétéroaralkyle comportant de 5 à 60 atomes de cycle aromatique, lequel peut être substitué par un radical ou plusieurs radicaux R⁹, ou un groupe diarylamino, un groupe dihétéroarylamino ou un groupe arylhétéroarylamino comportant de 10 à 40 atomes de cycle aromatique, lequel peut être substitué par un radical ou plusieurs radicaux R⁹ ; deux radicaux R⁸ adjacents ou plus peuvent ici former un système de cycle aliphatique ou aromatique monocyclique ou polycyclique l'un avec l'autre ou les uns avec les autres ;
R⁹ est, pour chaque occurrence, de manière identique ou différente, H, D, F ou un radical hydrocarbone aliphatique, aromatique et/ou hétéroaromatique comportant de 1 à 20 atome(s) de C, où, en outre, un ou plusieurs atome(s) de H peut/peuvent être remplacé(s) par F ; deux substituants R⁹ ou plus peuvent également ici former un système de cycle aliphatique ou aromatique monocyclique ou polycyclique l'un avec l'autre ou les uns avec les autres ;
L² est un ligand partiel bidenté qui est lié à V ;
n est 1 ou 2 ;
m est (2 - n).

2. Composé selon la revendication 1, **caractérisé en ce que** le ligand partiel de la formule (2) est choisi parmi les structures de la formule (4) : 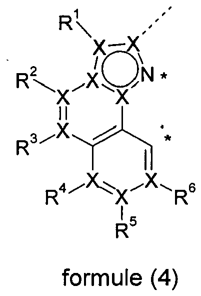 dans laquelle les symboles utilisés présentent les significations données selon la revendication 1 et au moins un symbole X et au plus 5 symboles X représentent N.

3. Composé selon la revendication 1 ou 2, **caractérisé en ce que** le ligand partiel de la formule (2) est choisi parmi les ligands partiels des formules (5), (6) ou (7) : 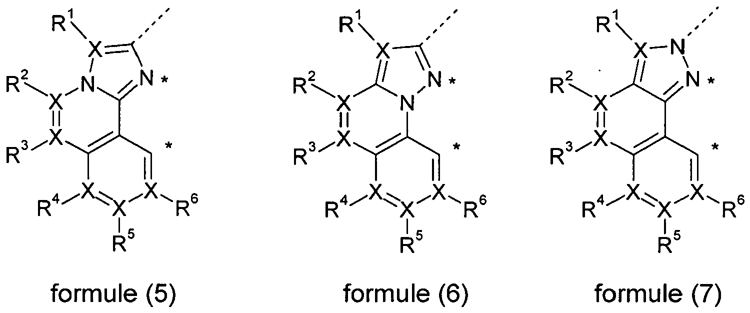 dans lesquelles les.symboles utilisés présentent les significations données selon la revendication 1, dans le cas de l'utilisation des ligands partiels de la formule (7), l'unité de pontage V est choisie parmi BR⁷ et B(R⁷)₂ et les ligands partiels contiennent deux, trois, quatre, cinq ou six atomes d'azote.

4. Composé selon une ou plusieurs des revendications 1 à 3, **caractérisé en ce que** les ligands de la formule (2) sont choisis parmi les ligands partiels des formules (5a) à (5r), (6a) à (6r) ou (7a) à (7r) : 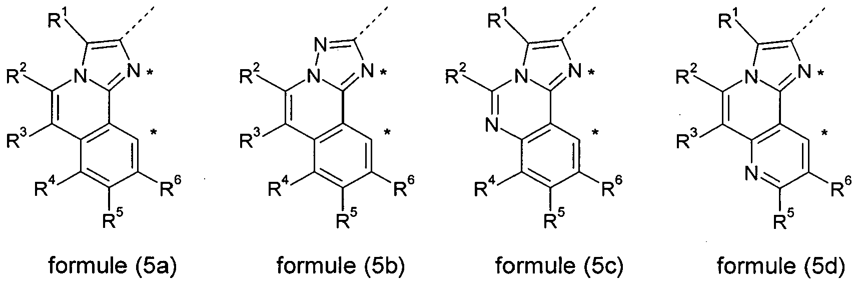 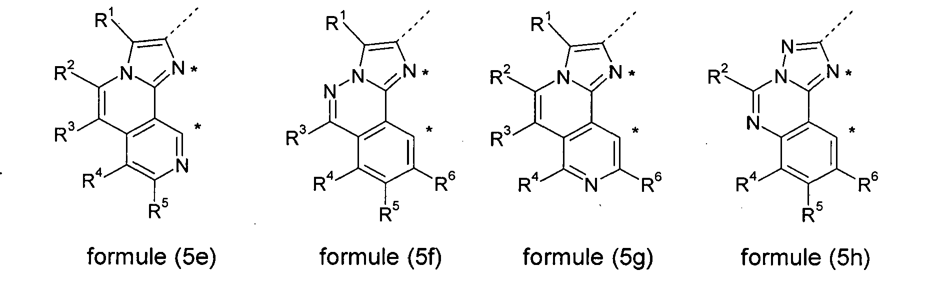 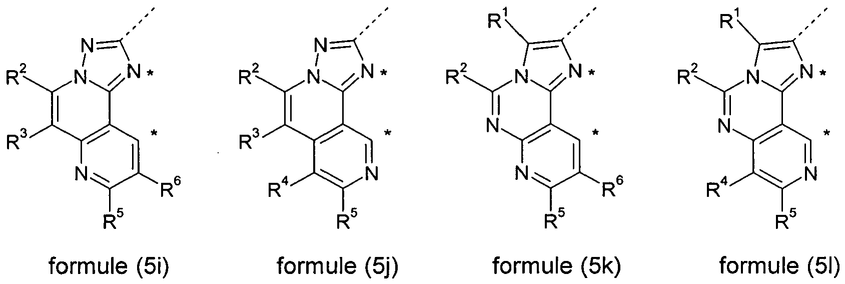 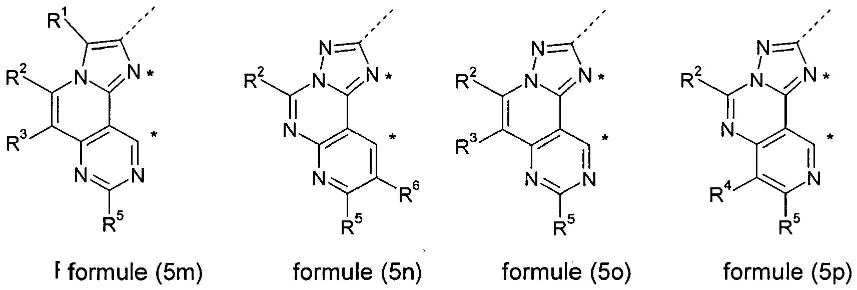 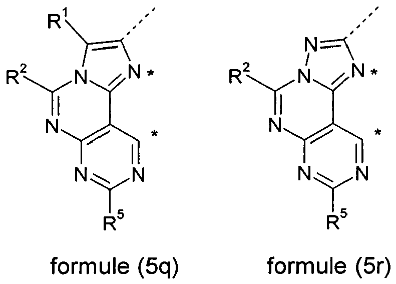 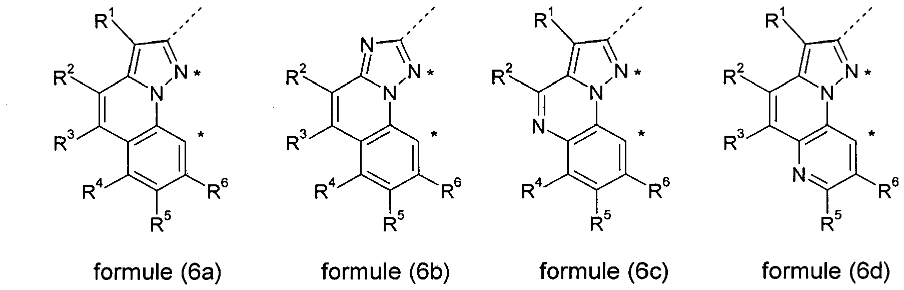 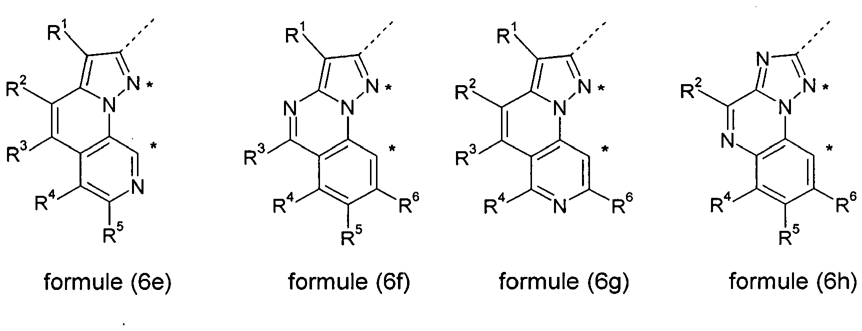 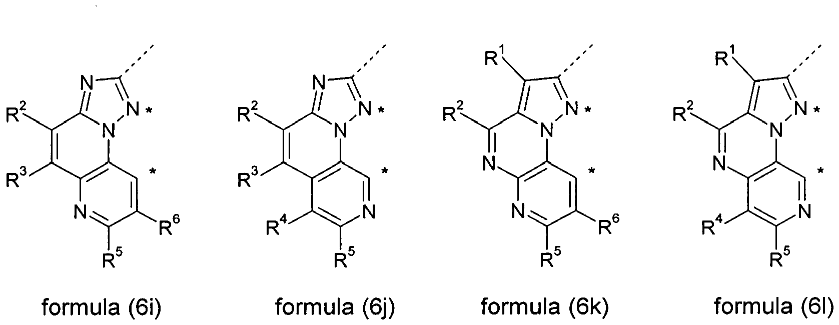 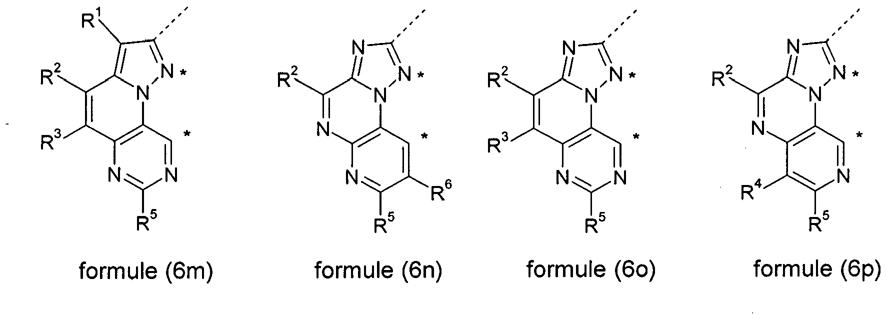 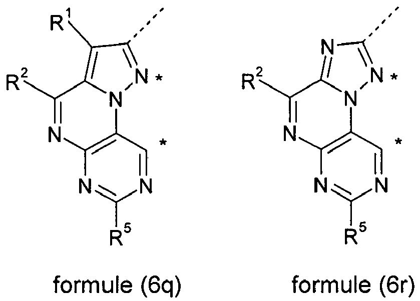 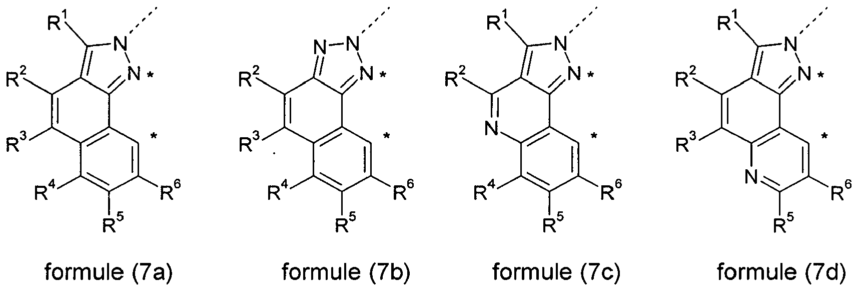 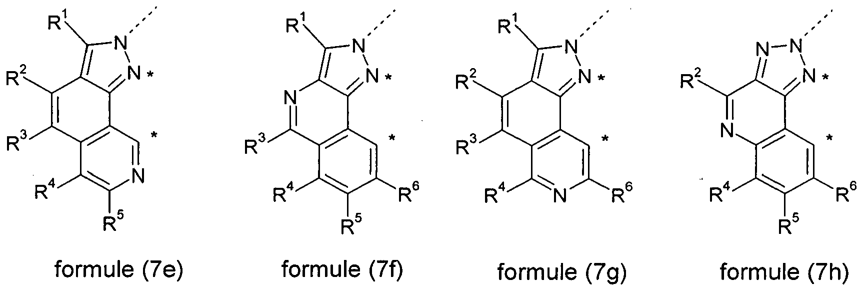 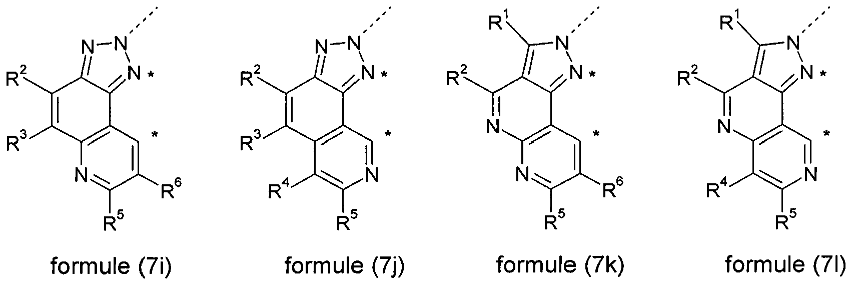 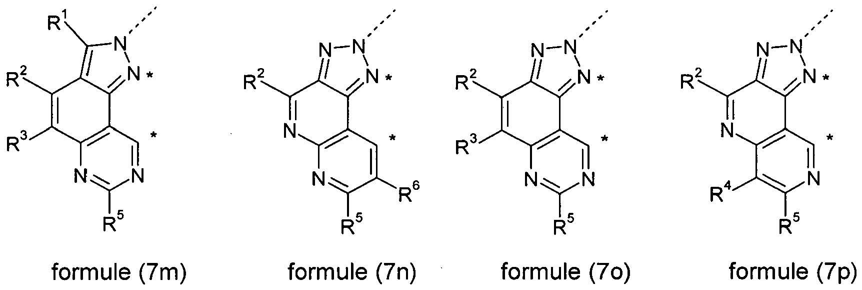 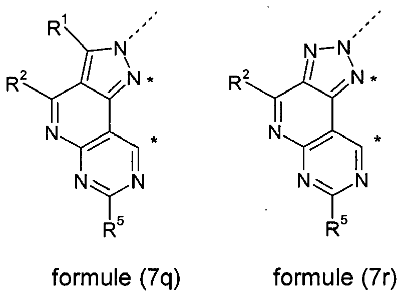 dans lesquelles les symboles utilisés présentent les significations données selon la revendication 1.

5. Composé selon une ou plusieurs des revendications 1 à 4, **caractérisé en ce que**, si le ligand partiel de la formule (2) contient 3 atomes d'azote ou plus, un radical dans la masse qui est choisi, de manière identique ou différente pour chaque occurrence, parmi le groupe constitué par N(R⁸)₂, un groupe alkyle, alcoxy ou thioalcoxy en chaîne droite comportant de 1 à 40 atome(s) de C ou un groupe alkényle ou alkynyle comportant de 2 à 40 atomes de C ou un groupe alkyle, alcoxy ou thioalcoxy ramifié ou cyclique comportant de 3 à 40 atomes de C, dont chacun peut être substitué par un radical ou plusieurs radicaux R⁸, où un ou plusieurs groupes CH₂ non adjacents peut/peuvent être remplacé(s) par R⁸C=CR⁸, C=C, Si(R⁸)₂, C=O, C=S, C=NR⁸, P(=O)(R⁷), SO, SO₂, NR⁸, O, S ou CONR⁸ et où un ou plusieurs atome(s) de H peut/peuvent être remplacé(s) par D, F, CI, Br, I ou CN, ou un système de cycle aromatique ou hétéroaromatique comportant de 5 à 60 atomes de cycle aromatique, lequel peut dans chaque cas être substitué par un radical ou plusieurs radicaux R⁸, ou un groupe aryloxy ou hétéroaryloxy comportant de 5 à 60 atomes de cycle aromatique, lequel peut être substitué par un radical ou plusieurs radicaux R⁸, ou un groupe aralkyle ou hétéroaralkyle comportant de 5 à 60 atomes de cycle aromatique, lequel peut être substitué par un radical ou plusieurs radicaux R⁸, ou un groupe diarylamino, un groupe dihétéroarylamino, ou un groupe arylhétéroarylamino comportant de 10 à 40 atomes de cycle aromatique, lequel peut être substitué par un radical ou plusieurs radicaux R⁸, est lié à un atome de carbone qui est adjacent à un atome d'azote qui n'est pas coordonné au métal et qui n'est pas simultanément lié dans un cycle à cinq éléments et dans un cycle à six éléments.

6. Composé selon la revendication 5, **caractérisé en ce que** le radical dans la masse est choisi parmi les structures des formules (R-1) à (R-112) : 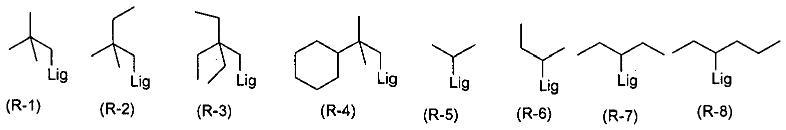 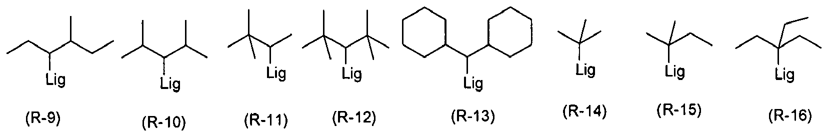 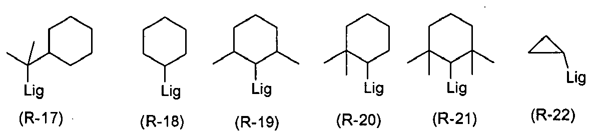 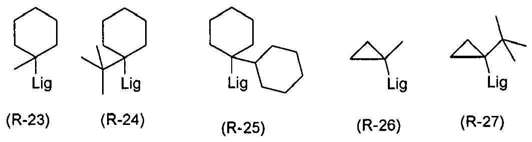 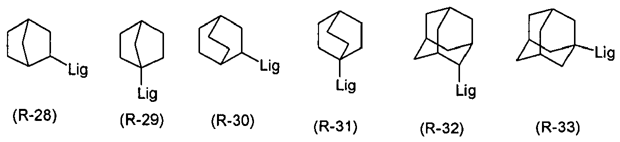 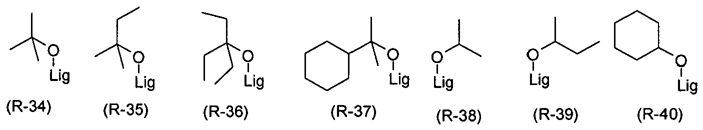 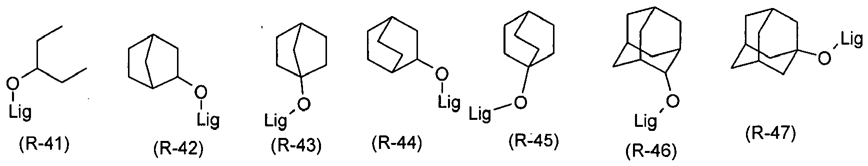 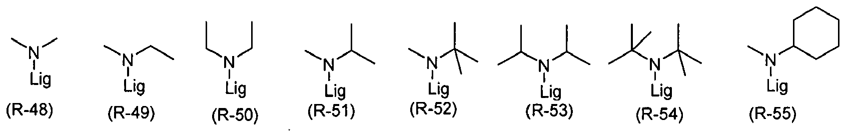 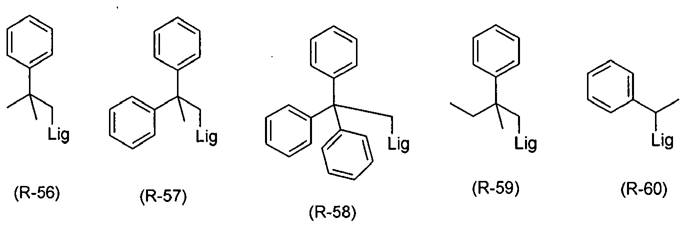 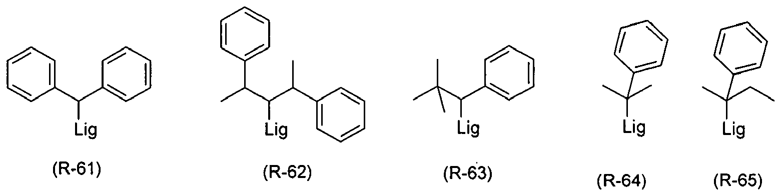 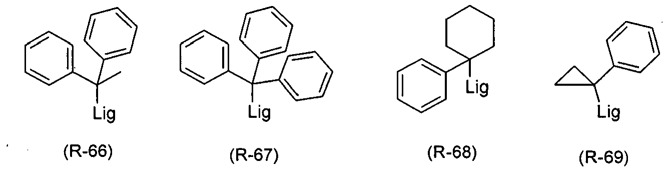 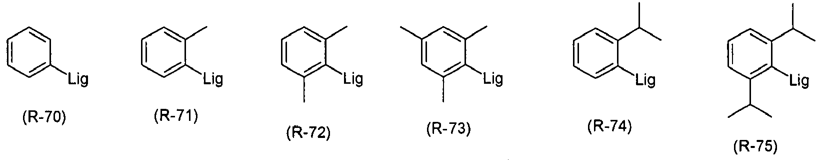 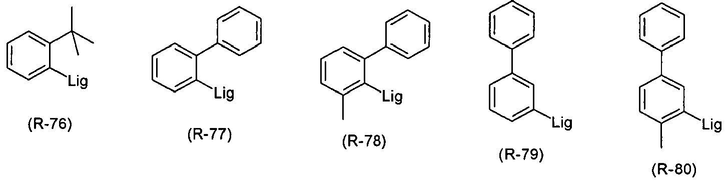 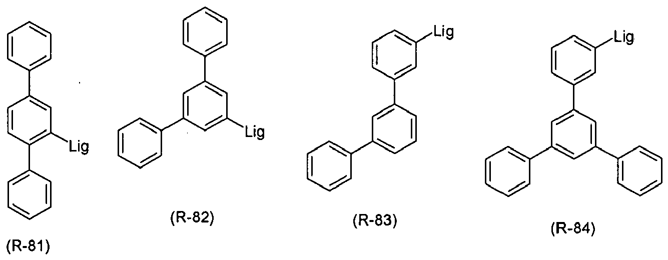 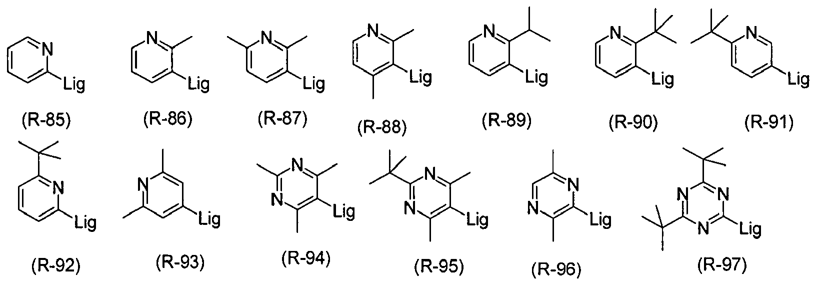 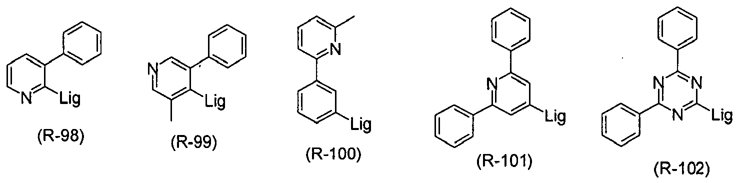 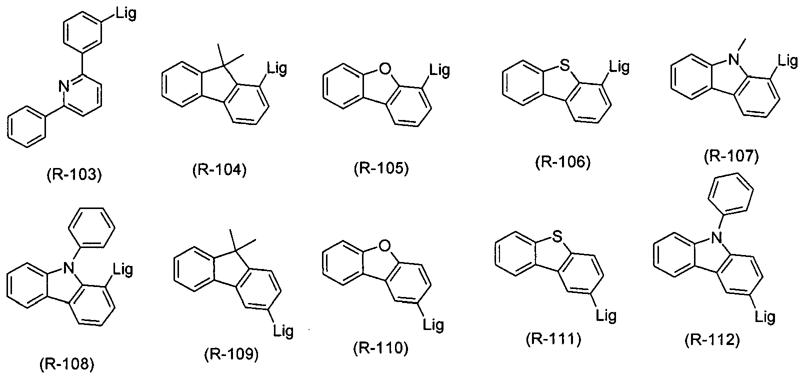 dans lesquelles Lig représente la liaison depuis le groupe sur le ligand et les groupes aromatiques et hétéroaromatiques peuvent chacun être substitués par un radical ou plusieurs radicaux R⁸.

7. Composé selon une ou plusieurs des revendications 1 à 6, **caractérise en ce que** l'indice n = 2 et les deux ligands partiels de la formule (2) sont identiques.

8. Composé selon une ou plusieurs des revendications 1 à 7, **caractérisé en ce que** V représente NR⁷ et R⁷ est choisi parmi le groupe constitué par un groupe alkyle en chaîne droite comportant de 1 à 20 atome(s) de C ou un groupe alkyle ramifié ou cyclique comportant de 3 à 20 atomes C, dont chacun peut être substitué par un radical ou plusieurs radicaux R⁸, où un ou plusieurs atome(s) de H peut/peuvent être remplacé(s) par D, F ou CN, ou un système de cycle aromatique ou hétéroaromatique comportant de 5 à 60 atomes de cycle aromatique, lequel peut dans chaque cas être substitués par un radical ou plusieurs radicaux R⁸.

9. Composé selon la revendication 8, **caractérisé en ce que** R⁷ est choisi parmi les groupes des formules (36) à (45) : 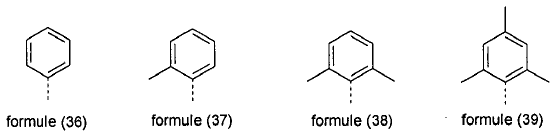 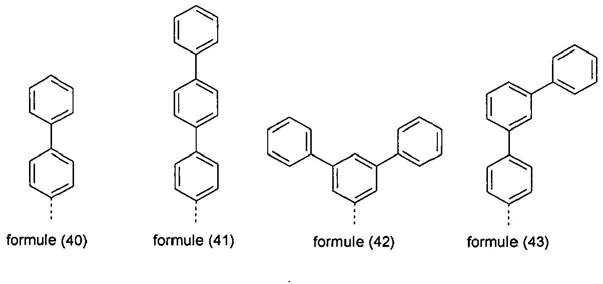 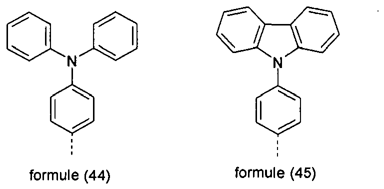 dans lesquelles la liaison en pointillés représente la liaison sur l'atome de bore ou sur l'atome d'azote et les groupes phényle terminaux dans la formule (44) peuvent également être substitués par un ou plusieurs groupes alkyle comportant de 1 à 5 atome(s) de C.

10. Procédé pour la préparation d'un composé selon une ou plusieurs des revendications 1 à 9 par réaction du ligand libre correspondant avec des alcoxydes de métaux de la formule (46), avec des cétocétonates de métaux de la formule (47) ou avec des halogénures de métaux de la formule (48) :
M(OR⁸)ₚ formule (46) 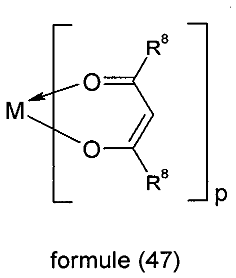
MHaIₚ formule (48)
dans lesquelles les symboles M et R⁸ présentent les significations indiquées selon la revendication 1, Hal = F, Cl, Br ou I et p représente 1, 2 ou 3, en fonction de la valence du métal M.

11. Formulation, en particulier une solution, une suspension ou une mini-émulsion, comprenant un ou plusieurs composé(s) selon une ou plusieurs des revendications 1 à 9 et au moins un solvant.

12. Utilisation d'un composé selon une ou plusieurs des revendications 1 à 9 ou d'une formulation selon la revendication 11 dans un dispositif électronique, de façon préférable choisi parmi le groupe constitué par des dispositifs électroluminescents organiques, des circuits intégrés organiques, des transistors à effet de champ organiques, des transistors à film mince organiques, des transistors à émission de lumière organiques, des cellules solaires organiques, des détecteurs optiques organiques, des photorécepteurs organiques, des dispositifs à extinction de champ organiques, des cellules électrochimiques émettrices de lumière ou des diodes laser organiques.

13. Dispositif électronique, de façon préférable choisi parmi le groupe constitué par des dispositifs électroluminescents organiques, des circuits intégrés organiques, des transistors à effet de champ organiques, des transistors à film mince organiques, des transistors à émission de lumière organiques, des cellules solaires organiques, des détecteurs optiques organiques, des photorécepteurs organiques, des dispositifs à extinction de champ organiques, des cellules électrochimiques émettrices de lumière ou des diodes laser organiques, comprenant un ou plusieurs composé(s) selon une ou plusieurs des revendications 1 à 9.

14. Dispositif électronique selon la revendication 13, **caractérisé en ce qu'**il s'agit d'un dispositif électroluminescent organique et **en ce qu'**il comprend le composé selon une ou plusieurs des revendications 1 à 9 en tant que composé d'émission dans une ou plusieurs couche(s) d'émission.

15. Dispositif électronique selon la revendication 14, **caractérisé en ce que** le composé selon une ou plusieurs des revendications 1 à 9 est utilisé en combinaison avec un matériau de matrice qui est choisi parmi le groupe constitué par des cétones, des oxydes de phosphine, des sulfoxydes, des sulfones, des triarylamines, des dérivés de carbazole, des dérivés d'indolocarbazole, des dérivés d'indénocarbazole, des, azacarbazoles, des matériaux de matrice bipolaires, des azaboroles, des esters boroniques, des dérivés de diazasilole, des dérivés de diazaphosphole, des dérivés de triazine, des complexes de zinc, des dérivés de dibenzofurane ou des dérivés de carbazole pontés.
